(19) Europäisches Patentamt
European Patent Office
Office européen des brevets

(11) EP 3 876 296 A1

(12) EUROPEAN PATENT APPLICATION

(43) Date of publication:
**08.09.2021 Bulletin 2021/36**

(51) Int Cl.:
***H01L 51/00*** *(2006.01)* ***H01L 51/50*** *(2006.01)*

(21) Application number: **21160639.7**

(22) Date of filing: **04.03.2021**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **05.03.2020 KR 20200027988**
**17.02.2021 KR 20210021419**

(71) Applicant: **Samsung Electronics Co., Ltd.**
**Suwon-si 16677 (KR)**

(72) Inventors:
- **JEON, Soonok**
  **16678 Gyeonggi-do (KR)**
- **KIM, Inkoo**
  **16678 Gyeonggi-do (KR)**
- **KIM, Sangmo**
  **16678 Gyeonggi-do (KR)**
- **MARUYAMA, Yusuke**
  **16678 Gyeonggi-do (KR)**
- **SON, Won-joon**
  **16678 Gyeonggi-do (KR)**
- **CHOI, Hyeonho**
  **16678 Gyeonggi-do (KR)**

(74) Representative: **Elkington and Fife LLP**
**Prospect House**
**8 Pembroke Road**
**Sevenoaks, Kent TN13 1XR (GB)**

# (54) ORGANIC LIGHT-EMITTING DEVICE

(57) Provided is an organic light-emitting device including: a first electrode; a second electrode; and an organic layer between the first electrode and the second electrode and including an emission layer, wherein the emission layer may include a polycyclic compound represented by specific Formula and a host, and a content of the polycyclic compound may be smaller than a content of the host.

FIG. 1

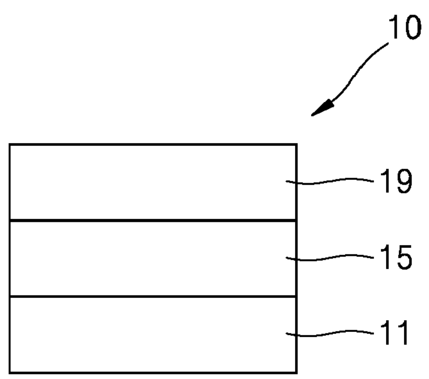


EP 3 876 296 A1

## Description

FIELD OF THE INVENTION

The present disclosure relates to an organic light-emitting device.

BACKGROUND OF THE INVENTION

Organic light-emitting devices (OLEDs) are self-emission devices that, as compared with conventional devices, have wide viewing angles, high contrast ratios, short response times, and excellent brightness, driving voltage, and response speed characteristics, and produce full-color images.

OLEDs include an anode, a cathode, and an organic layer between the anode and the cathode and including an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. The excitons may transit from an excited state to a ground state, thus generating light.

SUMMARY OF THE INVENTION

One or more embodiments include an organic light-emitting device having high efficiency and high colorimetric purity.

Additional aspects will be set forth in part in the description which follows and, in part, will be apparent from the description, or may be learned by practice of the presented embodiments of the disclosure.

According to an aspect of an embodiment, an organic light-emitting device may include a first electrode, a second electrode, and an organic layer between the first electrode and the second electrode and including an emission layer,

wherein the organic layer may include a polycyclic compound represented by Formula 1 and a host, and

a content of the polycyclic compound may be smaller than a content of the host.

Formula 1

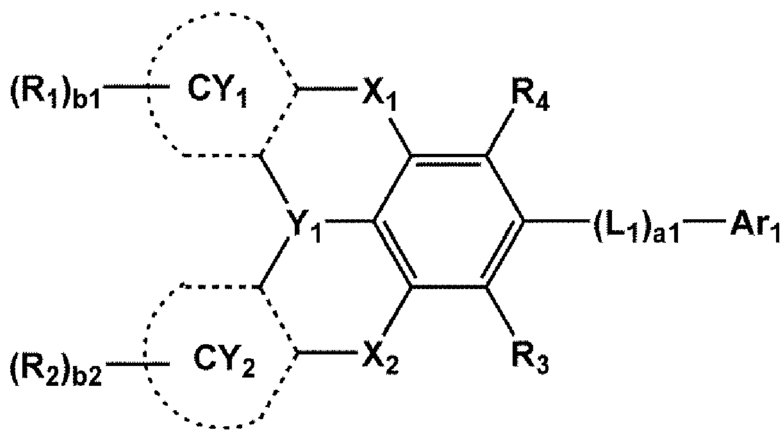

Formula 1A

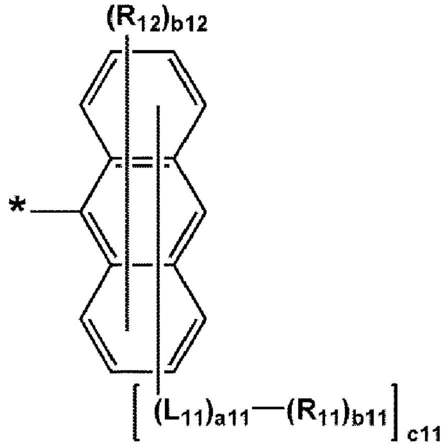

In Formulae 1 and 1A,

$Ar_1$ may be a group represented by Formula 1A,
rings $CY_1$ and $CY_2$ may each independently be a $C_5$-$C_{30}$ carbocyclic group or a $C_1$-$C_{30}$ heterocyclic group,
$Y_1$ may be B, N, P, P(=O), P(=S), Al, Ga, As, Si($R_5$), or Ge($R_5$),
$X_1$ and $X_2$ may each independently be selected from 0, S, Se, N($R_6$), C($R_6$)($R_7$), Si($R_6$)($R_7$), Ge($R_6$)($R_7$), and P(=O)($R_6$),
$L_1$ and $L_{11}$ may each independently be selected from a single bond, a substituted or unsubstituted $C_5$-$C_{30}$ carbocyclic group and a substituted or unsubstituted $C_1$-$C_{30}$ heterocyclic group,
a1 and a11 may each independently be an integer from 1 to 3,
when a1 is 2 or greater, at least two $L_1$(s) may be identical to or different from each other, and when a11 is 2 or greater, at least two $L_{11}$(s) may be identical to or different from each other,
$R_1$, $R_2$, $R_3$, $R_4$, $R_5$, $R_6$, $R_7$, $R_{11}$, and $R_{12}$ may each independently be selected from hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -B($Q_6$)($Q_7$), and -P(=O)($Q_8$)($Q_9$),
$R_1$ and $R_2$ may optionally be bound to form a substituted or unsubstituted $C_5$-$C_{30}$ carbocyclic group or a substituted or unsubstituted $C_1$-$C_{30}$ heterocyclic group,
b1 and b2 may each independently be an integer from 0 to 10,
when b1 is 2 or greater, at least two $R_1$(s) may be identical to or different from each other, and when b2 is 2 or greater, at least two $R_2$(s) may be identical to or different from each other,
b11 may be an integer from 1 to 5,
when b11 is 2 or greater, at least two $R_{11}$(s) may be identical to or different from each other,
b12 may be an integer from 1 to 8,
when b12 is 2 or greater, at least two $R_{12}$(s) may be identical to or different from each other,
c11 may be an integer from 1 to 8,
when c11 is 2 or greater, at least two -$(L_{11})_{a11}$-$(R_{11})_{b11}$(s) may be identical to or different from each other,
a sum of b12 and c11 may be 9, and
at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted monovalent non-aromatic condensed polycyclic group, and the substituted monovalent non-aromatic condensed heteropolycyclic group may be selected from

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group,
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each unsubstituted or substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, a monovalent non-aromatic condensed heteropolycyclic group, $-Si(Q_{11})(Q_{12})(Q_{13})$, $-N(Q_{14})(Q_{15})$, $-B(Q_{16})(Q_{17})$, and $-P(=O)(Q_{18})(Q_{19})$,
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, and a monovalent non-aromatic condensed heteropolycyclic group,
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, a monovalent non-aromatic condensed heteropolycyclic group, $-Si(Q_{21})(Q_{22})(Q_{23})$, $-N(Q_{24})(Q_{25})$ $-B(Q_{26})(Q_{27})$, and $-P(=O)(O_{28})(O_{29})$, and
$-Si(Q_{31})(Q_{32})(Q_{33})$, $-N(Q_{34})(Q_{35})$, $-B(Q_{36})(Q_{37})$, and $-P(=O)(O_{38})(O_{39})$,
wherein $Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted monovalent non-aromatic condensed polycyclic group, and a substituted or unsubstituted monovalent non-aromatic condensed heteropolycyclic group.

## BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a schematic cross-sectional view of an organic light-emitting device according to an embodiment; and
FIGS. 2A to 2C each show a diagram schematically illustrating energy transfer in an emission layer of an organic light-emitting device according to an embodiment.

## DETAILED DESCRIPTION OF THE EMBODIMENTS

An organic light-emitting device may include: a first electrode; a second electrode; and an organic layer between the first electrode and the second electrode and including an emission layer, wherein the organic layer may include a polycyclic compound represented by Formula 1 and a host, and a content of the polycyclic compound may be smaller than a content of the host.
The polycyclic compound may include a compound represented by Formula 1:

Formula 1

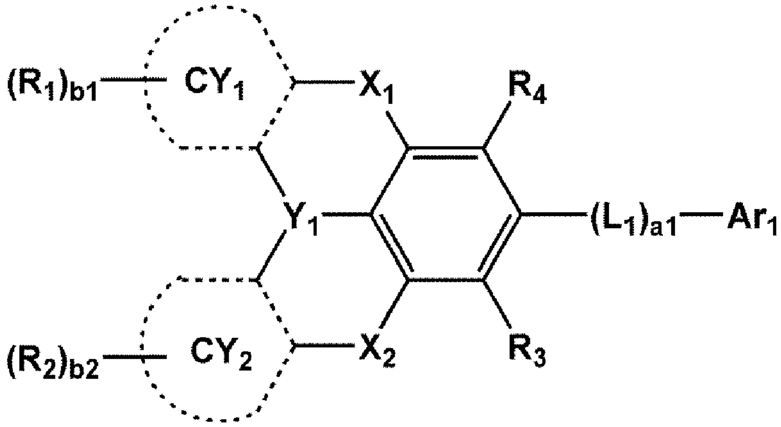

Formula 1A

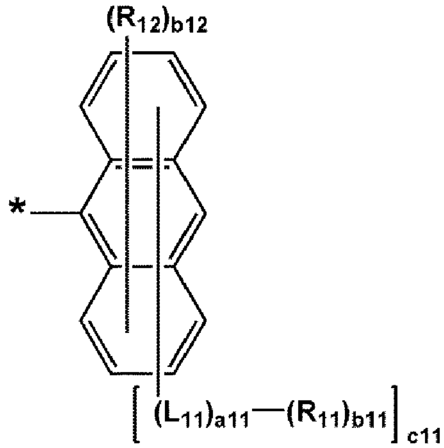

wherein, in Formulae 1 and 1A,

$Ar_1$ may be a group represented by Formula 1A. In Formula 1A, * indicates a binding site to Formula 1.

In Formula 1, rings $CY_1$ to $CY_2$ may each independently be a $C_5$-$C_{30}$ carbocyclic group or a $C_1$-$C_{30}$ heterocyclic group.

In an embodiment, $CY_1$ and $CY_2$ may each independently be selected from an A group, a B group, a condensed ring in which at least two groups selected from the A group are condensed, a condensed ring in which at least two groups selected from the B group are condensed, and a condensed ring in which at least one group selected from the A group and at least one group selected from the B group are condensed:

The A group may be selected from cyclopenta-1,3-diene, an indene group, an azulene group, a benzene group, a naphthalene group, an anthracene group, a phenanthrene group, a tetracene group, a tetrapene group, a pyrene group, a chrysene group, a triphenylene group, and a fluorene group, and

The B group may be selected from a furan group, a thiophene group, a pyrrole group, a borole group, a silole group, a pyrrolidine group, an imidazole group, a thiazole group, a triazole group, an oxazole group, an isoxazole group, a thiazole group, an isothiazole group, a pyridine group, a pyrimidine group, a pyridazine group, a triazine group, an indole group, an isoindole group, an indolizine group, a quinoline group, an isoquinoline group, a quinoxaline group, an isoquinoxaline group, a carbazole group, a dibenzofuran group, a dibenzothiophene group, a dibenzosilole group, and a dibenzoborole group.

In one or more embodiments, the A group may be selected from a benzene group, a naphthalene group, and an anthracene group, and the B group may be selected from a carbazole group, a dibenzofuran group, a dibenzothiophene group, a dibenzosilole group, and a dibenzoborole group.

For example, $CY_1$ and $CY_2$ may each independently be selected from a benzene group, a naphthalene group, an anthracene group, and a fluorene group, but embodiments are not limited thereto.

In Formula 1, $Y_1$ may be B, N, P, P(=O), P(=S), Al, Ga, As, $Si(R_5)$, or $Ge(R_5)$. For example, $Y_1$ may be B, N, P, P(=O), P(=S), Al, or Ga.

In Formula 1, $X_1$ and $X_2$ may each independently be selected from O, S, Se, $N(R_6)$, $C(R_6)(R_7)$, $Si(R_6)(R_7)$, $Ge(R_6)(R_7)$, and $P(=O)(R_6)$.

In an embodiment, $X_1$ and $X_2$ may be identical to each other. For example, $X_1$ and $X_2$ may each be O, S, $N(R_6)$, $C(R_6)(R_7)$, or $Si(R_6)(R_7)$, but embodiments are not limited thereto.

In one or more embodiments, $X_1$ and $X_2$ may be different from each other. For example, $X_1$ may be O, and $X_2$ may be S; $X_1$ may be O, and $X_2$ may be $N(R_6)$; $X_1$ may be O, and $X_2$ may be $C(R_6)(R_7)$; $X_1$ may be 0, and $X_2$ may be $Si(R_6)(R_7)$; $X_1$ may be S, and $X_2$ may be $N(R_6)$; X1 may be S, and $X_2$ may be $C(R_6)(R_7)$; $X_1$ may be S, and $X_2$ may be $Si(R_6)(R_7)$; $X_1$ may be $N(R_6)$, and $X_2$ may be $C(R_6)(R_7)$; $X_1$ may be $N(R_6)$, and $X_2$ may be $Si(R_6)(R_7)$; or $X_1$ may be $C(R_6)(R_7)$, and $X_2$ may be $Si(R_6)(R_7)$. For example, $X_2$ may be 0, and $X_1$ may be S; $X_2$ may be 0, and $X_1$ may be $N(R_6)$; $X_2$ may be 0, and $X_1$ may be $C(R_6)(R_7)$; $X_2$ may be 0, and $X_1$ may be $Si(R_6)(R_7)$; $X_2$ may be S, and $X_1$ may be $N(R_6)$; $X_2$ may be S, and $X_1$ may be $C(R_6)(R_7)$; $X_2$ may be S, and $X_1$ may be $Si(R_6)(R_7)$; $X_2$ may be $N(R_6)$, and $X_1$ may be $C(R_6)(R_7)$; $X_2$ may be $N(R_6)$, and $X_1$ may be $Si(R_6)(R_7)$; or $X_2$ may be $C(R_6)(R_7)$, and $X_1$ may be $Si(R_6)(R_7)$.

In an embodiment, $Y_1$ may be B, and $X_1$ and $X_2$ may each independently be selected from O, S, Se, $N(R_6)$, $C(R_6)(R_7)$, and $Si(R_6)(R_7)$, but embodiments are not limited thereto.

In Formulae 1 and 1A, $L_1$ and $L_{11}$ may each independently be selected from a single bond, a substituted or unsubstituted $C_5$-$C_{30}$ carbocyclic group, and a substituted or unsubstituted $C_1$-$C_{30}$ heterocyclic group.

In an embodiment, $L_1$ and $L_{11}$ may each independently be selected from:

a single bond;

a phenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, and a chrysenylenylene group; and

a phenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, and a chrysenylenylene group, each substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, and a monovalent non-aromatic condensed heteropolycyclic group; and

a phenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, and a chrysenylenylene group, each substituted with at least one selected from a phenyl group, an indenyl group, a naphthyl group, an azulenyl group, a heptalenyl group, an acenaphthyl group, a fluorenyl group, a phenalenyl group, a phenanthrenyl group, an anthracenyl group, a fluoranthenyl group, a triphenylenyl group, a pyrenyl group, and a chrysenylenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, and a monovalent non-aromatic condensed heteropolycyclic group, but embodiments are not limited thereto.

For example, $L_1$ and $L_{11}$ may be selected from a single bond and groups represented by Formulae 3-1 to 3-32, but embodiments are not limited thereto:

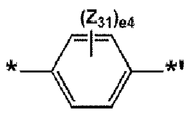
3-1

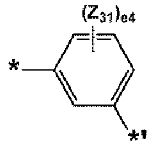
3-2

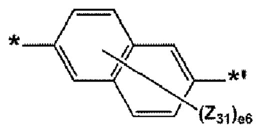
3-3

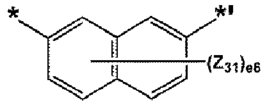
3-4

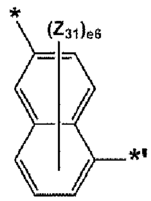
3-5

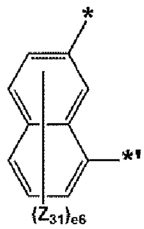
3-6

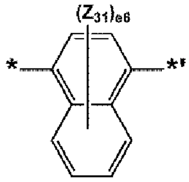
3-7

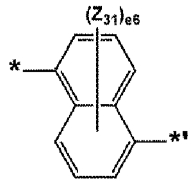
3-8

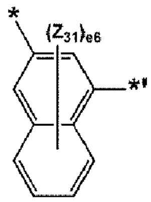
3-9

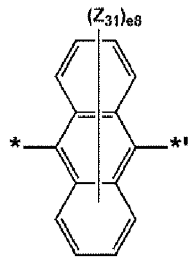
3-10

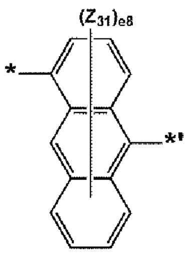
3-11

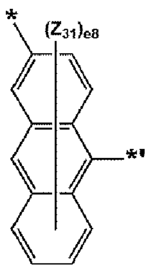
3-12

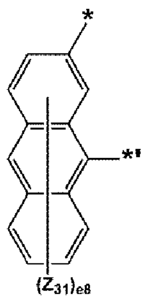
3-13

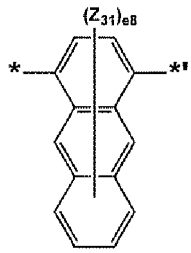
3-14

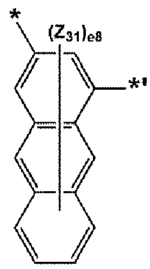
3-15

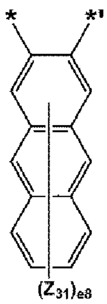
3-16

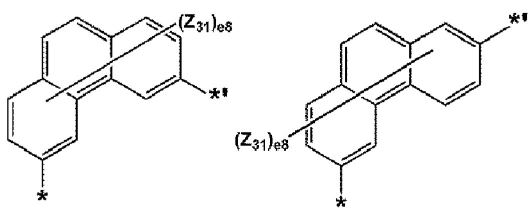
3-17

3-18

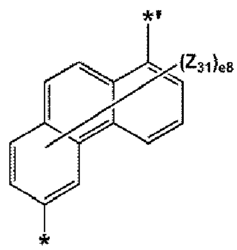
3-19

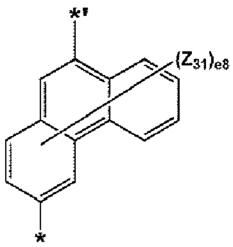
3-20

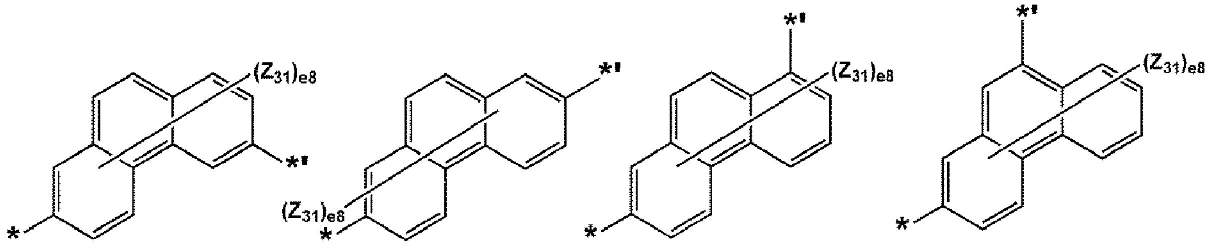
3-21

3-22

3-23

3-24

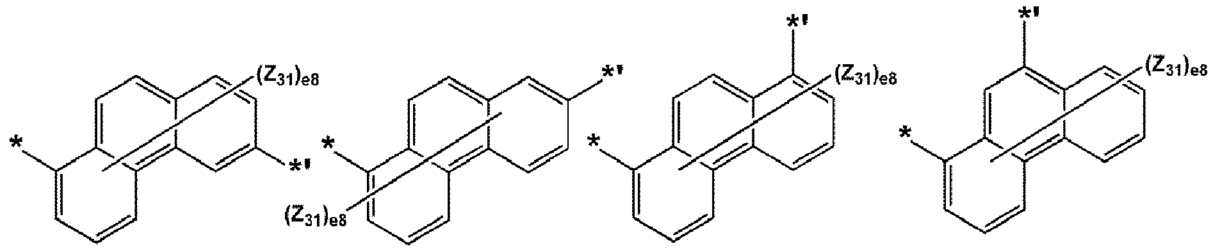

3-25 3-26 3-27 3-28

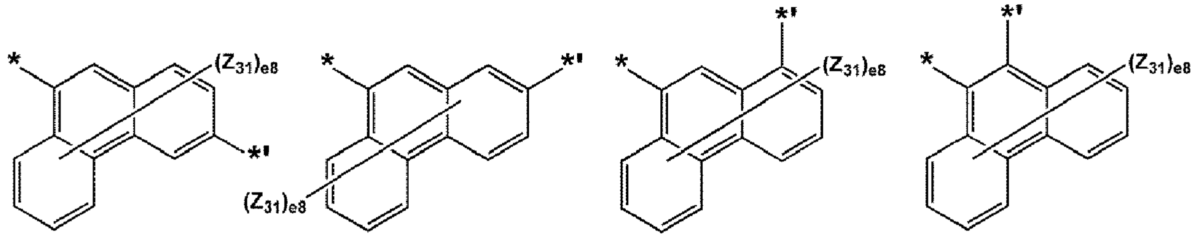

3-29 3-30 3-31 3-32

wherein, in Formulae 3-1 to 3-32,

$Z_{31}$ may be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, and a $C_1$-$C_{60}$ heteroaryl group,

a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, and a $C_1$-$C_{60}$ heteroaryl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, a monovalent non-aromatic condensed heteropolycyclic group, - $Si(Q_{21})(Q_{22})(Q_{23})$, $-N(Q_{24})(Q_{25})$ $-B(Q_{26})(Q_{27})$, and $-P(=O)(Q_{28})(Q_{29})$,

e4 may be an integer from 1 to 4,

e6 may be an integer from 1 to 6,

e8 may be an integer from 1 to 8, and

* and *' each indicate a binding site to an adjacent atom.

In Formulae 1 and 1A, a1 and a11 may each independently be an integer from 1 to 3, and when a1 is 2 or greater, at least two $L_1$(s) may be identical to or different from each other, and when a11 is 2 or greater, at least two $L_{11}$(s) may be identical to or different from each other.

In Formulae 1 and 1A, $R_1$, $R_2$, $R_3$, $R_4$, $R_5$, $R_6$, $R_7$, $R_{11}$, and $R_{12}$ may each independently be selected from hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$,

$-B(Q_6)(Q_7)$, and $-P(=O)(Q_8)(Q_9)$, and in Formula 1, $R_1$ and $R_2$ may optionally be bound to form a substituted or unsubstituted $C_5$-$C_{30}$ carbocyclic group or a substituted or unsubstituted $C_1$-$C_{30}$ heterocyclic group.

In one or more embodiments, in Formula 1, $R_1$ and $R_2$ may each independently be selected from:

hydrogen, deuterium, -F, -Cl, -Br, -I, a hydroxyl group, a cyano group (CN), a nitro group, an amino group, a $C_1$-$C_{60}$ alkyl group, and a $C_1$-$C_{60}$ alkoxy group;
a $C_1$-$C_{60}$ alkyl group and a $C_1$-$C_{60}$ alkoxy group, each substituted with at least one of deuterium, -F, -Cl, -Br, -I, a hydroxyl group, a cyano group (CN), a nitro group, an amino group, a phenyl group, a biphenyl group, a naphthyl group, a fluorenyl group, a phenanthrenyl group, an anthracenyl group, a fluoranthenyl group, a triphenylenyl group, a pyrenyl group, and a chrysenyl group;
a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, and a carbazolyl group;
a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, and a carbazolyl group, each substituted with at least one of deuterium, -F, -Cl, -Br, -I, a hydroxyl group, a cyano group, a nitro group, an amino group, a $C_1$-$C_{60}$ alkyl group, a $C_1$-$C_{60}$ alkoxy group, a $C_7$-$C_{60}$ arylalkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a carbazolyl group, $-Si(Q_{31})(Q_{32})(Q_{33})$, $-N(Q_{34})(Q_{35})$, $-B(Q_{36})(Q_{37})$, and $-P(=O)(Q_{38})(Q_{39})$; and
$-N(Q_1)(Q_2)$, $-Si(Q_3)(Q_4)(Q_5)$, $-B(Q_6)(Q_7)$, and $-P(=O)(Q_8)(Q_9)$, but embodiments are not limited thereto.

In some embodiments, $R_1$ and $R_2$ may each independently be selected from:

hydrogen, deuterium, -F, -Cl, -Br, -I, a hydroxyl group, a cyano group, a nitro group, a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group;
a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group, each substituted with at least one of deuterium, -F, -Cl, -Br, -I, a hydroxyl group, a cyano group, a nitro group, and a phenyl group.

In an embodiment, at least one of $R_1$ and $R_2$ may be selected from Formulae 5-1 and 5-2, but embodiments are not limited thereto:

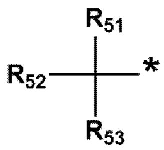

5-1

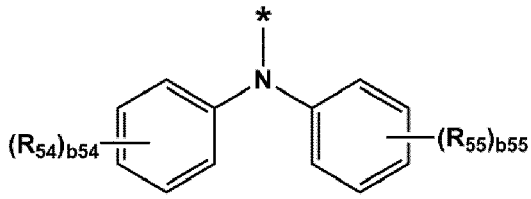

5-2

wherein, in Formulae 5-1 and 5-2,
$R_{51}$ to $R_{55}$ may each independently be:

deuterium, -F, -Cl, -Br, -I, a hydroxyl group, a cyano group, a nitro group, a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, a tert-hexyl group, a phenyl group, a biphenyl group, and a terphenyl group; and;
a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group, each substituted with at least one of deuterium, -F, -Cl, -Br, -I, a hydroxyl group, a cyano group, a nitro group, and a phenyl group,
$R_{54}$ and $R_{55}$ may optionally be bound to each other to form a heteroring, and
b54 and b55 may each independently be an integer from 0 to 4.

For example, in Formula 5-1, one of $R_{51}$ to $R_{53}$ may be a phenyl group, and other two of $R_{51}$ to $R_{53}$ may be selected from a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group.
For example, in Formula 5-1, $R_{51}$ to $R_{53}$ may each independently be selected from a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group. For example, in Formula 5-1, $R_{51}$ to $R_{53}$ may each be a methyl group.
For example, in Formula 5-2, $R_{54}$ and $R_{55}$ may be bound to each other to form a pentagonal ring with a ring-forming atom N.
In one or more embodiments, in Formula 1, $R_3$ and $R_4$ may each independently be selected from:

hydrogen, deuterium, -F, -Cl, -Br, -I, a hydroxyl group, a cyano group, a nitro group, a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group;
a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group, each substituted with at least one of deuterium, -F, -Cl, -Br, -I, a hydroxyl group, a cyano group, a nitro group, and a phenyl group, but embodiments are not limited thereto.

For example, $R_3$ and $R_4$ may each be hydrogen.
In an embodiment, in Formula 1, $R_5$, $R_6$, and $R_7$ may each independently be selected from:

hydrogen, deuterium, -F, -Cl, -Br, -I, a hydroxyl group, a cyano group, a nitro group, a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group;
a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group, each substituted with at least one of deuterium, -F, -Cl, -Br, -I, a hydroxyl group, a cyano group, a nitro group, and a phenyl group,

a phenyl group, a biphenyl group, a naphthyl group, a fluorenyl group, a carbazolyl group, a dibenzofuranyl group, and a dibenzothiophenyl group;

a phenyl group, a biphenyl group, a naphthyl group, a fluorenyl group, a carbazolyl group, a dibenzofuranyl group, and a dibenzothiophenyl group, each substituted with a phenyl group, a biphenyl group, a naphthyl group, a fluorenyl group, a carbazolyl group, a dibenzofuranyl group, and a dibenzothiophenyl group, but embodiments are not limited thereto.

In an embodiment, in Formula 1A, $R_{11}$ may be selected from Formulae 4-1 to 4-42,

$R_{12}$ may be selected from: hydrogen, deuterium, -F, -Cl, -Br, -I, a hydroxyl group, a cyano group, a nitro group, a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group; a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group, each substituted with at least one of deuterium, -F, -Cl, -Br, -I, a hydroxyl group, a cyano group, a nitro group, and a phenyl group, but embodiments are not limited thereto:

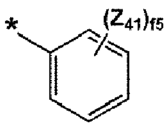
4-1

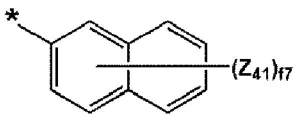
4-2

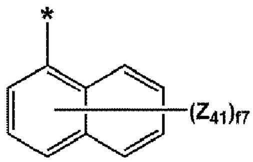
4-3

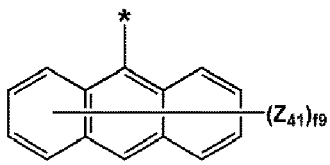
4-4

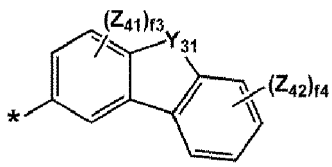
4-5

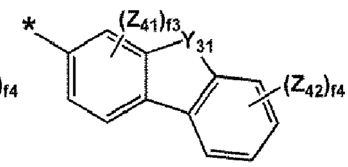
4-6

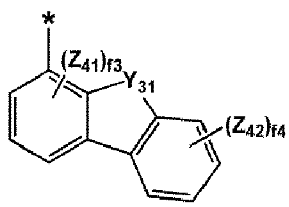
4-7

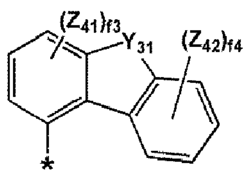
4-8

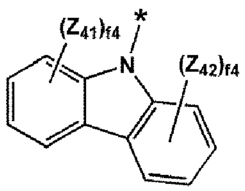
4-9

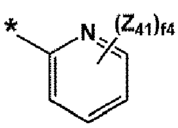
4-10

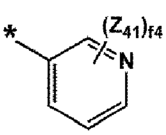
4-11

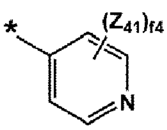
4-12

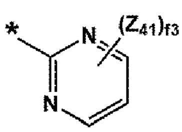
4-13

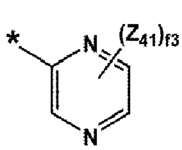
4-14

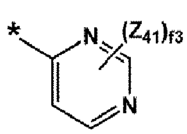
4-15

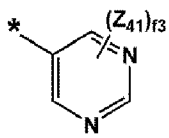
4-16

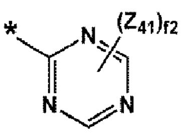
4-17

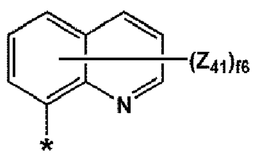
4-18

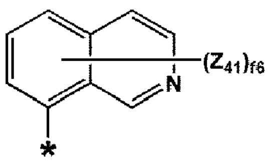
4-19

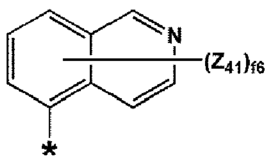
4-20

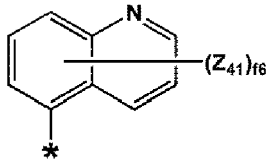
4-21

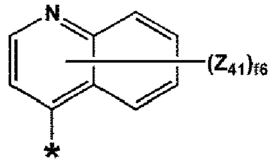
4-22

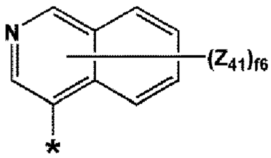
4-23

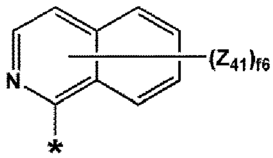
4-24

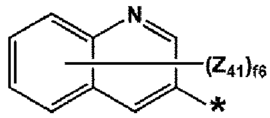
4-25

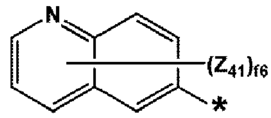
4-26

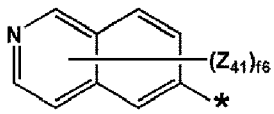
4-27

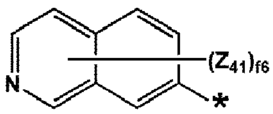
4-28

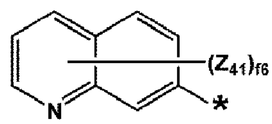
4-29

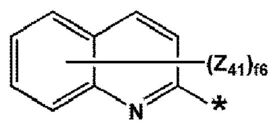
4-30

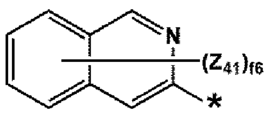
4-31

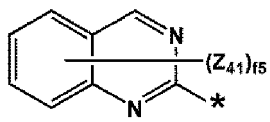
4-32

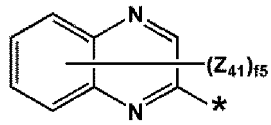
4-33

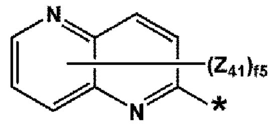
4-34

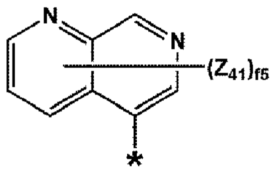
4-35

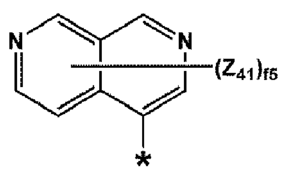
4-36

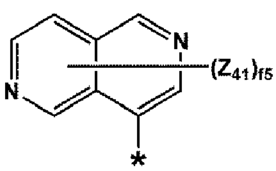
4-37

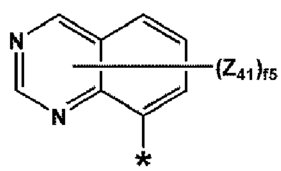
4-38

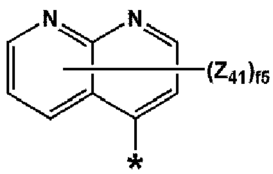
4-39

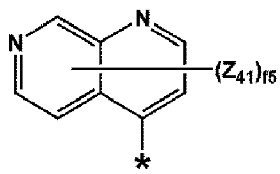
4-40

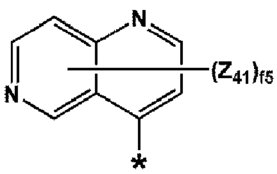
4-41

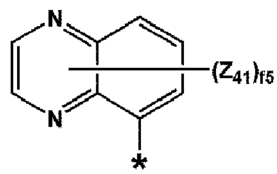
4-42

wherein, in Formulae 4-1 to 4-42,
$Y_{31}$ may be O, S, $C(Z_{45})(Z_{46})$, $N(Z_{47})$, or $Si(Z_{48})(Z_{49})$,
$Z_{41}$ to $Z_{49}$ may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_7$-$C_{60}$ arylalkyl group, a cyclopentyl group, a cyclohexyl group, a cycloheptyl group, a cyclopentenyl group, a cyclohexenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group,

an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, and a carbazolyl group; a cyclopentyl group, a cyclohexyl group, a cycloheptyl group, a cyclopentenyl group, a cyclohexenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, and a carbazolyl group, each substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, and a $C_7$-$C_{60}$ arylalkyl group, for example a cumyl group, but embodiments are not limited thereto,

f3 may be an integer from 1 to 3,

f4 may be an integer from 1 to 4,

f5 may be an integer from 1 to 5,

f6 may be an integer from 1 to 6,

f7 may be an integer from 1 to 7,

f9 may be an integer from 1 to 9, and

* indicates a binding site to an adjacent atom.

In Formula 1, b1 and b2 may each independently be an integer from 0 to 10, and when b1 is 2 or greater, at least two $R_1$(s) may be identical to or different from each other, and when b2 is 2 or greater, at least two $R_2$(s) may be identical to or different from each other.

In Formula 1A, b11 may be an integer from 1 to 5, and when b11 is 2 or greater, at least two $R_{11}$(s) may be identical to or different from each other.

In Formula 1A, b12 may be an integer from 1 to 8, and when b12 is 2 or greater, at least two $R_{12}$(s) may be identical to or different from each other.

In Formula 1A, c11 may be an integer from 1 to 8, and when c11 is 2 or greater, at least two $-(L_{11})_{a11}-(R_{11})_{b11}$(s) may be identical to or different from each other.

In Formula 1A, a sum of b12 and c11 may be 9. For example, b12 may be 8, and c11 may be 1.

In an embodiment, Formula 1A may be selected from Formulae 1A-1 to 1A-5:

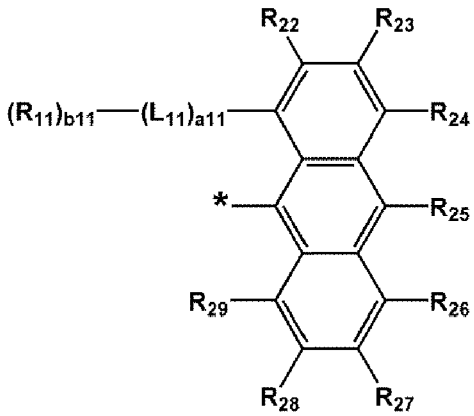

1A-1

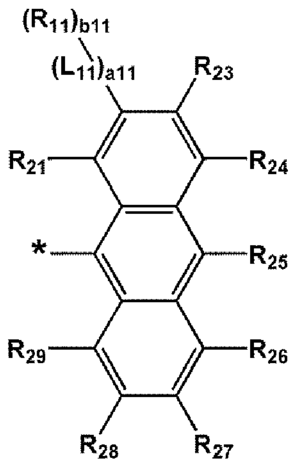

1A-2

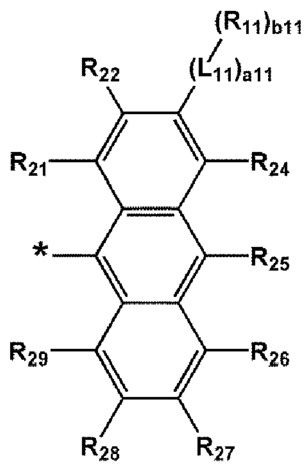

1A-3

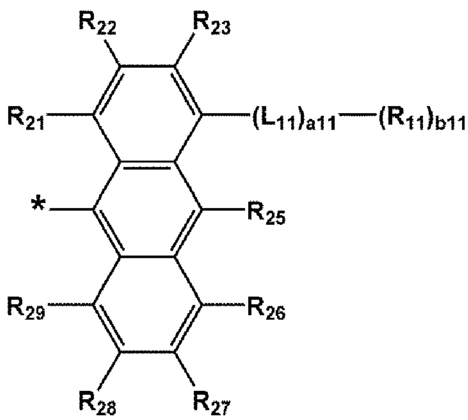

1A-4

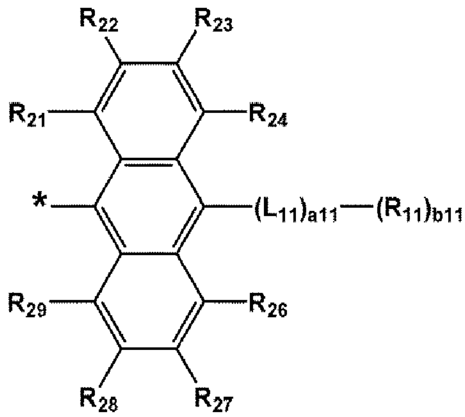

1A-5

wherein in Formulae 1A-1 to 1A-5,
$L_{11}$, $a_{11}$, $R_{11}$, and $b_{11}$ may respectively be understood by referring to the descriptions of $L_{11}$, $a_{11}$, $R_{11}$, and $b_{11}$ provided herein,
$R_{21}$ to $R_{29}$ may each be understood by referring to the description of $R_{12}$ provided herein, and
* indicates a binding site to an adjacent atom.

In an embodiment, the polycyclic compound may include a compound represented by one of Formulae 2-1 to 2-8:

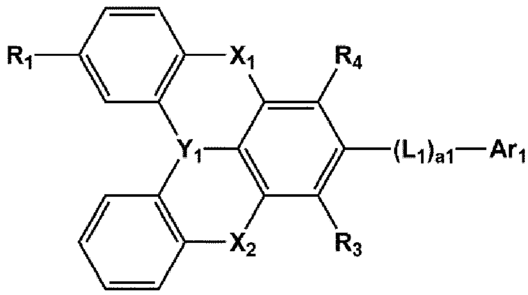

2-1

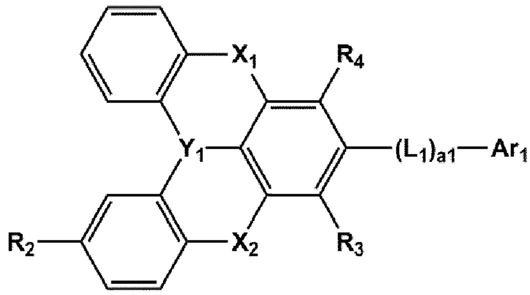

2-2

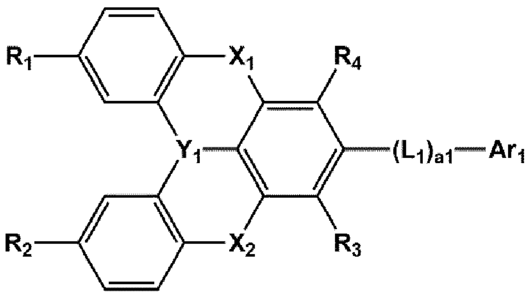

2-3

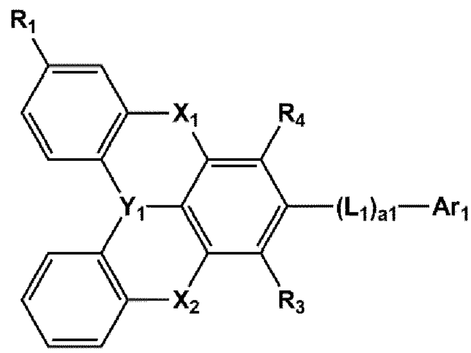

2-4

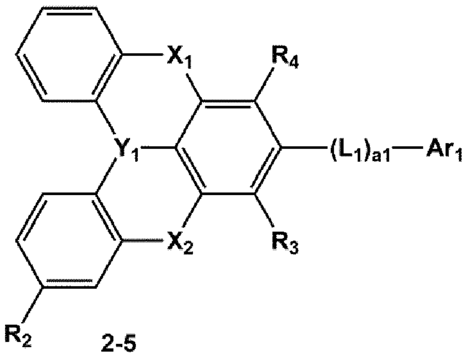

2-5

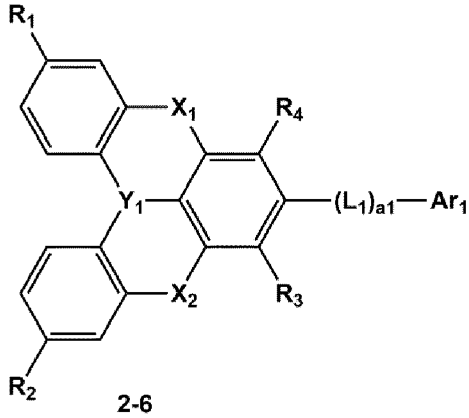

2-6

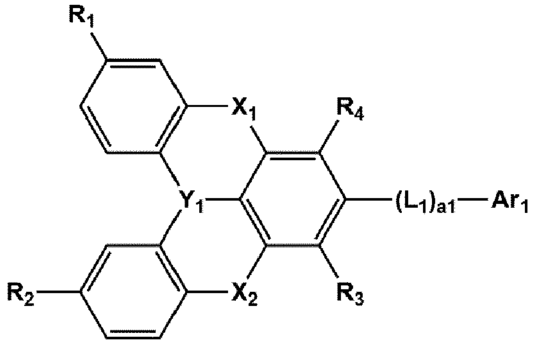

2-7

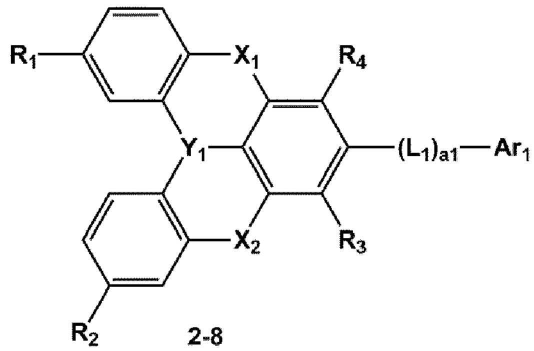

2-8

wherein, in Formulae 2-1 to 2-8,

$Y_1$, $X_1$, $X_2$, $R_1$, $R_2$, $R_3$, $R_4$, $R_5$, $L_1$, $a_1$, and $Ar_1$ may respectively be understood by referring to the descriptions of $Y_1$, $X_1$, $X_2$, $R_1$, $R_2$, $R_3$, $R_4$, $R_5$, $L_1$, $a_1$, and $Ar_1$ provided herein.

In an embodiment, the polycyclic compound may be selected from Compounds 1 to 468:

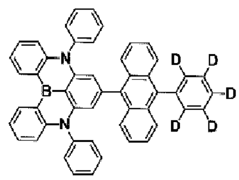

1

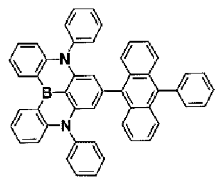

2

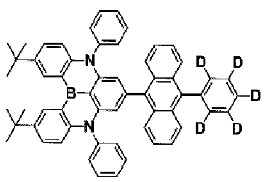

3

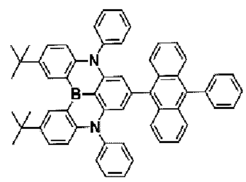

4

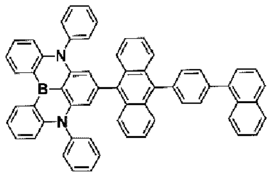

5

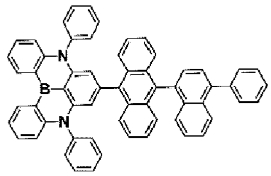

6

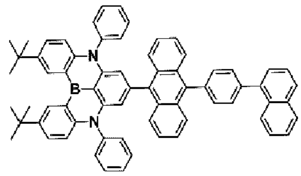

7

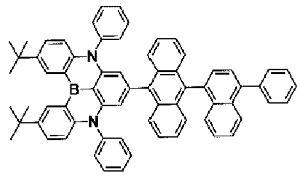

8

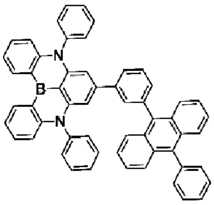

9

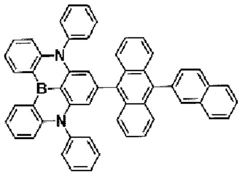

10

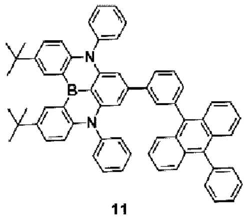

11

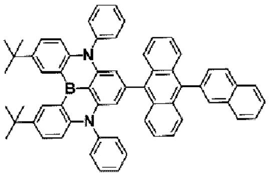

12

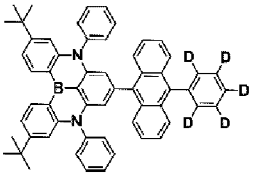

13

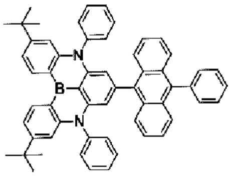

14

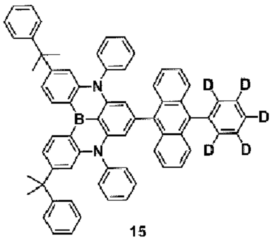

15

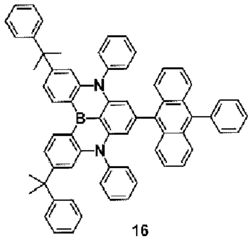

16

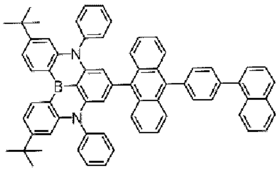

17

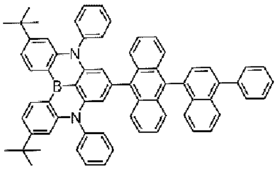

18

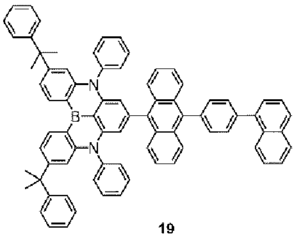

19

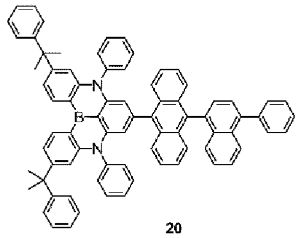

20

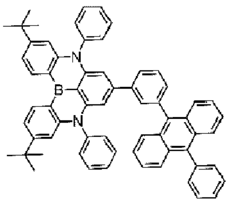

21

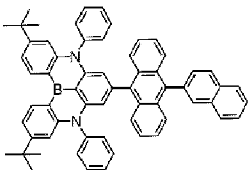

22

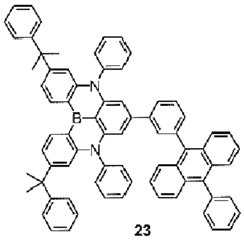

23

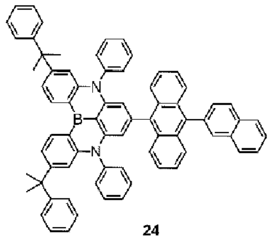

24

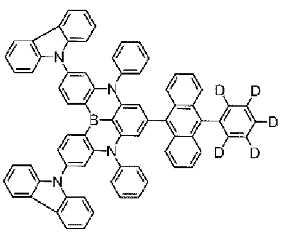

25

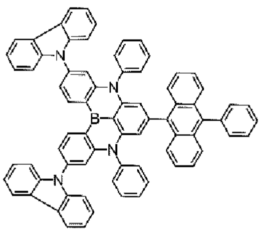

26

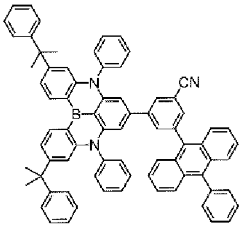

27

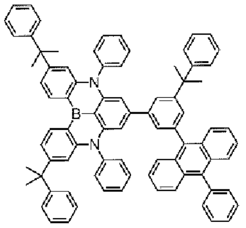

28

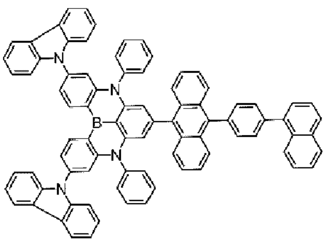

29

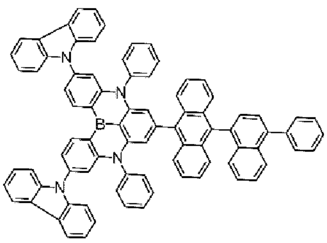

30

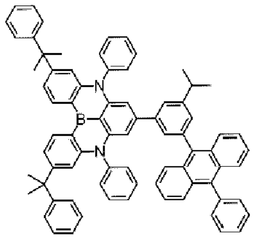

31

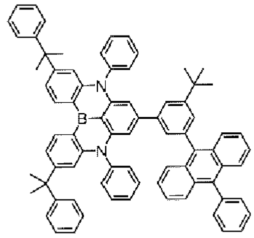

32

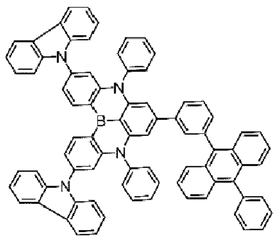
33
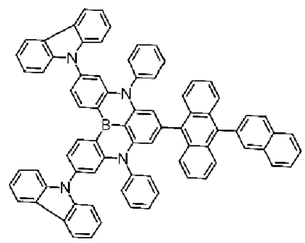
34
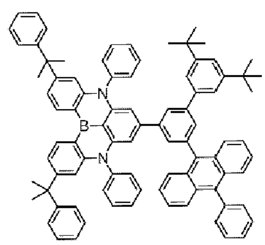
35
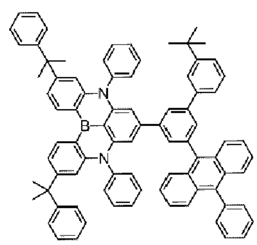
36

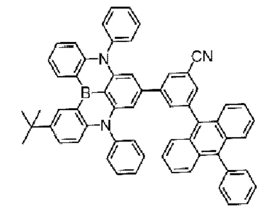
37
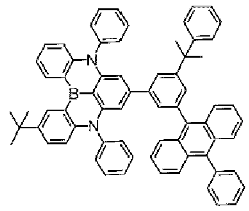
38
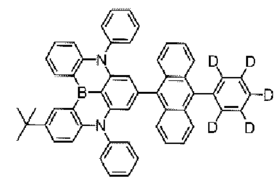
39
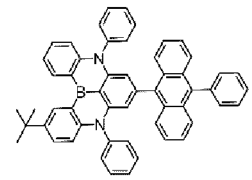
40

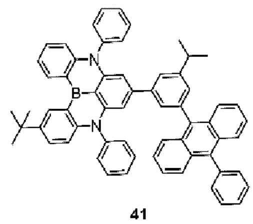
41
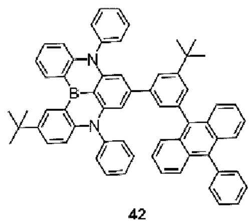
42
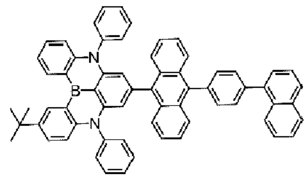
43
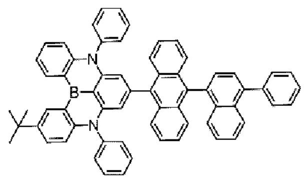
44

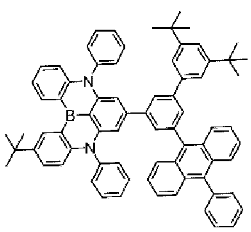
45
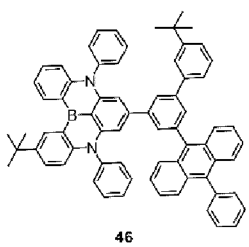
46
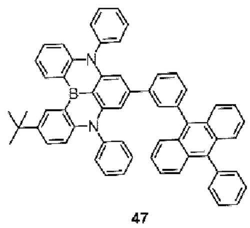
47
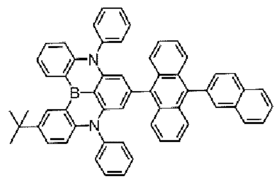
48

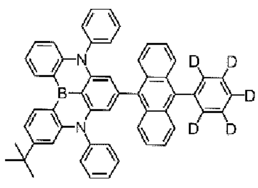
49
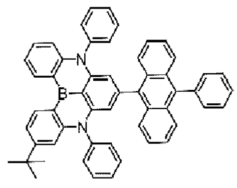
50
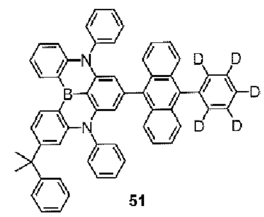
51
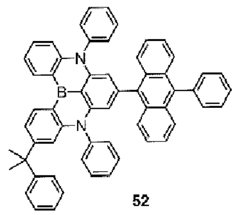
52

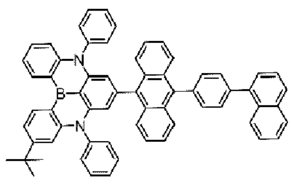
53
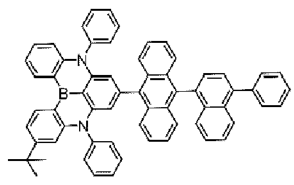
54
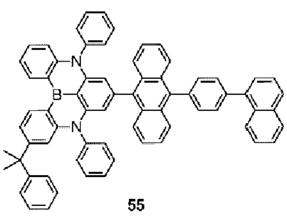
55
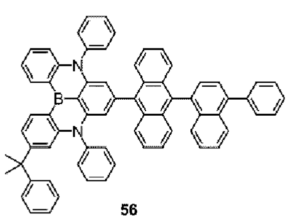
56

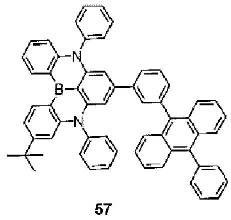
57

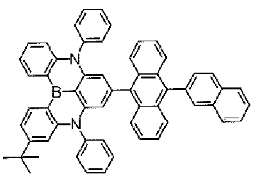
58

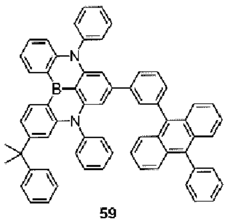
59

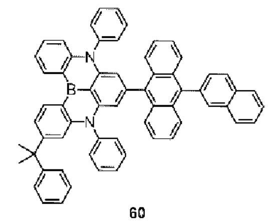
60

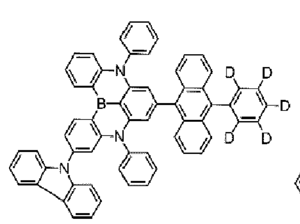
61

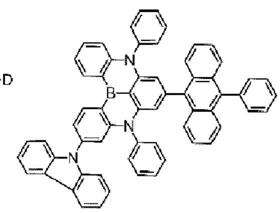
62

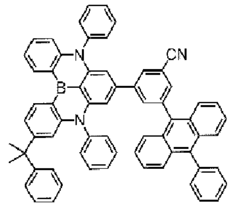
63

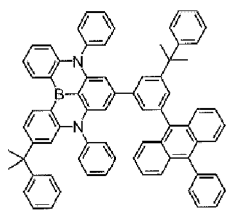
64

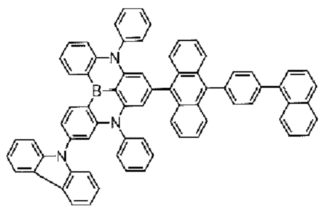
65

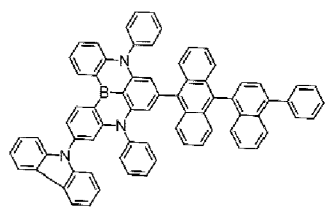
66

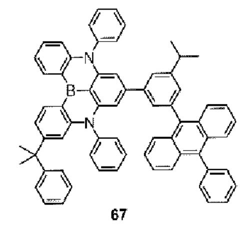
67

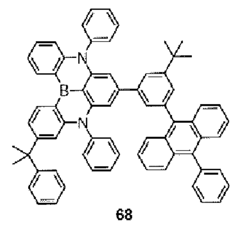
68

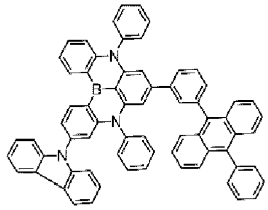
69

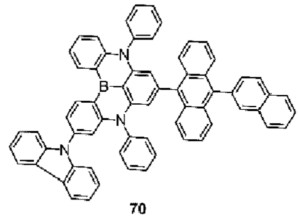
70

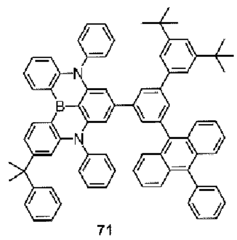
71

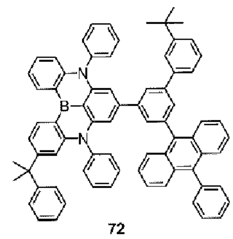
72

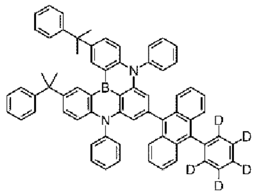
73

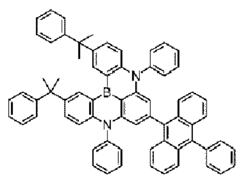
74

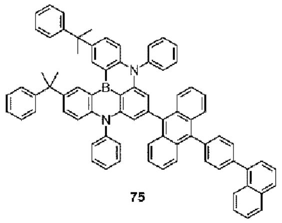
75

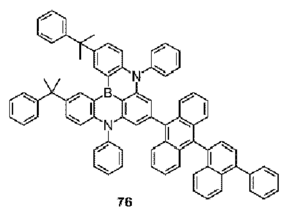
76

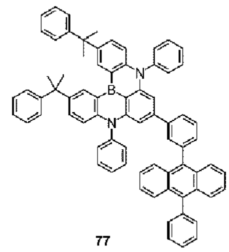
77

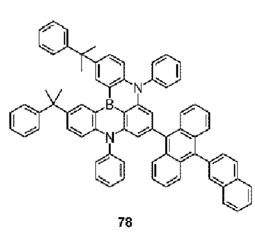
78

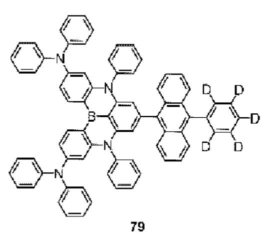
79

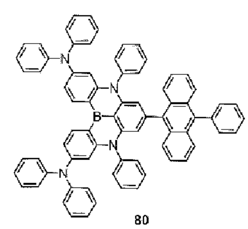
80

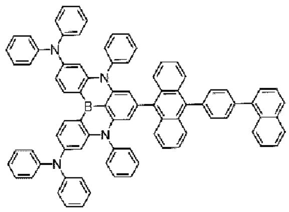

81

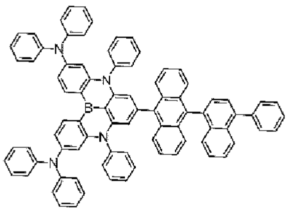

82

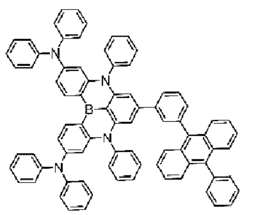

83

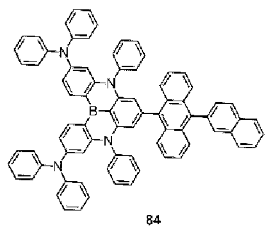

84

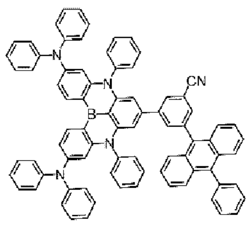

85

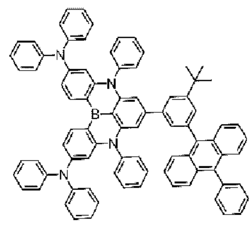

86

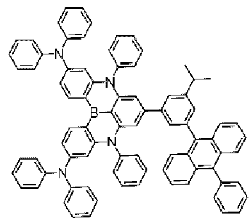

87

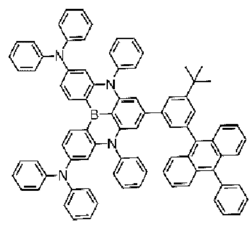

88

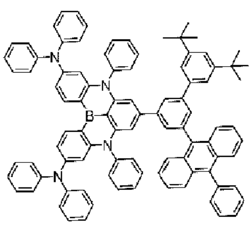

89

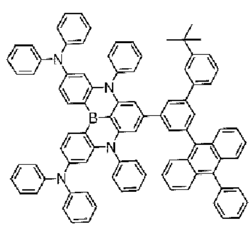

90

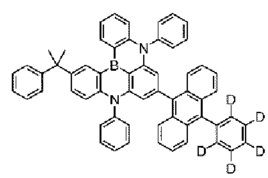

91

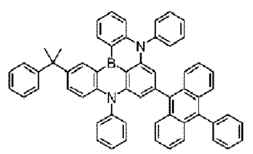

92

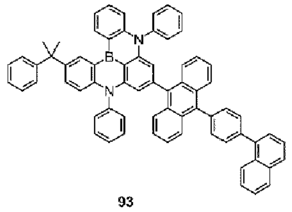

93

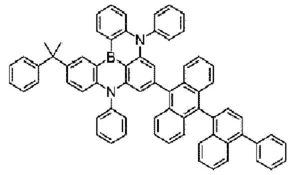

94

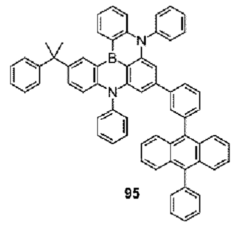

95

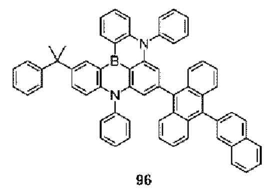

96

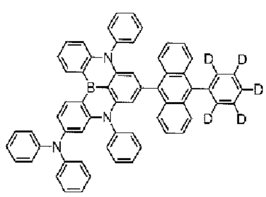

97

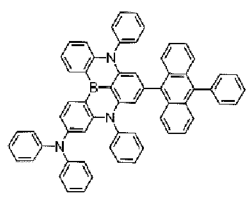

98

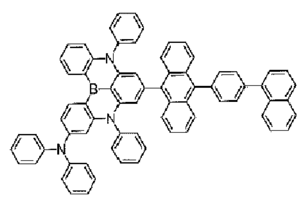

99

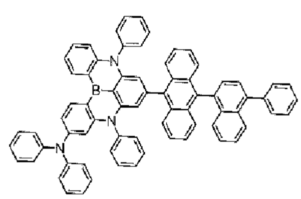

100

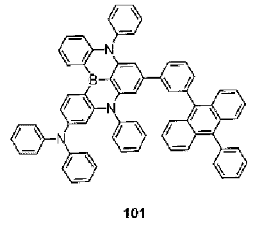

101

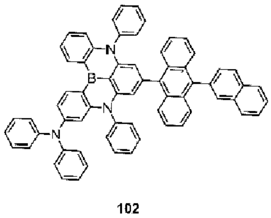

102

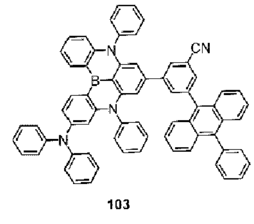

103

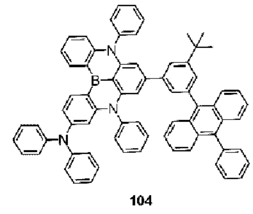

104

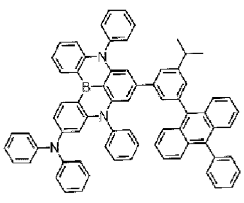
105

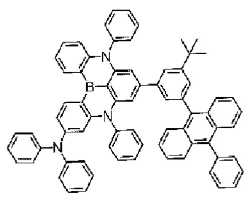
106

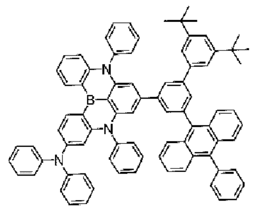
107

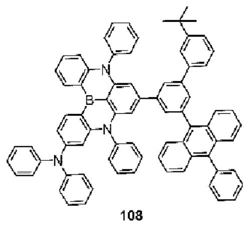
108

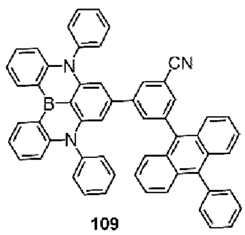
109

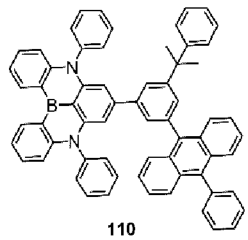
110

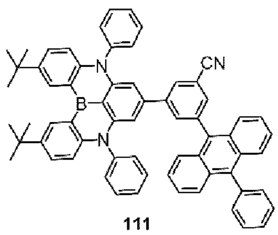
111

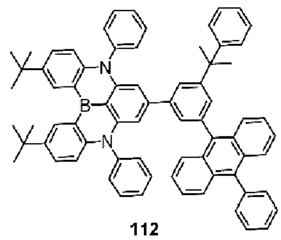
112

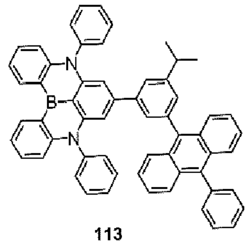
113

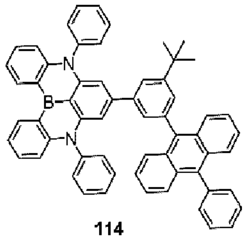
114

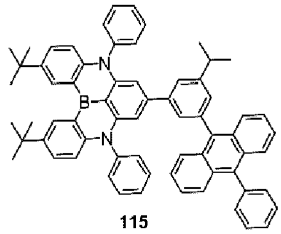
115

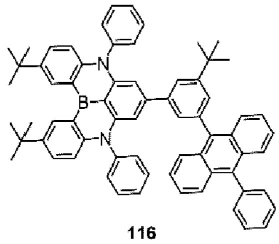
116

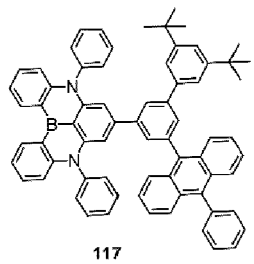
117

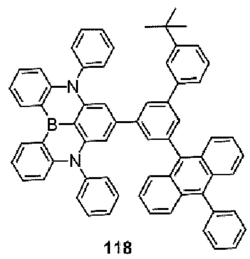
118

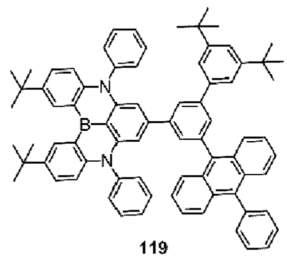
119

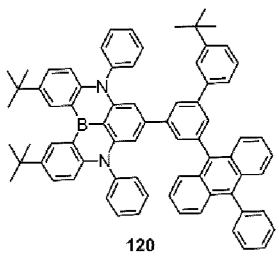
120

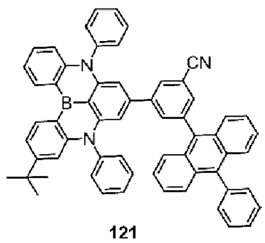
121

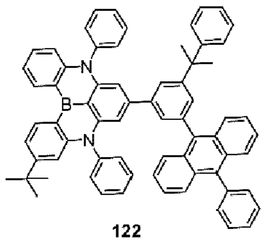
122

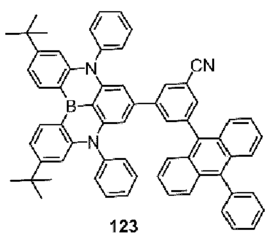
123

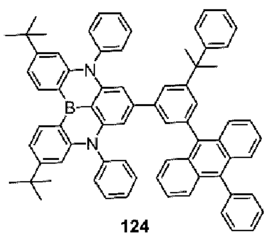
124

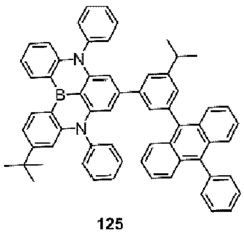
125

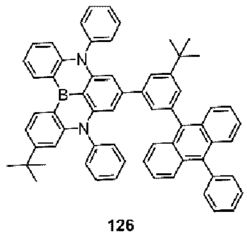
126

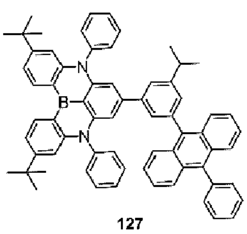
127

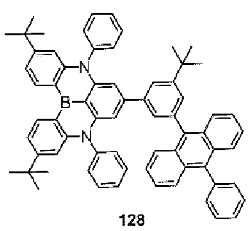
128

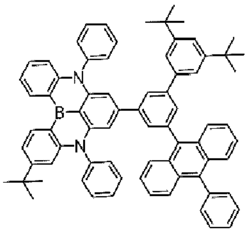

129

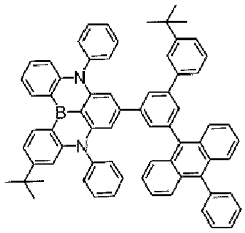

130

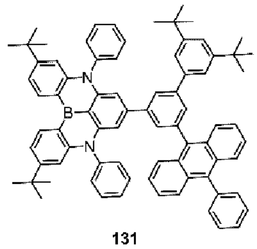

131

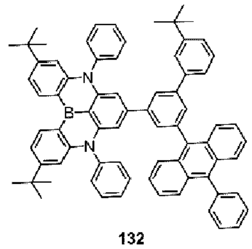

132

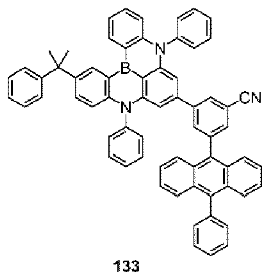

133

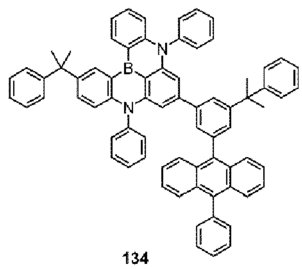

134

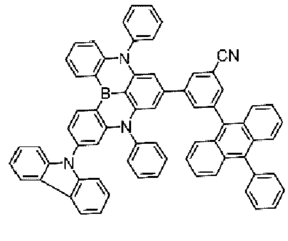

135

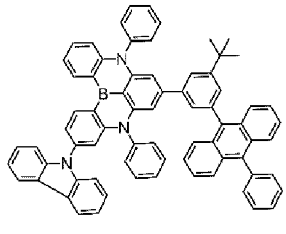

136

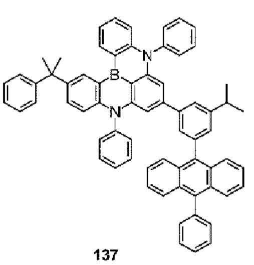

137

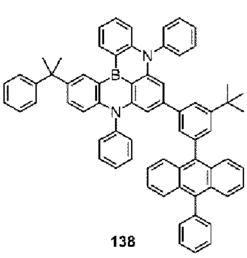

138

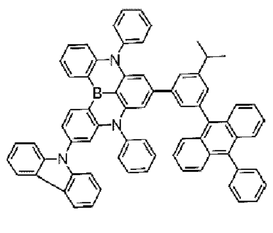

139

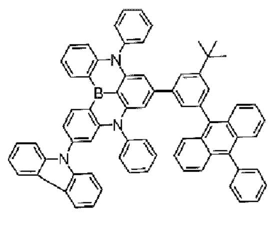

140

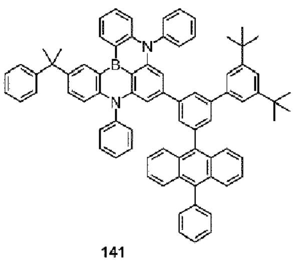

141

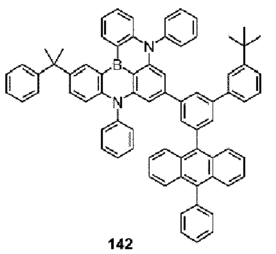

142

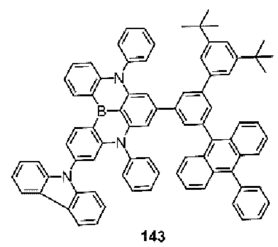

143

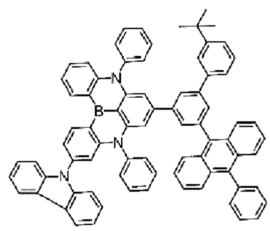

144

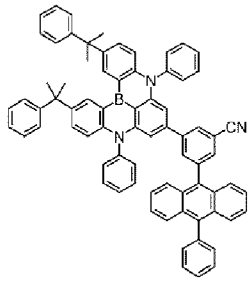

145

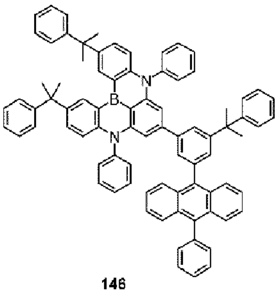

146

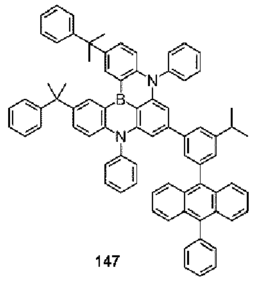

147

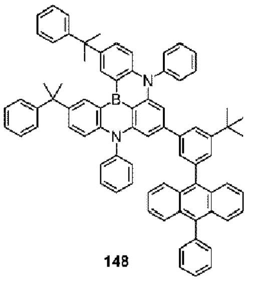

148

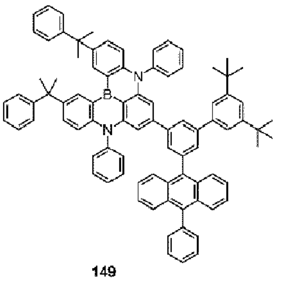
149
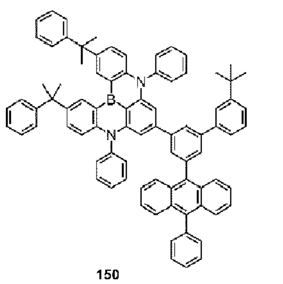
150
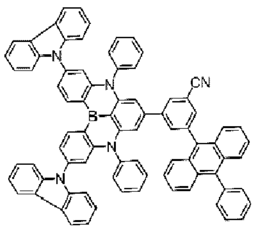
151
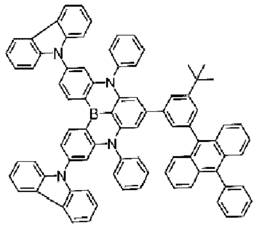
152

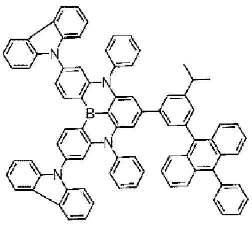
153
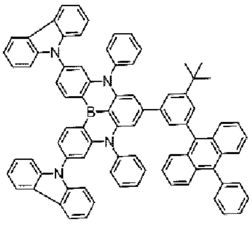
154
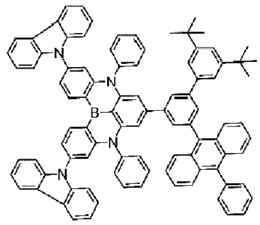
155
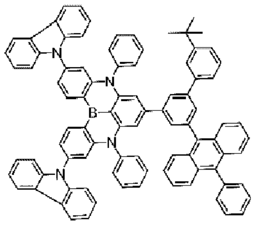
156

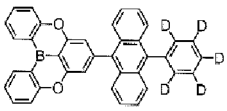
157
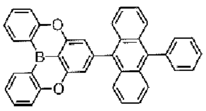
158
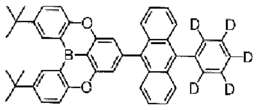
159
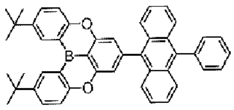
160

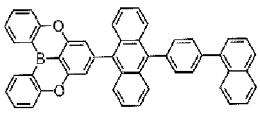
161
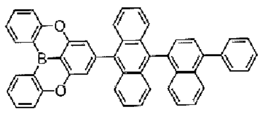
162
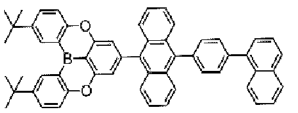
163
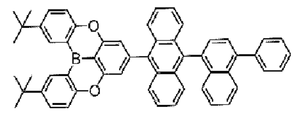
164

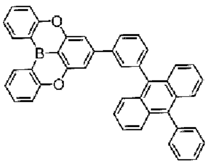
165
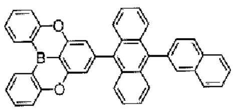
166
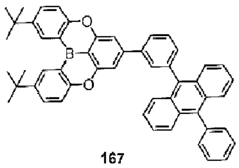
167
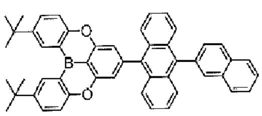
168

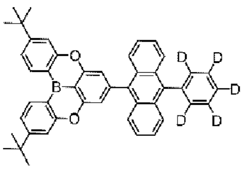
169
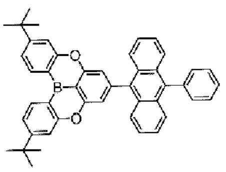
170
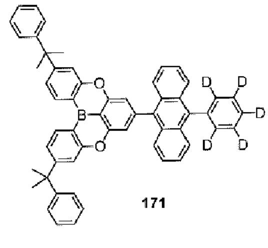
171
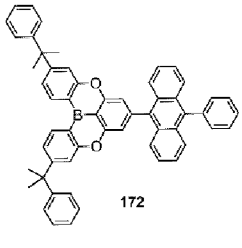
172

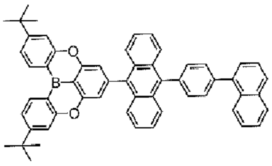
173
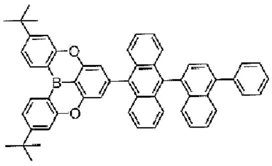
174
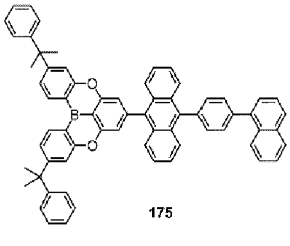
175
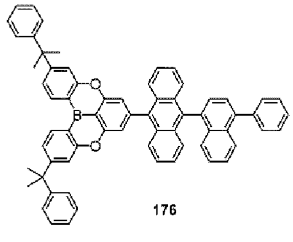
176

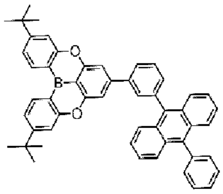
177

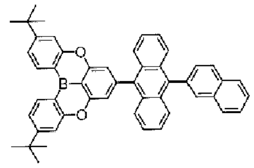
178

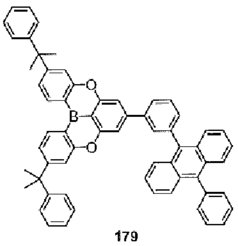
179

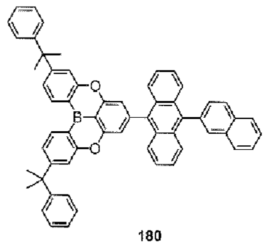
180

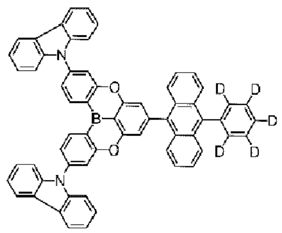
181

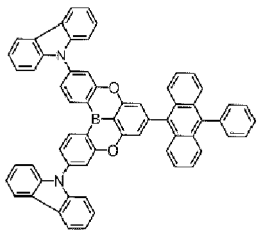
182

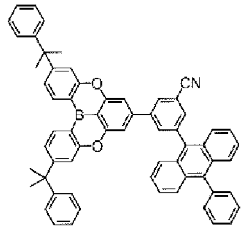
183

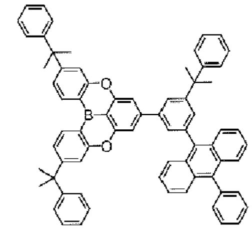
184

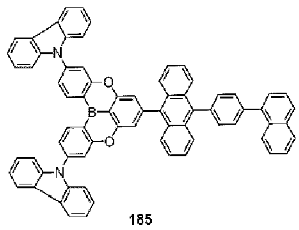
185

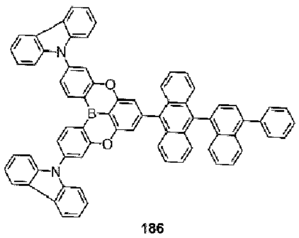
186

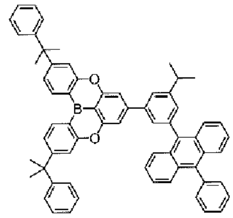
187

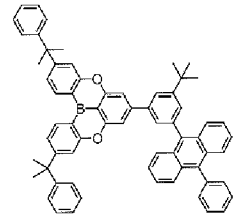
188

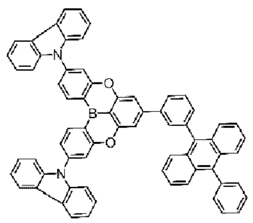
189

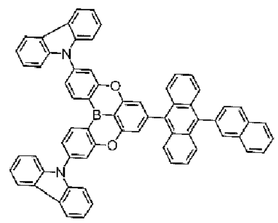
190

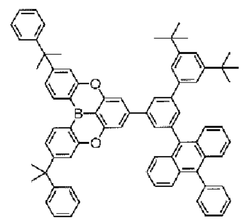
191

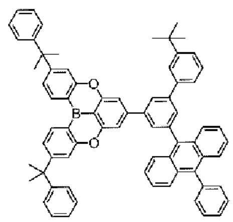
192

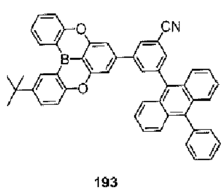
193

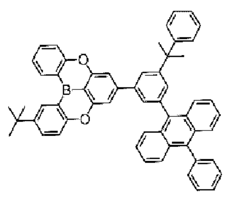
194

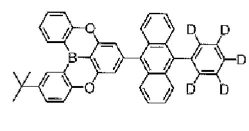
195

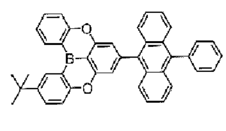
196

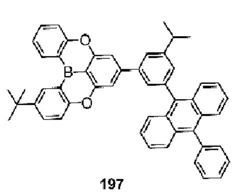
197

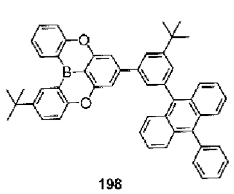
198

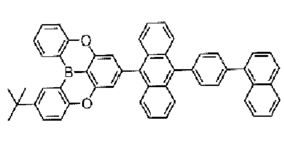
199

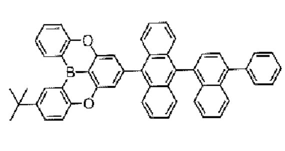
200

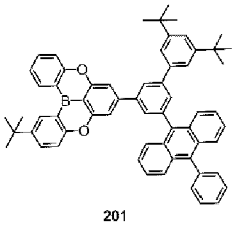
201

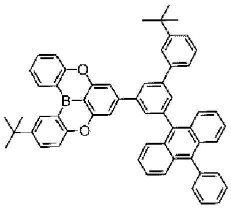
202

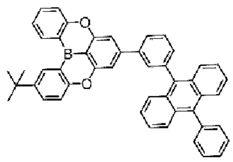
203

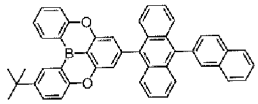
204

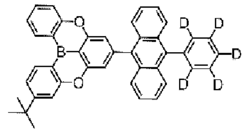
205

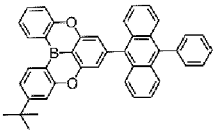
206

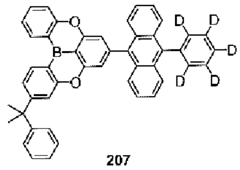
207

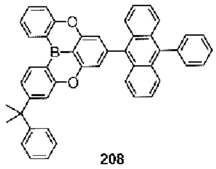
208

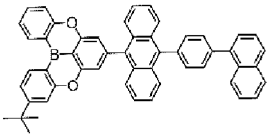
209

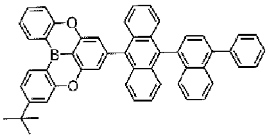
210

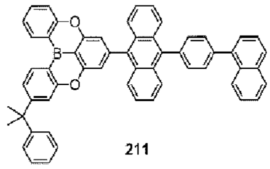
211

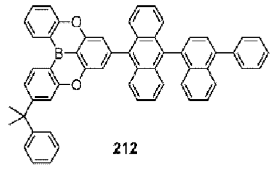
212

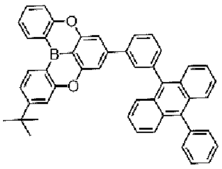
213

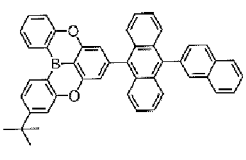
214

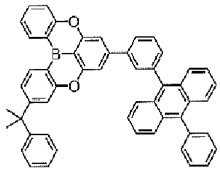
215

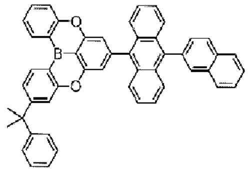
216

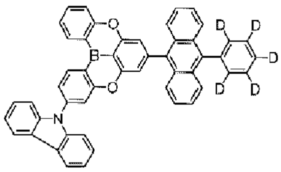
217

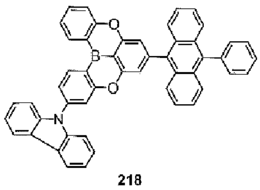
218

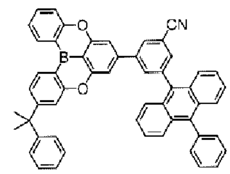
219

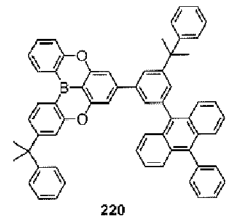
220

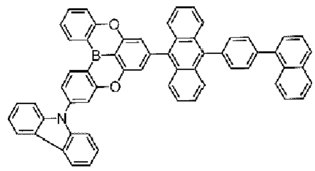
221

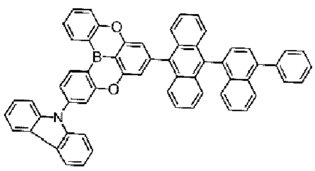
222

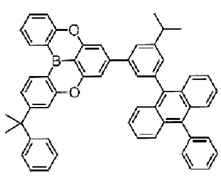
223

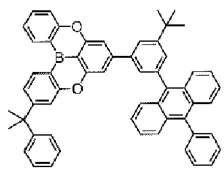
224

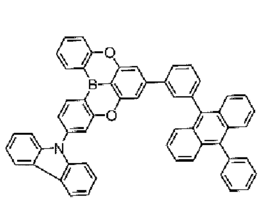
225

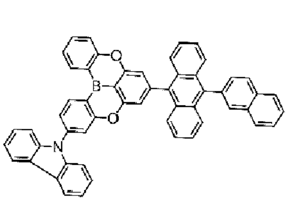
226

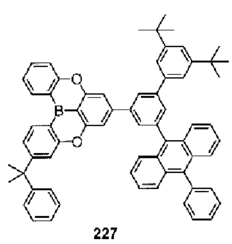
227

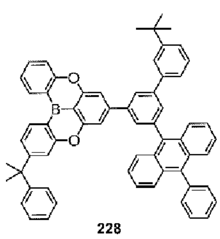
228

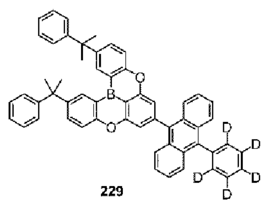
229

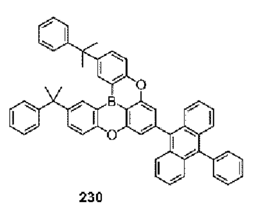
230

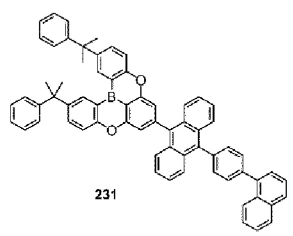
231

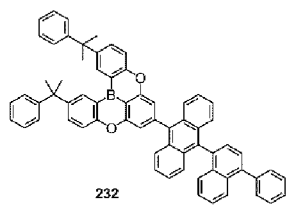
232

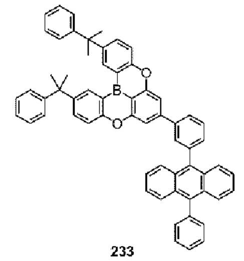
233

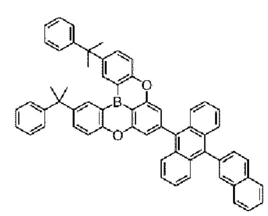
234

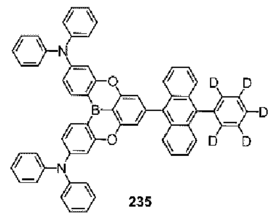
235

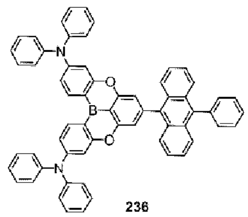
236

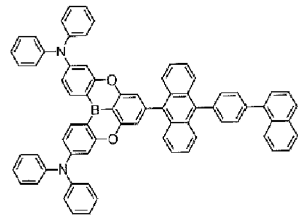
237

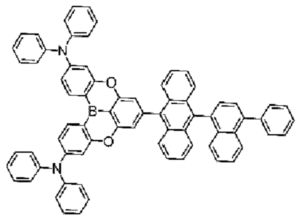
238

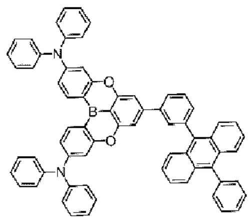
239

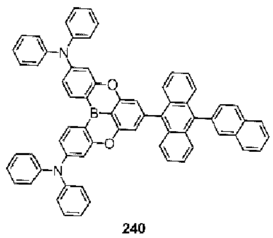
240

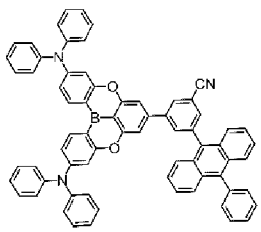
241

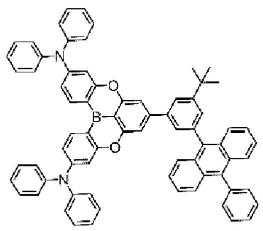
242

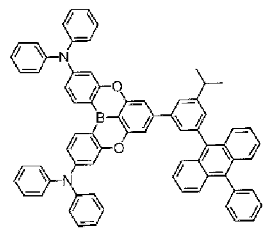
243

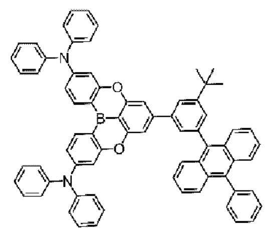
244

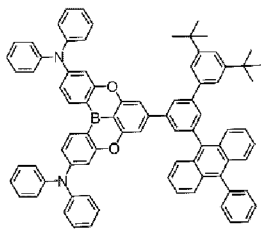
245

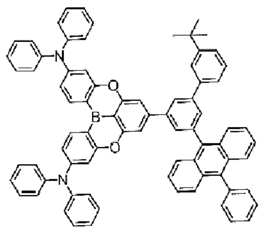
246

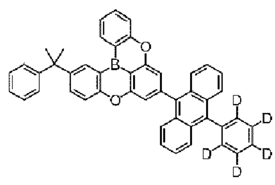
247

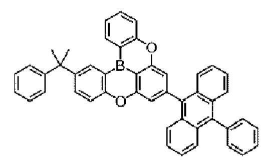
248

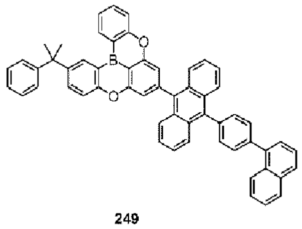
249

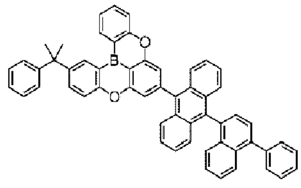
250

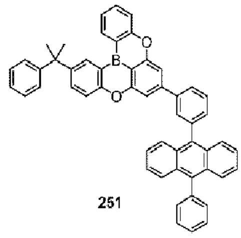
251

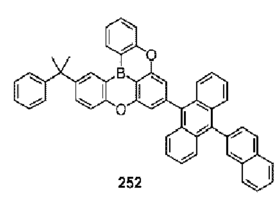
252

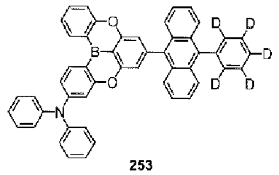
253

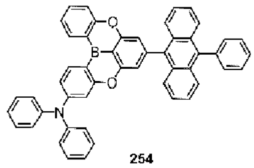
254

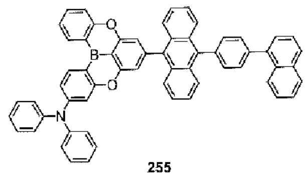
255

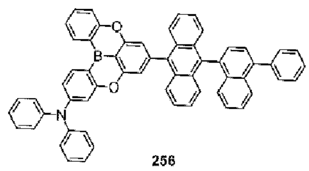
256

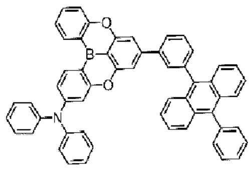
257

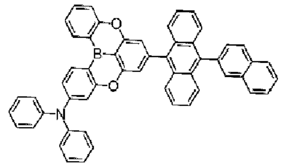
258

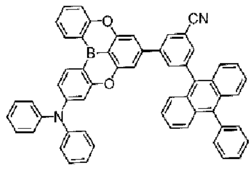
259

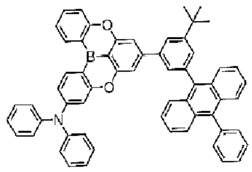
260

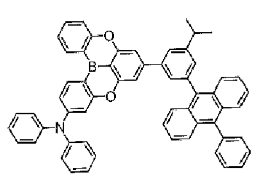
261

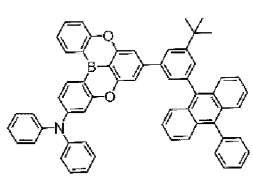
262

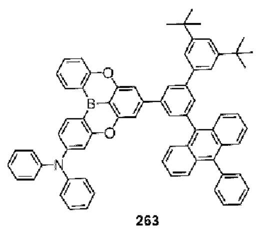
263

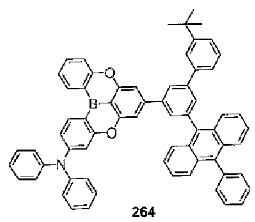
264

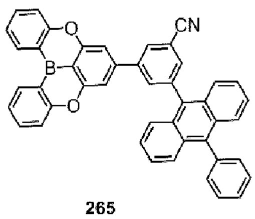
265

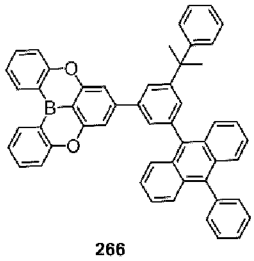
266

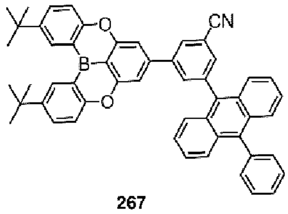
267

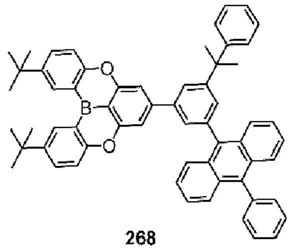
268

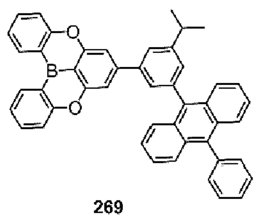
269

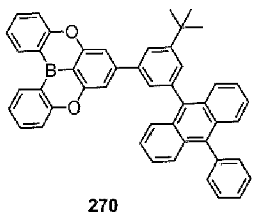
270

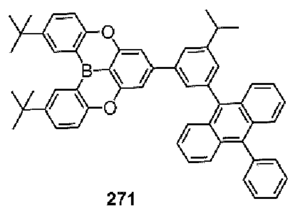
271

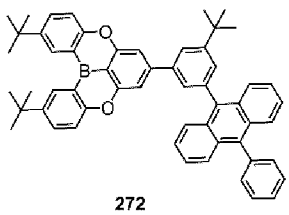
272

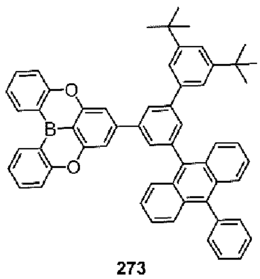
273

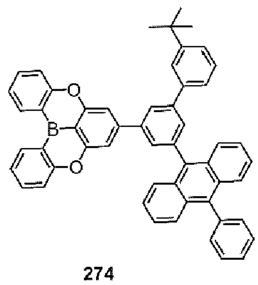
274

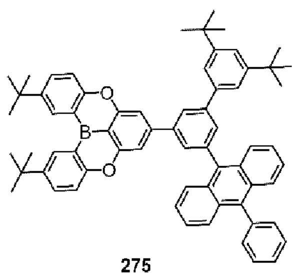
275

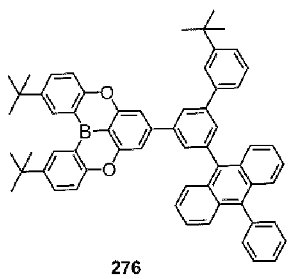
276

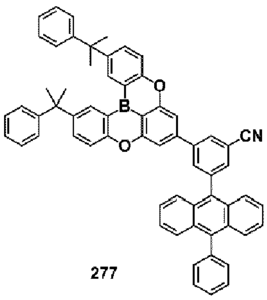
277
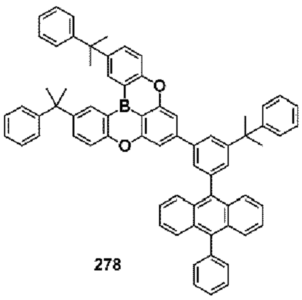
278
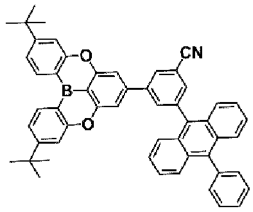
279
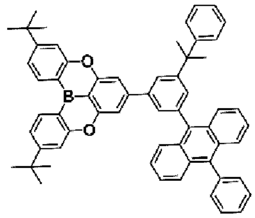
280

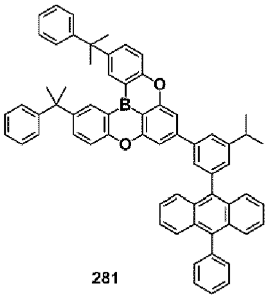
281
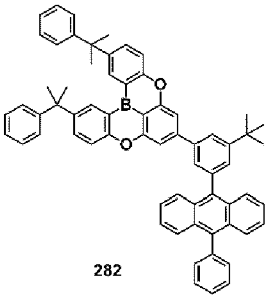
282
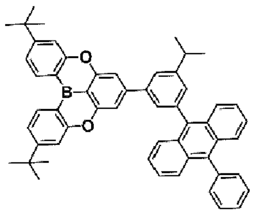
283
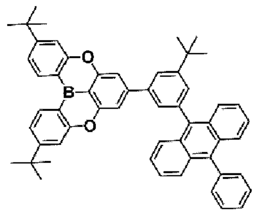
284

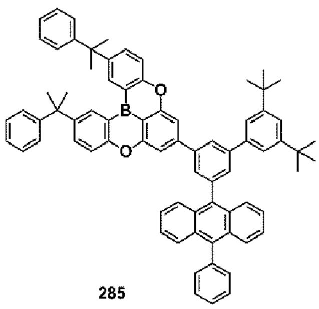
285
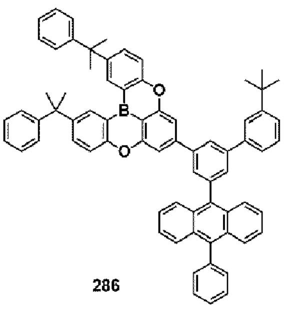
286
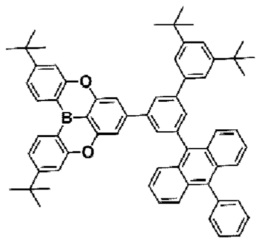
287
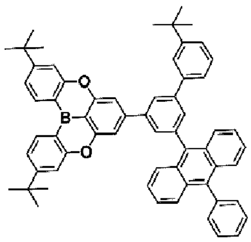
288

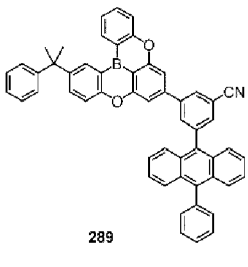
289
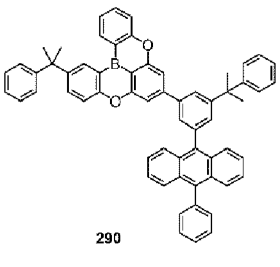
290
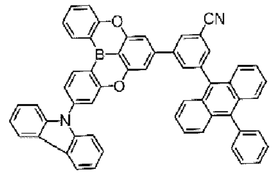
291
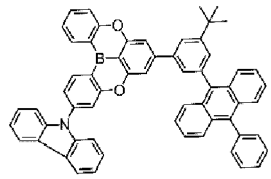
292

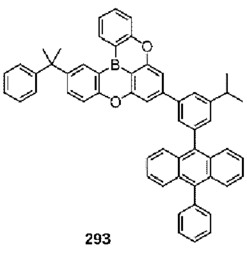
293
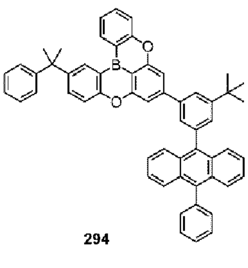
294
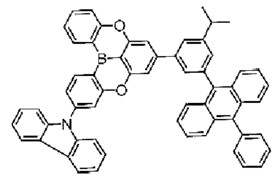
295
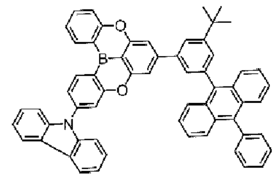
296

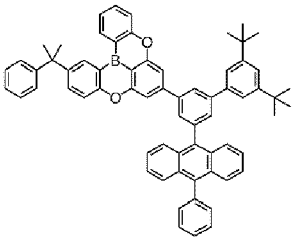
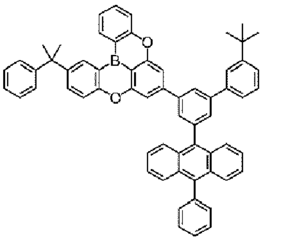
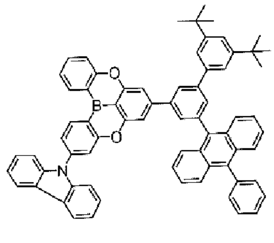
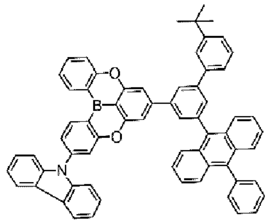

297 298 299 300

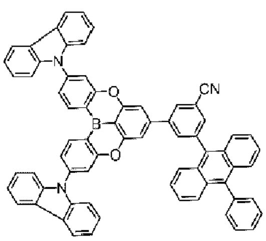
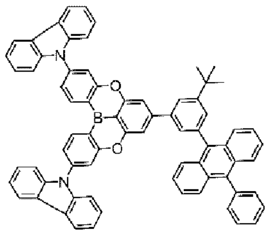
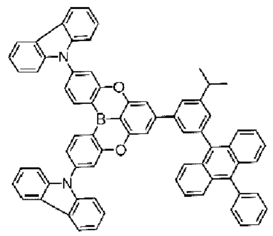
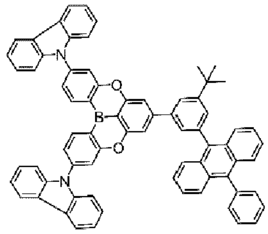

301 302 303 304

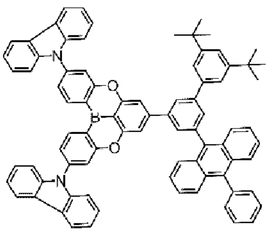
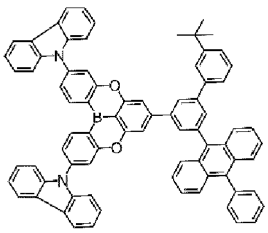
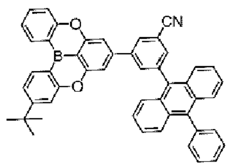
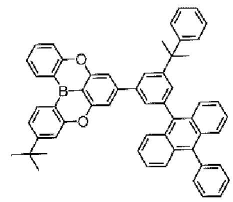

305 306 307 308

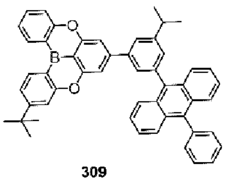
309
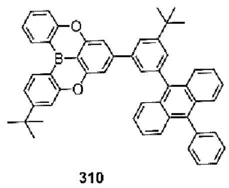
310
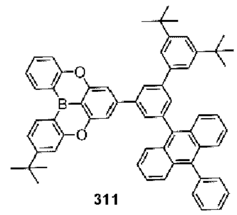
311
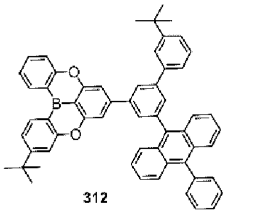
312

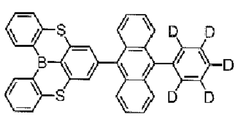
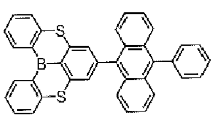
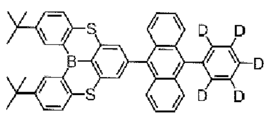
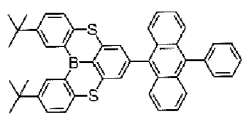

313 314 315 316

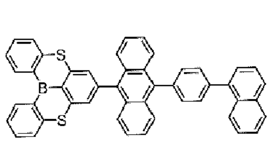
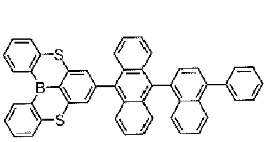
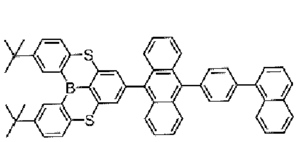
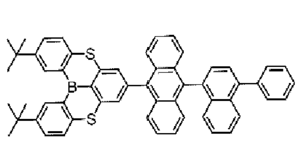

317 318 319 320

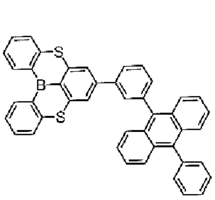
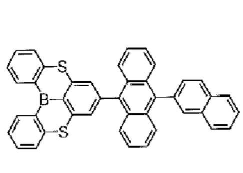
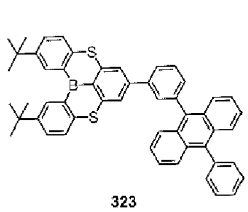
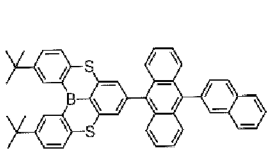

321 322 323 324

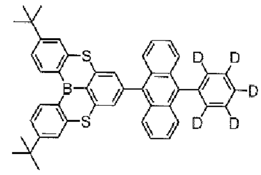

325

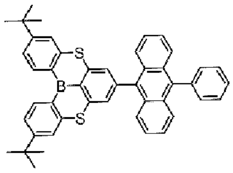

326

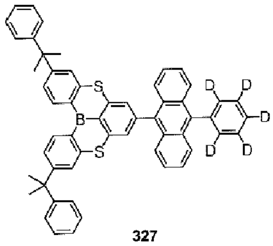

327

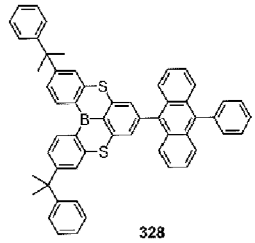

328

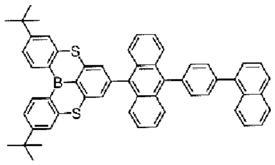

329

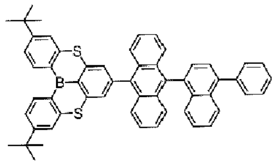

330

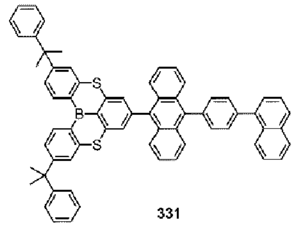

331

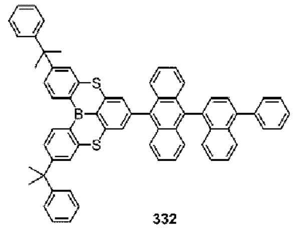

332

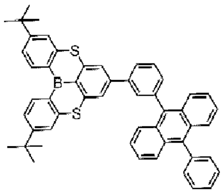

333

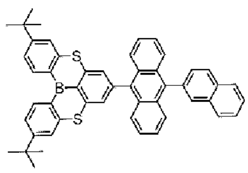

334

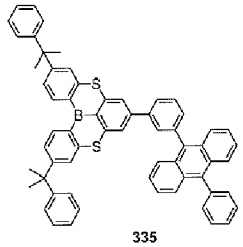

335

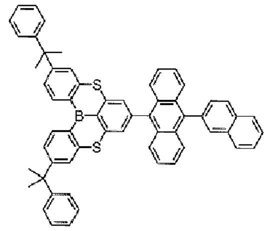

336

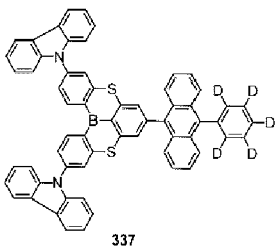

337

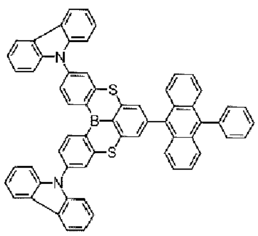

338

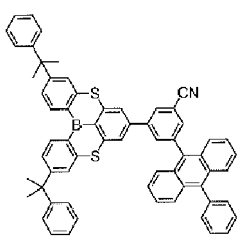

339

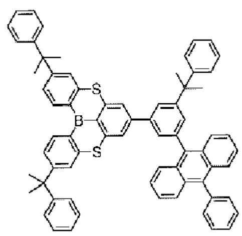

340

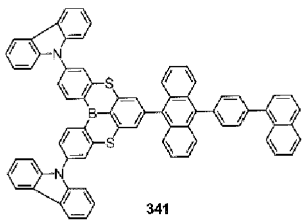

341

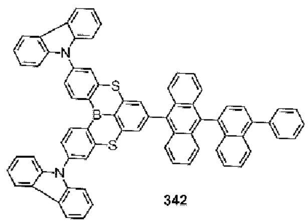

342

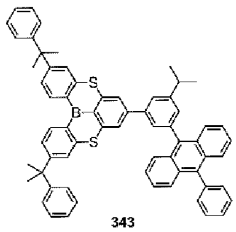

343

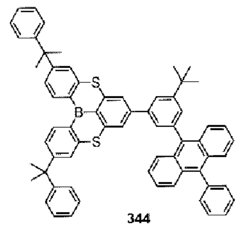

344

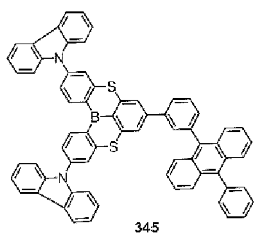

345

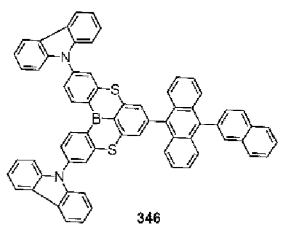

346

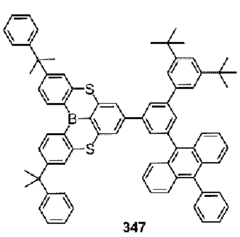

347

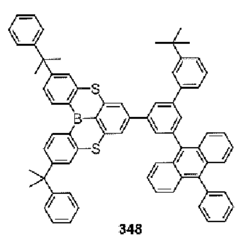

348

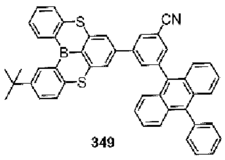
349

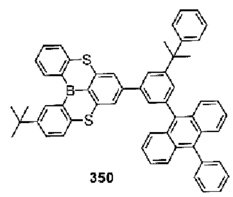
350

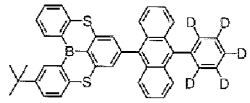
351

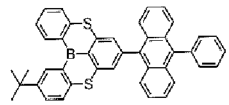
352

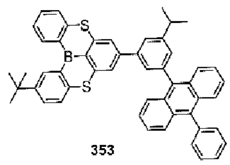
353

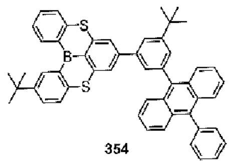
354

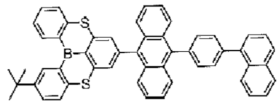
355

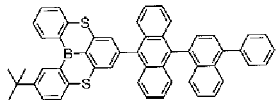
356

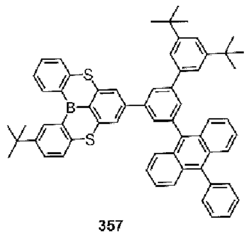
357

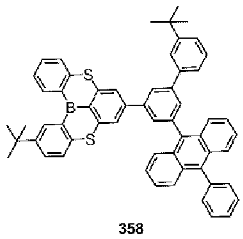
358

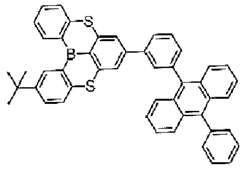
359

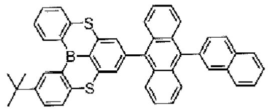
360

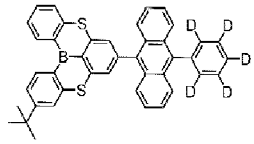
361

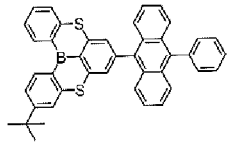
362

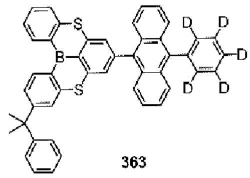
363

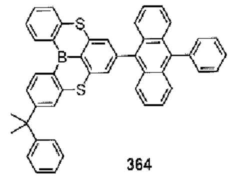
364

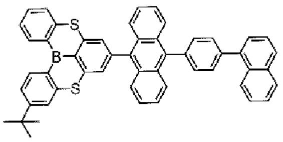
365

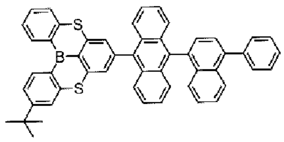
366

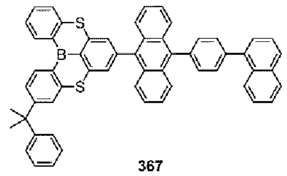
367

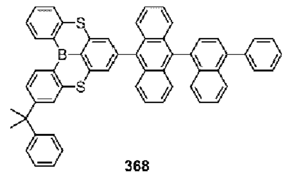
368

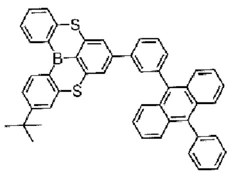
369

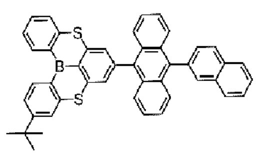
370

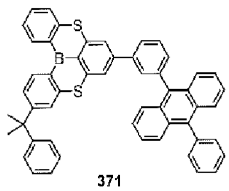
371

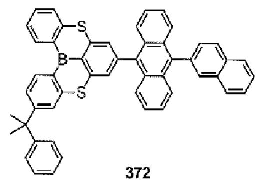
372

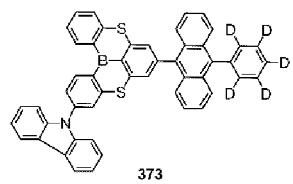
373

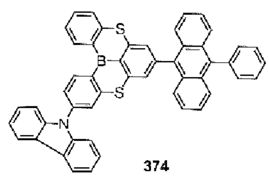
374

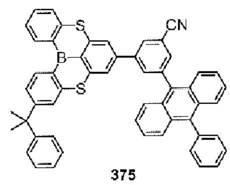
375

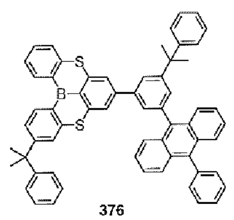
376

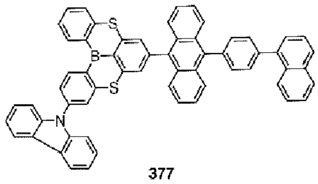
377

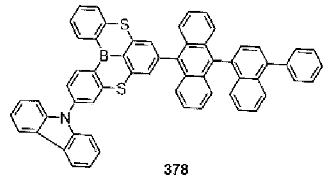
378

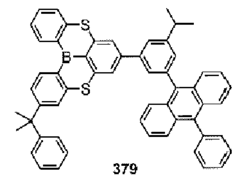
379

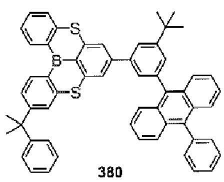
380

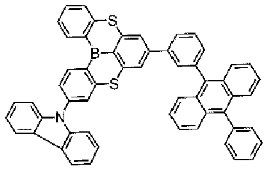
381

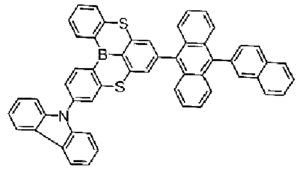
382

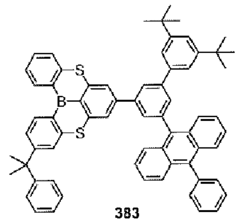
383

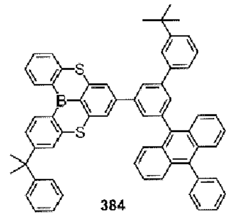
384

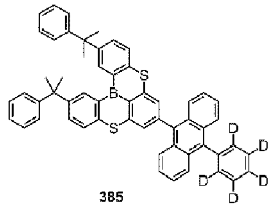
385

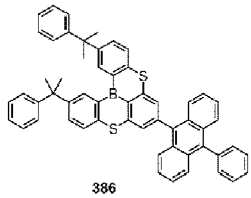
386

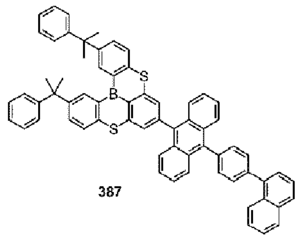
387

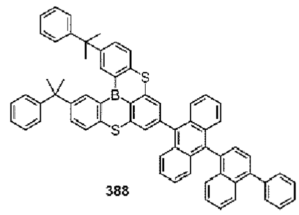
388

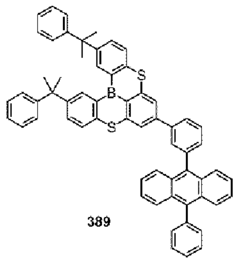
389

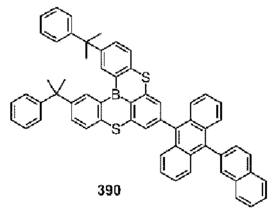
390

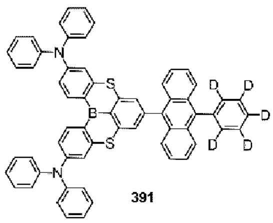
391

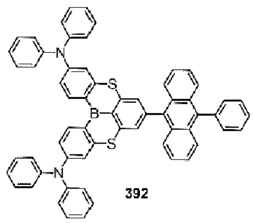
392

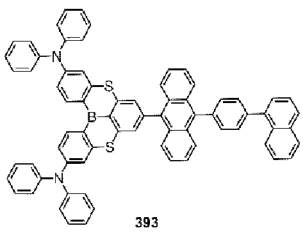
393

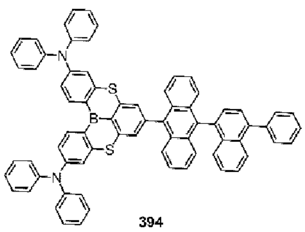
394

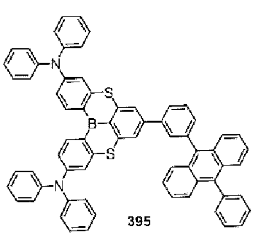
395

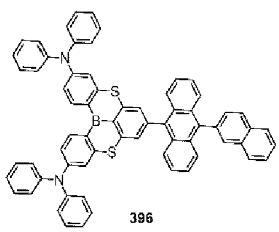
396

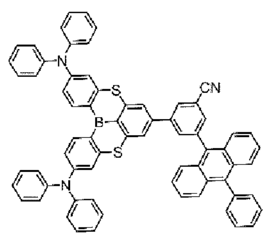
397

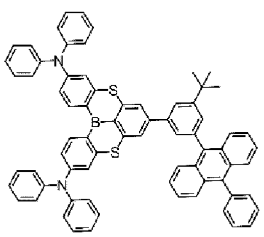
398

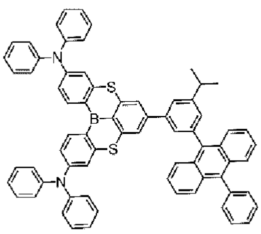
399

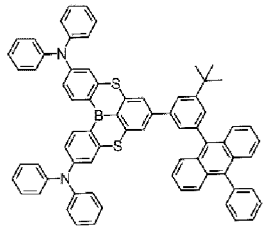
400

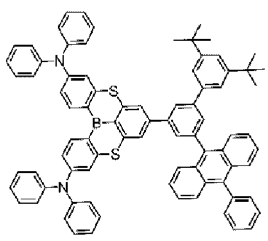
401

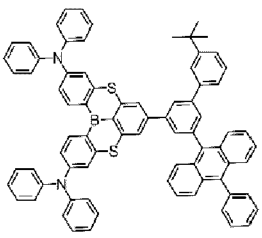
402

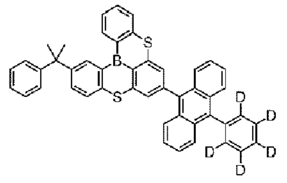
403

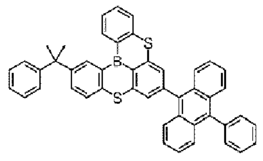
404

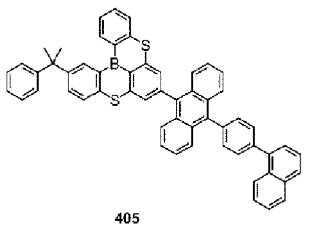
405

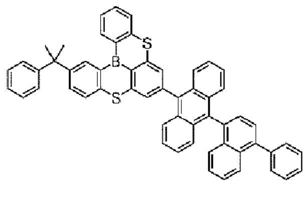
406

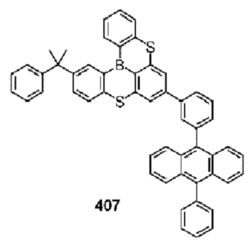
407

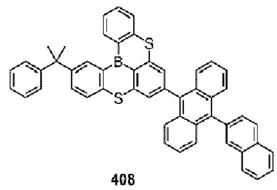
408

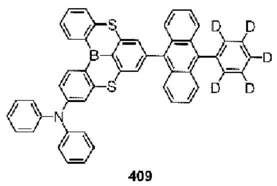
409

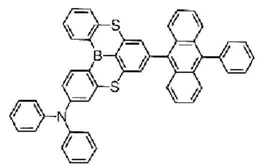
410

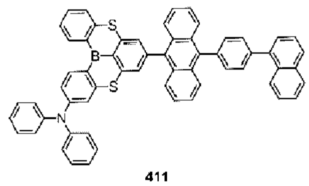
411

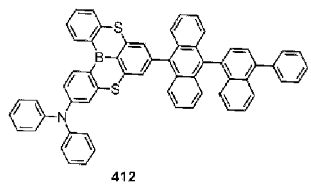
412

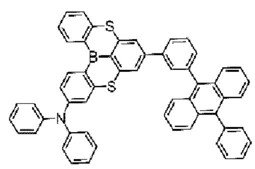
413

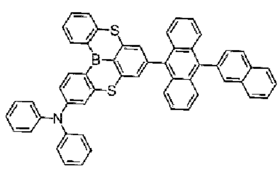
414

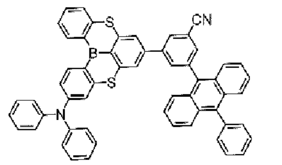
415

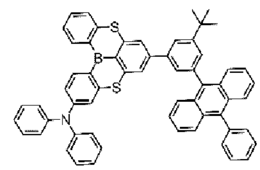
416

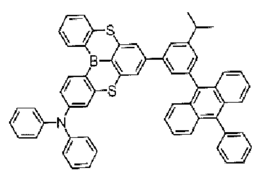
417

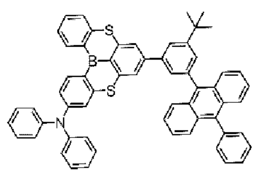
418

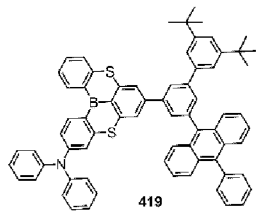
419

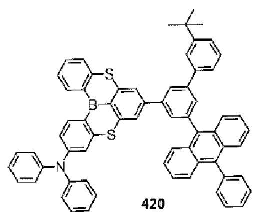
420

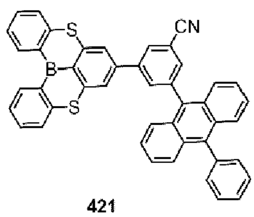
421

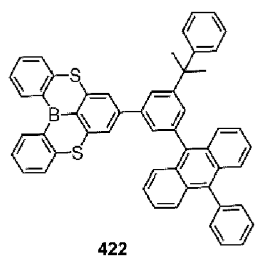
422

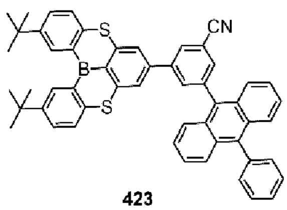
423

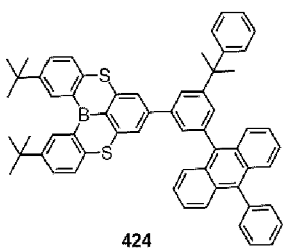
424

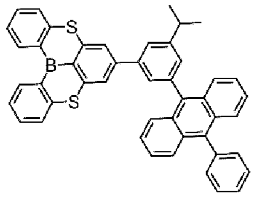
425

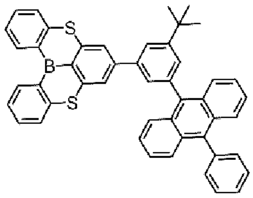
426

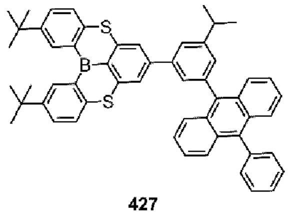
427

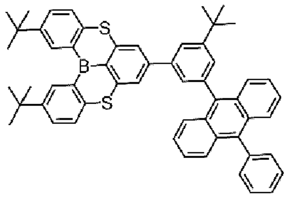
428

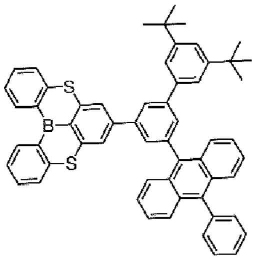
429

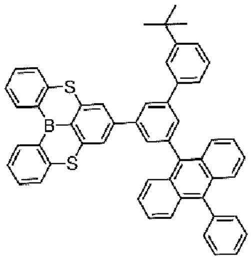
430

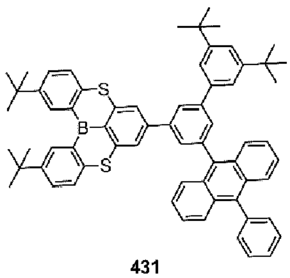
431

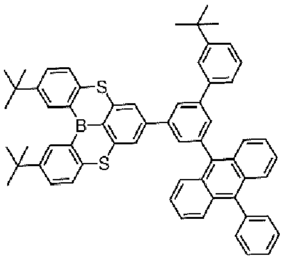
432

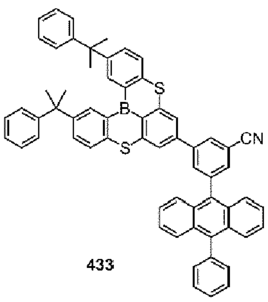
433

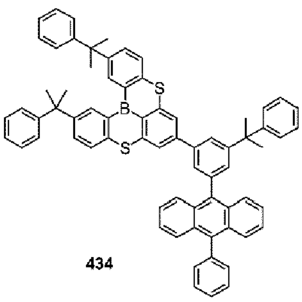
434

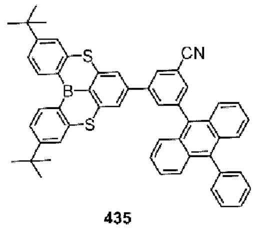
435

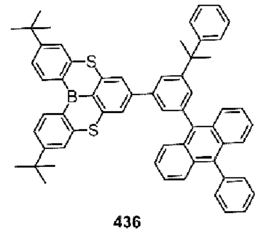
436

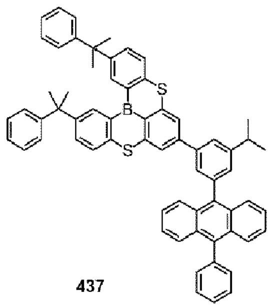
437

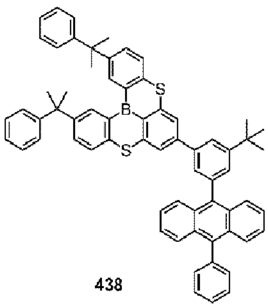
438

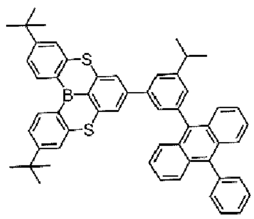
439

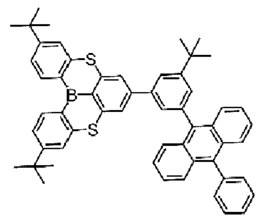
440

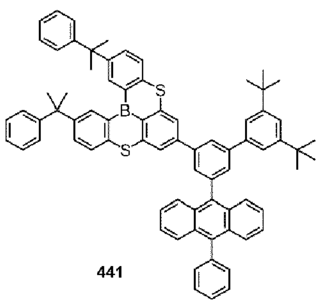
441

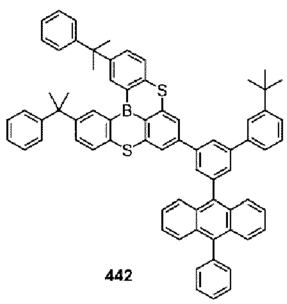
442

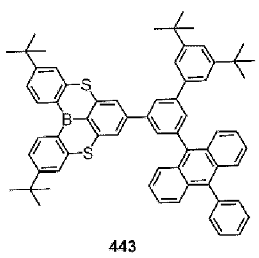
443

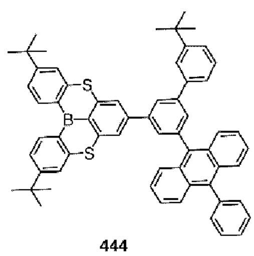
444

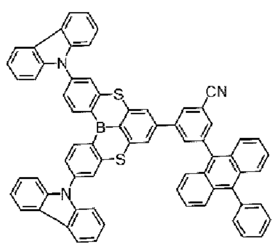
445

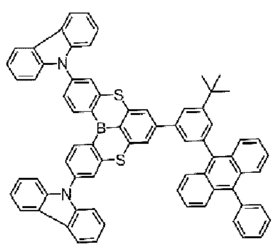
446

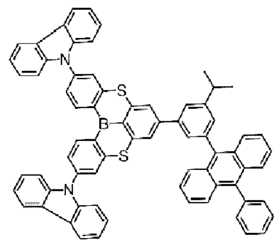
447

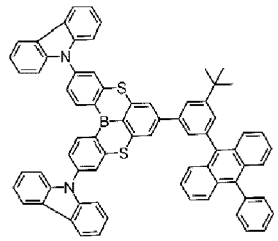
448

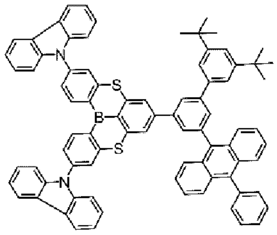
449

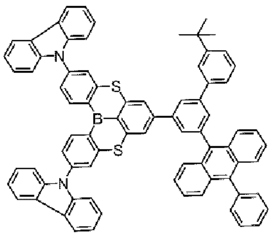
450

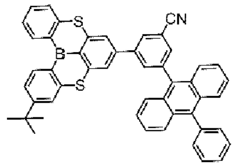
451

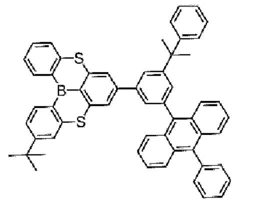
452

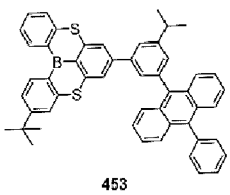
453

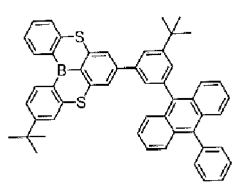
454

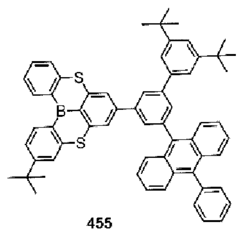
455

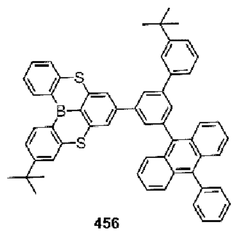
456

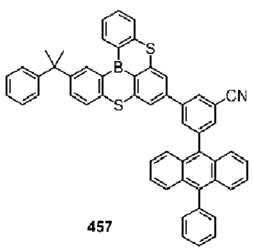
457

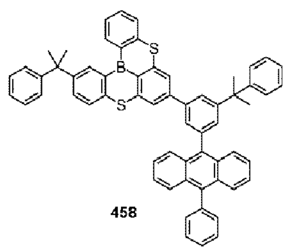
458

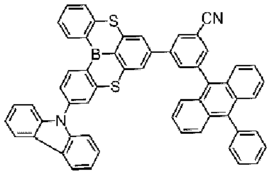
459

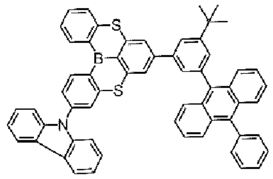
460

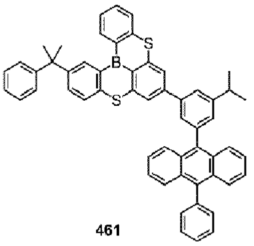
461

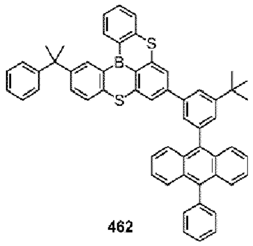
462

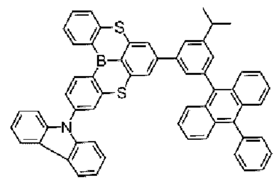
463

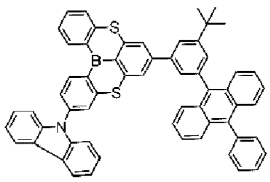
464

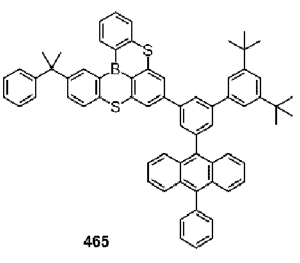
465

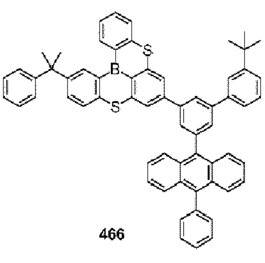
466

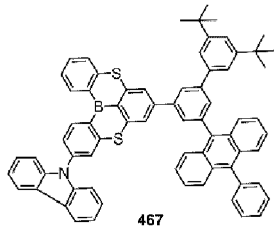
467

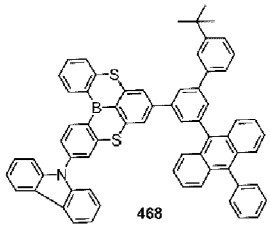
468

.

As Formula 1, in the polycyclic compound, an element $Y_1$-containing core may have a planar structure with multiple resonance and a rigid backbone condensed by sharing a benzene ring. Thus, the polycyclic compound may exhibit high colorimetric purity. At the same time, a fluorescent emitter represented by Formula 1 may include an anthracenyl group having a lowest excited triplet (T1*) similar to a lowest excited triplet (T1) of a core structure, and reverse intersystem crossing (RISC) by a spin orbit coupling (SOC) mechanism due to a resonance between T1 and T1* may be amplified, thus significantly improving efficiency.

A compound having a multiple resonance structure in the related art may achieve improvement in colorimetric purity, but may not achieve improvement in efficiency due to a reduced spatial overlapping between the highest occupied molecular orbital (HOMO) and the lowest unoccupied molecular orbital (LUMO). On the other hand, a donor-acceptor structure in which HOMO and LUMO are spaced apart spatially to decrease ΔEst value was suggested to improve the efficiency. In this embodiment, the efficiency was improved, however, oscillator strength was reduced to thereby reduce a colorimetric purity. The colorimetric purity and the efficiency are in a trade-off relationship.

However, as the organic light-emitting device according to one or more embodiments may include the polycyclic compound represented by Formula 1, the colorimetric purity and the efficiency may be both improved by a triple resonance mechanism that simultaneously uses multiple resonance mechanism and resonance mechanism between triplets.

In an embodiment, the polycyclic compound represented by Formula 1 may be a fluorescent emitter.

In an embodiment, the emission layer may further include a sensitizer that may satisfy Equation 1, and a content of the host may be greater than a total content of the sensitizer and the polycyclic compound:

Equation 1

$$\Delta E_{ST} \leq 0.3 \text{ eV}$$

wherein, in Equation 1, $\Delta E_{ST}$ represents an energy level gap between a lowest excited singlet energy level ($S_1$) and a lowest excited triplet energy level ($T_1$).

Here, the triplet energy level and the singlet energy level may be evaluated according to density functional theory (DFT) method, wherein structure optimization is performed at a degree of B3LYP, and 6-31G(d,p) according to Gaussian according to DFT method.

The sensitizer and the polycyclic compound may satisfy Conditions 1 and 2:

Condition 1

$$T_{decay}(PC) < T_{decay}(S)$$

Condition 2

$$T_{decay}(PC) < 1.5 \ \mu s$$

wherein, in Conditions 1 and 2,
$T_{decay}(PC)$ is a decay time of the polycyclic compound, and
$T_{decay}(S)$ is a decay time of the sensitizer.

The decay time of the polycyclic compound is calculated from a time-resolved photoluminescence spectrum (TRPL) at room temperature with respect to a 40 nm-thickness film (hereinafter referred to as "Film (CD)") obtained by vacuum-codepositing the host and the dopant comprised in the emission layer at the weight ratio of 90:10 on a quartz substrate at the vacuum pressure of $10^{-7}$ torr.

The decay time of the sensitizer is calculated from TRPL at room temperature with respect to a 40 nm-thickness film (hereinafter referred to as "Film (S)") obtained by vacuum-codepositing the host and the sensitizer comprised in the emission layer at the weight ratio of 90:10 on a quartz substrate at the vacuum pressure of $10^{-7}$ torr.

In general, it is known that since triplet excitons remain long in an excited state, they influence the decrease in the lifespan of organic light-emitting devices. However, according to the present disclosure, the polycyclic compound is used to reduce the time during which the triplet excitons of the sensitizer remains in the excited state. Accordingly, an organic light-emitting device including the polycyclic compound may have a prolonged lifespan.

In one or more embodiments, the more triplet excitons the sensitizer has, the more excess energy is accumulated in the sensitizer, resulting in more hot excitons. That is, the amount of triplet excitons of the sensitizer is proportional to

the amount of hot excitons. The hot excitons break down various chemical bonds of a compound included in an emission layer and/or a compound existing at the interface of the emission layer and other layers to degrade the compound. Accordingly, the lifespan of organic light-emitting devices may be reduced. However, according to the present disclosure, by using polycyclic compounds, the triplet excitons of the sensitizer can be quickly converted to singlet excitons of the polycyclic compound, ultimately reducing the amount of hot excitons and increasing the lifespan of an organic light-emitting device.

In this regard, "hot excitons" may be generated or increased by exciton-exciton annihilation due to an increase in the density of excitons in an emission layer, exciton-charge annihilation due to the charge imbalance in an emission layer, and/or radical ion pairs due to the delivery of electrons between a host and dopant(for example, the polycyclic compound).

In order to quickly convert triplet excitons of the sensitizer to singlet excitons of the polycyclic compound, Condition 1 should be satisfied.

In addition, since the polycyclic compound emits fluorescent light, a high color purity organic light-emitting device can be provided, and in particular, since Condition 2 is satisfied, so that the singlet excitons of the polycyclic compound excited state at room temperature can be rapidly transferred, and thus, the single state of the polycyclic compound in the excited state may not be accumulated, and the lifespan of an organic light-emitting device may be increased.

In addition, when Condition 3 is further satisfied, the transition from the triplet excitons of the sensitizer to the singlet excitons of the polycyclic compound may occur more smoothly. Accordingly, the lifespan of an organic light-emitting device may be further prolonged:

Condition 3

$$T_{decay}(PC) / T_{decay}(S) < 0.5$$

wherein, in Condition 3,
$T_{decay}(PC)$ is a decay time of the polycyclic compound, and
$T_{decay}(S)$ is a decay time of the sensitizer.

In one or more embodiments, the organic light-emitting device may further satisfy Condition 4:

Condition 4

$$BDE(S) - T_1(S) < 3.0\ eV$$

wherein, in Condition 4,
BDE (S) is the bond dissociation energy level of the sensitizer, and
$T_1$ (S) is the lowest excitation triplet energy level of the sensitizer.

Ultimately, the organic light-emitting device may have the target level of lifespan by satisfying Condition 5 below:

Condition 5

$$R(Hex)/e^{10} < 15$$

wherein, in Condition 5,
R (Hex) is the production rate of hot excitons.

In this regard, R (Hex) was subjected to the photochemical stability of the organic light-emitting device (photochemical stability), and then calculated through the Gaussian 09 program according to Equation C below.

Equation C

$$R(Hex) = a \times T_{decay}(S) \times e^{-(BDE(S) - T_1(S))}$$

wherein, in Equation C,
a is an arbitrary constant,
$T_{decay}(S)$ is a decay time of the sensitizer,
BDE (S) is the bond dissociation energy level of the sensitizer, and
$T_1$ (S) is the lowest excitation triplet energy level of the sensitizer.

The hot-exciton production rate is estimated to be proportional to (decay time) X e- $^{(BDE-T1)}$, and in order to obtain the target level of the lifespan of the organic light-emitting device, (hot-exciton production rate)/$e^{10}$ should be less than 15.

In this regard, the degradation analysis (PCS) of organic light-emitting devices was calculated according to the following Equation P:

Equation P

$$PCS\ (\%) = I_2 / I_1 \times 100$$

wherein, in Equation P,
$I_1$, with respect to a film formed by depositing a compound of which PCS is to be measured, is a maximum light intensity obtained from the PL spectrum which is evaluated at room temperature under Ar atmosphere where outside air is blocked immediately after the formation of the film by using a He-Cd laser (excitation wavelength = 325 nanometers, laser power density = 100 mW/$cm^2$) of KIMMON-KOHA Inc., and
$I_2$, with respect to a film formed by depositing a compound of which PCS is to be measured, is a maximum light intensity obtained from the PL spectrum which is evaluated at room temperature under Ar atmosphere where outside air is blocked, by exposing the film to light of the He-Cd laser (excitation wavelength = 325 nanometers and laser power density = 100 mW/$cm^2$) of KIMMON-KOHA Inc., which is a pumping laser which has been used to evaluate $I_1$, for 3 hours, and then, using He-Cd laser of KIMMON-KOHA Inc. (excitation wavelength = 325 nanometers). In the case of the sensitizer, reverse intersystem crossing (RISC) and/or intersystem crossing (ISC) actively occur, which allows excitons generated at the host to be delivered to the polycyclic compound.

Specifically, the general energy transfer of an organic light-emitting device according to an embodiment will be described with reference to FIG. 2A.

Singlet and triplet excitons are formed at the host in the emission layer, and the singlet and triplet excitons formed at the host are transferred to the sensitizer and then to the polycyclic compound through Forster energy transfer (FRET). At this time, in order to embody the high efficiency and long lifespan of the organic light-emitting device, it is necessary to control the hot excitons generated in the emission layer, which requires optimization of energy transfer.

Specifically, the general energy transfer of an organic light-emitting device (type I) according to an embodiment will be described with reference to FIG. 2B. This is the case when the sensitizer is a thermally activated delayed fluorescence (TADF) emitter satisfying the condition of $\Delta E_{ST} \leq 0.3$ eV.

The singlet excitons formed at the host, which is 25% of the total excitons, are transferred to the sensitizer through FRET, and the energy of triplet excitons formed at the host, which is 75% of the total excitons, is transferred to the singlet and triplet of the sensitizer, among which the energy delivered to triplet is subjected to RISC into singlet, and then, the singlet energy of the sensitizer is transferred to the polycyclic compound through FRET.

Specifically, the general energy transfer of an organic light-emitting device (type II) according to an embodiment will be described with reference to FIG. 2C. In this case, the sensitizer is an organic metallic compound including Pt.

The triplet excitons formed at the host, which is 75% of the total excitons, are transferred to the sensitizer through Dexter energy transfer, and the energy of singlet excitons formed at the host, which is 25% of the total excitons, is transferred to the singlet and triplet of the sensitizer, among which the energy delivered to singlet is subjected to ISC into triplet, and then, the triplet energy of the sensitizer is transferred to the polycyclic compound through FRET.

Accordingly, by transferring all the singlet excitons and triplet excitons generated in the emission layer to the dopant, an organic light-emitting device having improved efficiency can be obtained. In addition, since an organic light-emitting device can be obtained with significantly reduced energy loss, the lifespan characteristics of the organic light-emitting device can be improved.

The amount of the sensitizer in the emission layer may be from about 5 wt% to about 50 wt% with respect to the total weight of the emission layer. Within these ranges, it is possible to achieve effective energy transfer in the emission layer, and accordingly, an organic light-emitting device having high efficiency and long lifespan can be obtained.

In one or more embodiments, the host, the polycyclic compound, and the sensitizer may further satisfy Condition 6:

Condition 6

$$T_1(H) \geq T_1(S) \geq S_1(PC)$$

wherein, in Condition 6,
$T_1(H)$ is the lowest excitation triplet energy level of the host,
$S_1(PC)$ is the lowest excitation singlet energy level of the polycyclic compound, and
$T_1(S)$ is the lowest excitation triplet energy level of the sensitizer.

When the host, the polycyclic compound, and the sensitizer each satisfy Condition 6, triplet excitons may be effectively transferred from the emission layer to the polycyclic compound, and thus, an organic light-emitting device having improved efficiency may be obtained.

The emission layer may consist of the host, the polycyclic compound, and the sensitizer. That is, the emission layer may not further include materials other than the host, the polycyclic compound, and the sensitizer.

In one or more embodiments, the emission layer may further include a photoluminescent dopant, and a content of the host may be greater than a total content of the photoluminescent dopant and the polycyclic compound represented by Formula 1. The photoluminescent dopant may include a photoluminescent dopant having suitable $S_1$ and $T_1$ energy levels for receiving energy from an excited $S_1$ energy level of the polycyclic compound. In this embodiment, the polycyclic compound may serve as a sensitizer that may transfer energy, and the polycyclic compound and the photoluminescent dopant may equally satisfy the Equation for the sensitizer and the polycyclic compound.

A method of synthesizing the polycyclic compound represented by Formula 1 may be apparent to one of ordinary skill in the art by referring to Synthesis Examples provided herein.

In an embodiment, in the organic light-emitting device,
the first electrode may be an anode, the second electrode may be a cathode,
the organic layer may include a hole transport region between the first electrode and the emission layer and an electron transport region between the emission layer and the second electrode,
the hole transport region may include a hole injection layer, a hole transport layer, an electron blocking layer, a buffer layer, or a combination thereof, and
the electron transport region may include a hole blocking layer, an electron transport layer, an electron injection layer, or a combination thereof, but embodiments are not limited thereto.

The emission layer may emit blue light. For example, the blue light may have a wavelength in a range of about 440 nm to about 490 nm.

FIG. 1 is a schematic view of an exemplary embodiment of an organic light-emitting device 10. Hereinafter, the structure of an exemplary embodiment of an organic light-emitting device and an exemplary embodiment of a method of manufacturing an organic light-emitting device will be described in connection with FIG. 1. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent polymeric substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode may be, for example, indium tin oxide (ITO), indium zinc oxide (IZO), tin oxide ($SnO_2$), or zinc oxide (ZnO). In one or more embodiments, magnesium (Mg), aluminum (Al), aluminum-lithium (Al-Li), calcium (Ca), magnesium-indium (Mg-In), or magnesium-silver (Mg-Ag) may be used as the material for forming the first electrode.

The first electrode 11 may have a single-layered structure or a multi-layered structure including two or more layers. In an exemplary embodiment, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. In one or more embodiments, the hole transport region may have a hole injection layer/hole transport layer structure or a hole injection

layer/hole transport layer/electron blocking layer structure, which are sequentially stacked in this stated order from the first electrode 11.

A hole injection layer may be formed on the first electrode 11 by using one or more suitable methods selected from vacuum deposition, spin coating, casting, or Langmuir-Blodgett (LB) deposition.

When a hole injection layer is formed by vacuum deposition, the deposition conditions may vary according to a compound that is used to form the hole injection layer, and the structure and thermal characteristics of the hole injection layer. In an exemplary embodiment, the deposition conditions may include a deposition temperature of about 100 °C to about 500 °C, a vacuum pressure of about $10^{-8}$ torr to about $10^{-3}$ torr, and a deposition rate of about 0.01 Å/sec to about 100 Å/sec. However, the deposition conditions are not limited thereto.

When the hole injection layer is formed using spin coating, coating conditions may vary according to the material used to form the hole injection layer, and the structure and thermal properties of the hole injection layer. In an exemplary embodiment, a coating speed may be from about 2,000 rpm to about 5,000 rpm, and a temperature at which a heat treatment is performed to remove a solvent after coating may be from about 80 °C to about 200 °C. However, the coating conditions are not limited thereto.

Conditions for forming a hole transport layer and an electron blocking layer may be understood by referring to conditions for forming the hole injection layer.

The hole transport region may include m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202, or a combination thereof:

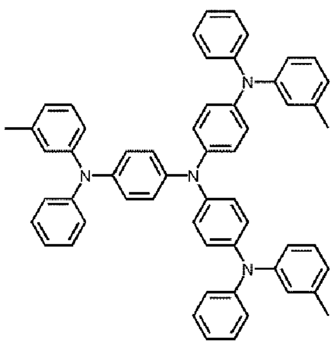

m-MTDATA

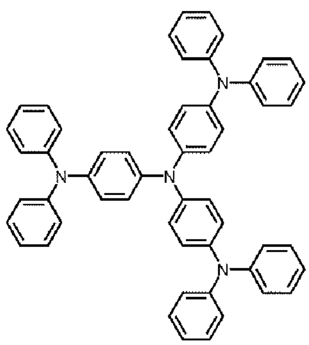

TDATA

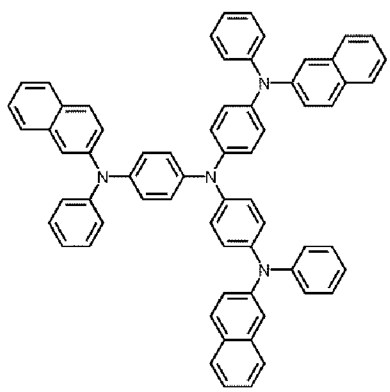

2-TNATA

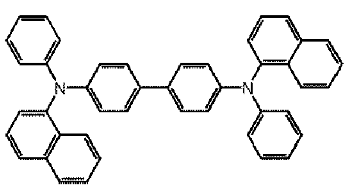

NPB

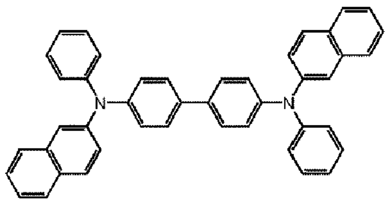

β-NPB

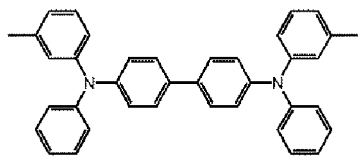

TPD

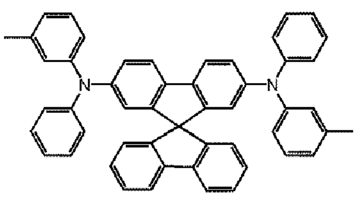

Spiro-TPD

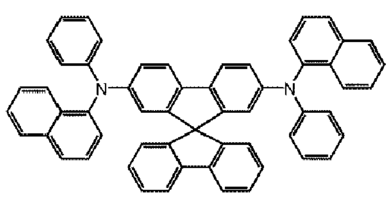

Spiro-NPB

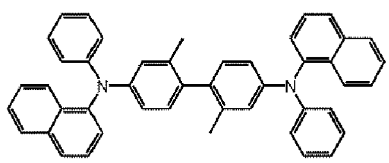

methylated NPB

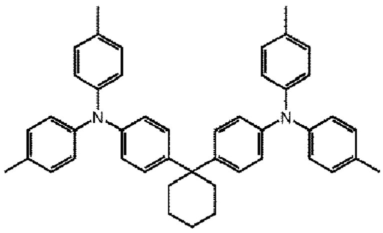

TAPC

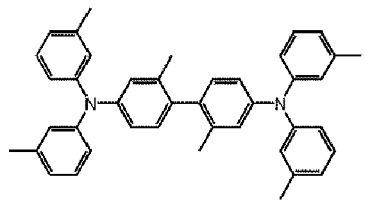

HMTPD

Formula 201

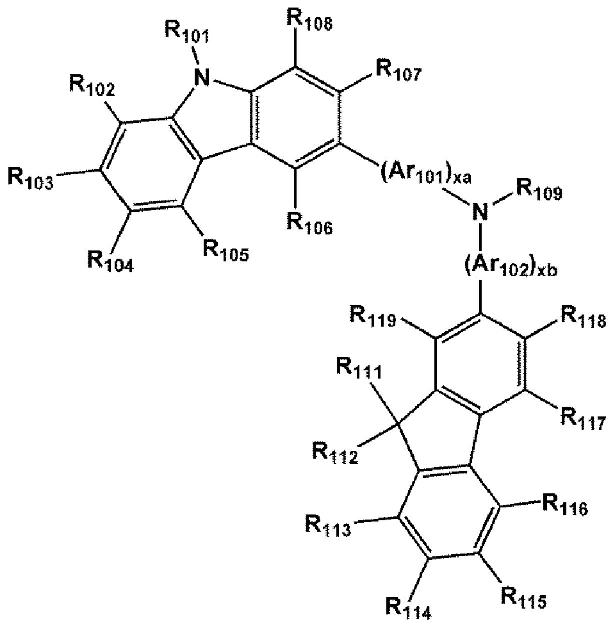

Formula 202

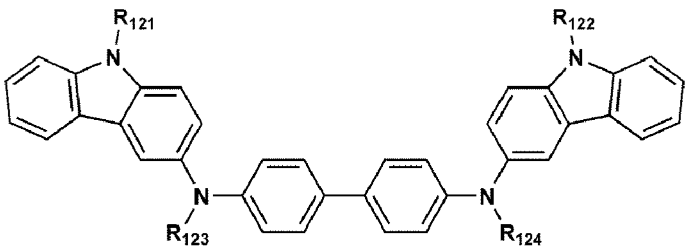

.

$Ar_{101}$ and $Ar_{102}$ in Formula 201 may each independently be:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group; or a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each substituted with a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a

$C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group.

In Formula 201, xa and xb may each independently be an integer from 0 to 5, or may be 0, 1, or 2. In an exemplary embodiment, xa may be 1 and xb may be 0, but embodiments of the present disclosure are not limited thereto.
$R_{101}$ to $R_{108}$, $R_{111}$ to $R_{119}$, and $R_{121}$ to $R_{124}$ in Formulae 201 and 202 may each independently be:

a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a $C_1$-$C_{10}$ alkyl group (for example, a methyl group, an ethyl group, a propyl group, a butyl group, a pentyl group, a hexyl group, and the like), or a $C_1$-$C_{10}$ alkoxy group (for example, a methoxy group, an ethoxy group, a propoxy group, a butoxy group, a pentoxy group, and the like);
a $C_1$-$C_{10}$ alkyl group or a $C_1$-$C_{10}$ alkoxy group, each substituted with a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof;
a phenyl group, a naphthyl group, an anthracenyl group, a fluorenyl group, and a pyrenyl group; or
a phenyl group, a naphthyl group, an anthracenyl group, a fluorenyl group, and a pyrenyl group, each substituted with a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, or a combination thereof, but embodiments of the present disclosure are not limited thereto.
$R_{109}$ in Formula 201 may be: a phenyl group, a naphthyl group, an anthracenyl group, and a pyridinyl group; or
a phenyl group, a naphthyl group, an anthracenyl group, and a pyridinyl group, each substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyridinyl group, or a combination thereof..

In one embodiment, the compound represented by Formula 201 may be represented by Formula 201A, but embodiments of the present disclosure are not limited thereto:

Formula 201A

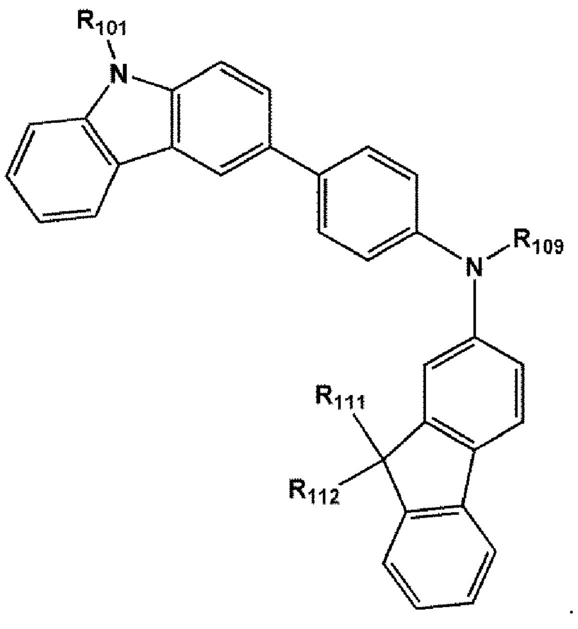

$R_{101}$, $R_{111}$, $R_{112}$, and $R_{109}$ in Formula 201A are the same as described above.

In an exemplary embodiment, the compound represented by Formula 201, and the compound represented by Formula 202 may include Compounds HT1 to HT20, but embodiments of the present disclosure are not limited thereto:

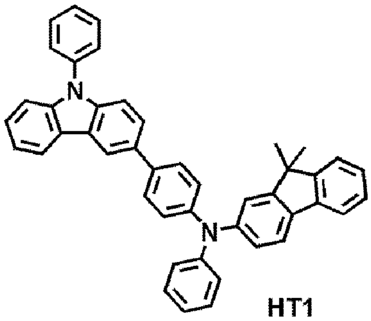
HT1

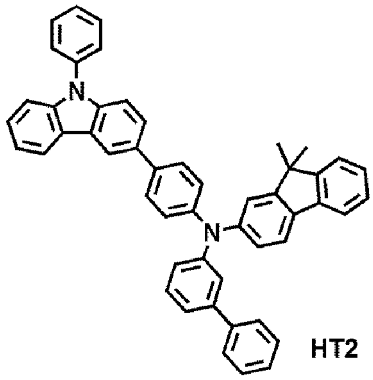
HT2

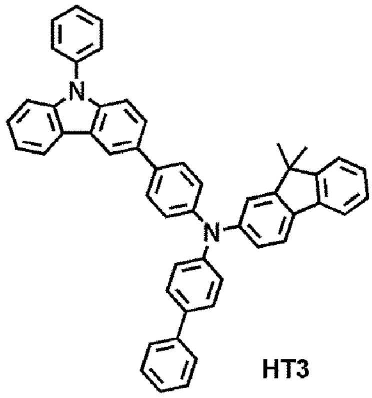
HT3

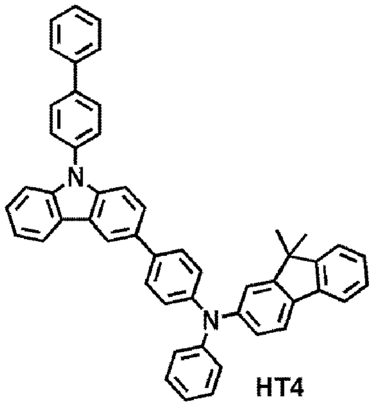
HT4

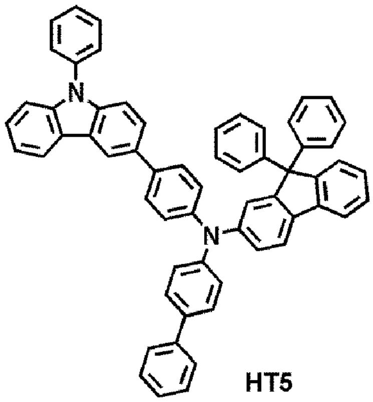
HT5

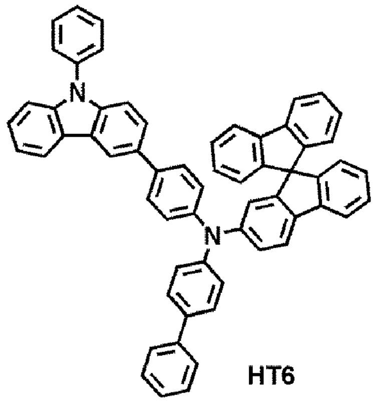
HT6

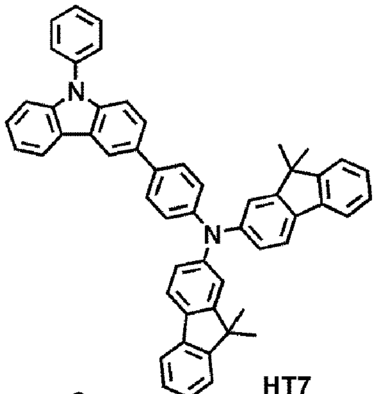
HT7

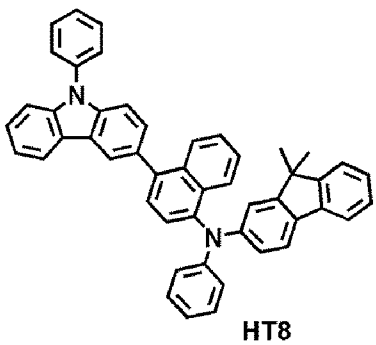
HT8

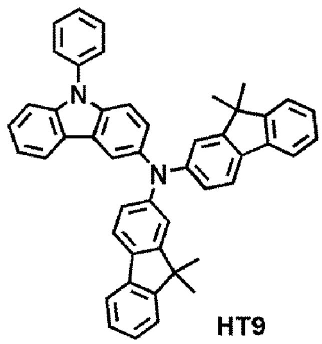
HT9

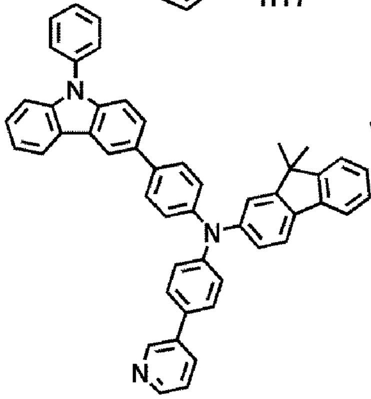
HT10

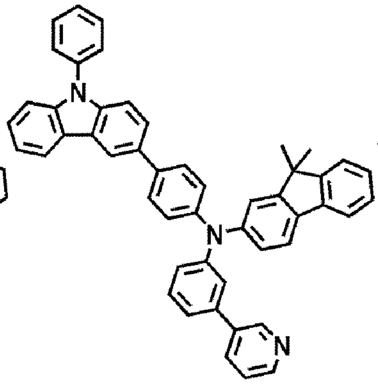
HT11

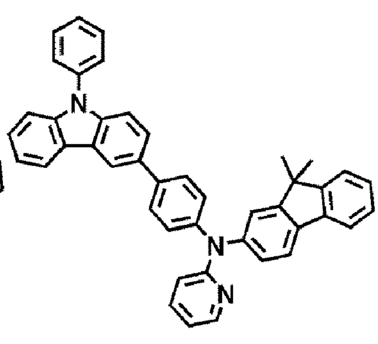
HT12

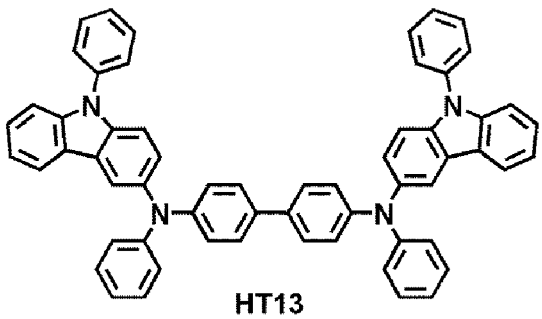

HT13

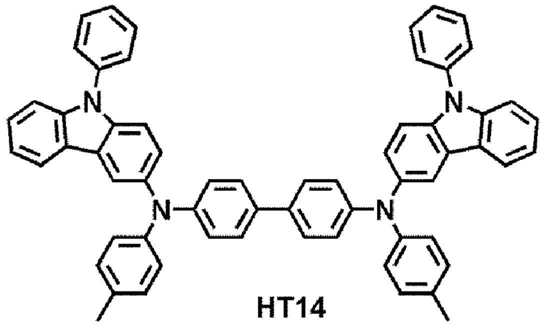

HT14

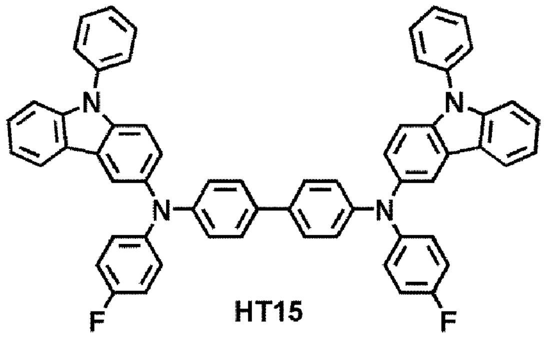

HT15

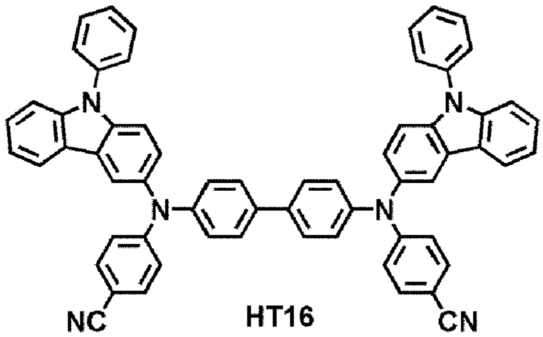

HT16

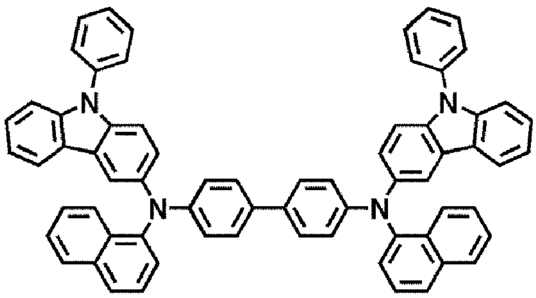

HT17

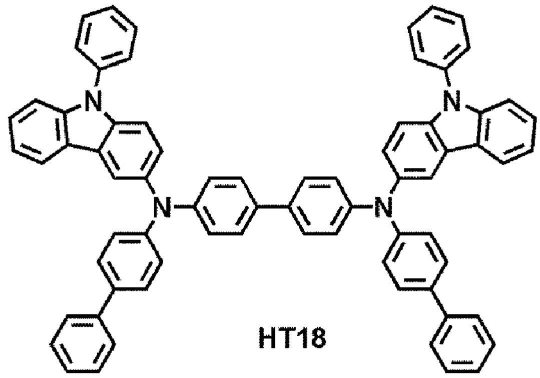

HT18

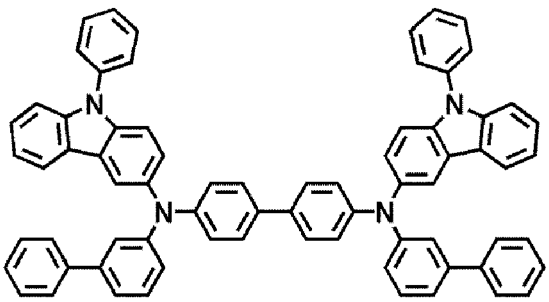

HT19

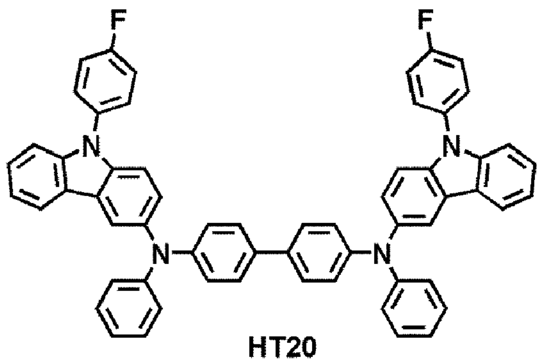

HT20

A thickness of the hole transport region may be in a range of about 100 Å to about 10,000 Å, for example, about 100 Å to about 1,000 Å. When the hole transport region includes a hole injection layer and a hole transport layer, the thickness of the hole injection layer may be in a range of about 100 Å to about 10,000 Å, and for example, about 100 Å to about 1,000 Å, and the thickness of the hole transport layer may be in a range of about 50 Å to about 2,000 Å, and for example, about 100 Å to about 1,500 Å. When the thicknesses of the hole transport region, the hole injection layer, and the hole transport layer are within these ranges, satisfactory hole transporting characteristics may be obtained

without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be a quinone derivative, a metal oxide, or a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenum oxide; and a cyano group-containing compound, such as Compound HT-D1 or Compound HT-D2 below, but are not limited thereto:

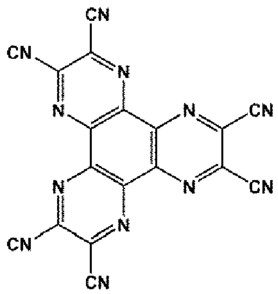

HT-D1

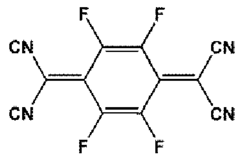

F4-TCNQ

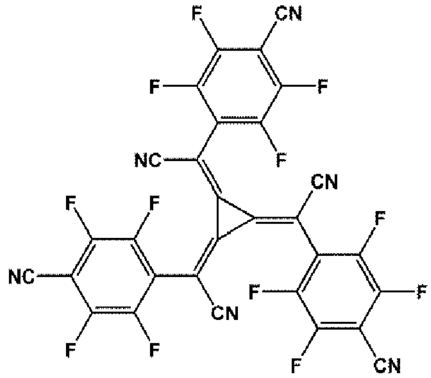

HT-D2 .

The hole transport region may include a buffer layer.

Also, the buffer layer may compensate for an optical resonance distance according to a wavelength of light emitted from the emission layer, and thus, efficiency of a formed organic light-emitting device may be improved.

The electron transport region may further include an electron blocking layer. The electron blocking layer may include, for example, mCP, but a material therefor is not limited thereto:

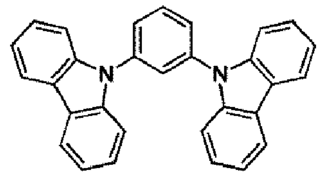

mCP .

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

The emission layer may include a host and a dopant, and the dopant may include the polycyclic compound represented by Formula 1.

The host may include at least one TPBi, TBADN, ADN (also referred to as "DNA"), CBP, CDBP, TCP, mCP, and Compound H50 to Compound H52:

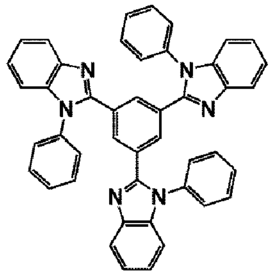

TPBi

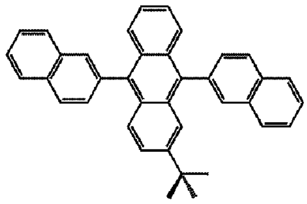

TBADN

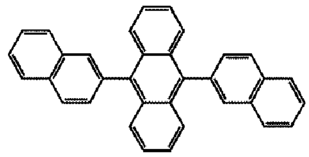

ADN

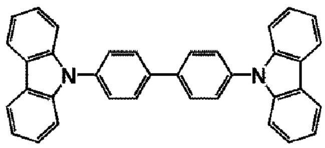

CBP

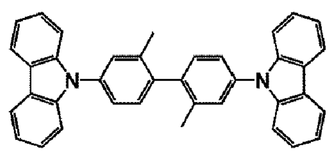

CDBP

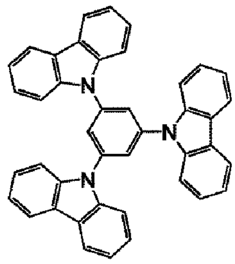

TCP

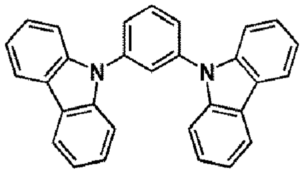

mCP

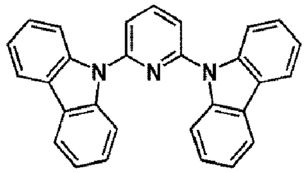

H50

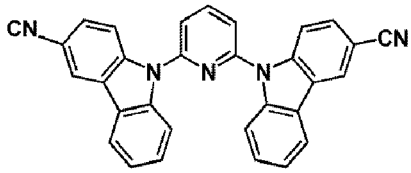

H51

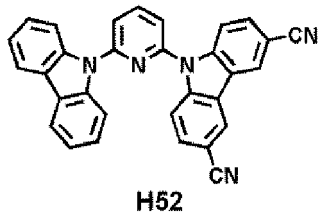

H52

.

In one or more embodiments, the host may further include a compound represented by Formula 301 below.

Formula 301

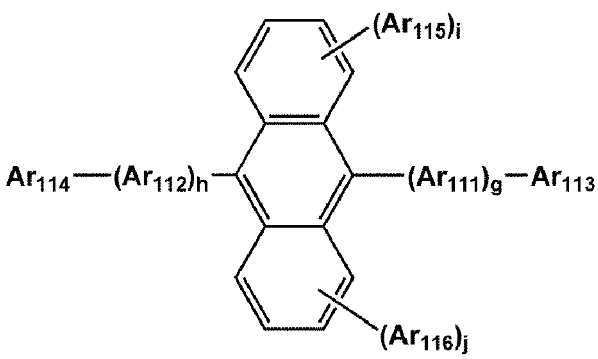

.

$Ar_{111}$ and $Ar_{112}$ in Formula 301 may each independently be:

a phenylene group, a naphthylene group, a phenanthrenylene group, a pyrenylene group, or any combination thereof; or

a phenylene group, a naphthylene group, a phenanthrenylene group, a pyrenylene group, or any combination thereof, each substituted with at least one of a phenyl group, a naphthyl group, an anthracenyl group, or any combination thereof.

$Ar_{113}$ to $Ar_{116}$ in Formula 301 may each independently be:

a $C_1$-$C_{10}$ alkyl group, a phenyl group, a naphthyl group, a phenanthrenyl group, a pyrenyl group, or any combination thereof; or

a phenyl group, a naphthyl group, a phenanthrenyl group, a pyrenyl group, or any combination thereof, each substituted with at least one a phenyl group, a naphthyl group, an anthracenyl group, or any combination thereof.

g, h, i, and j in Formula 301 may each independently be an integer from 0 to 4 and may be, for example, 0, 1, or 2.

$Ar_{113}$ to $Ar_{116}$ in Formula 301 may each independently be:

a $C_1$-$C_{10}$ alkyl group, substituted with at least one a phenyl group, a naphthyl group, an anthracenyl group, or any combination thereof;

a phenyl group, a naphthyl group, an anthracenyl group, a pyrenyl, a phenanthrenyl group, a fluorenyl group, or any combination thereof;

a phenyl group, a naphthyl group, an anthracenyl group, a pyrenyl group, a phenanthrenyl group, a fluorenyl group, or any combination thereof, each substituted with at least one deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a phenyl group, a naphthyl group, an anthracenyl group, a pyrenyl group, a phenanthrenyl group, a fluorenyl group, or any combination thereof; or

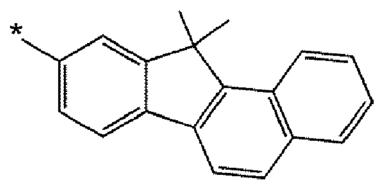
;

but embodiments of the present disclosure are not limited thereto.

In one or more embodiments, the host may include a compound represented by Formula 302 below:

Formula 302

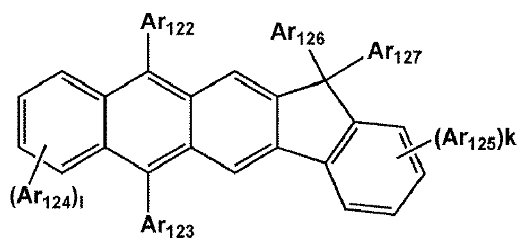

$Ar_{122}$ to $Ar_{125}$ in Formula 302 are the same as described in detail in connection with $Ar_{113}$ in Formula 301.

$Ar_{126}$ and $Ar_{127}$ in Formula 302 may each independently be a $C_1$-$C_{10}$ alkyl group (for example, a methyl group, an ethyl group, or a propyl group).

k and l in Formula 302 may each independently be an integer from 0 to 4. For example, k and l may be 0, 1, or 2.

When the emission layer includes a host and a dopant, an amount of the dopant may be in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. When the thickness of the emission layer is within any of these ranges, excellent light-emission characteristics may be obtained without a substantial increase in driving voltage.

Then, an electron transport region may be disposed on the emission layer.

The electron transport region may include a hole blocking layer, an electron transport layer, an electron injection layer, or a combination thereof.

In an exemplary embodiment, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP and Bphen, but may also include other materials:

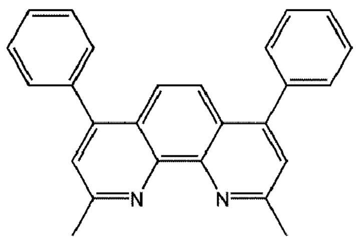

BCP

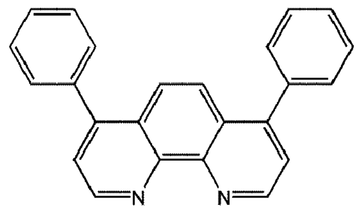

Bphen .

A thickness of the hole blocking layer may be in a range of about 20 Å to about 1,000 Å, for example, about 30 Å to about 300 Å. When the thickness of the hole blocking layer is within these ranges, the hole blocking layer may have improved hole blocking ability without a substantial increase in driving voltage.

The electron transport layer may further include BCP, Bphen, $Alq_3$, BAlq, TAZ, NTAZ, or a combination thereof.

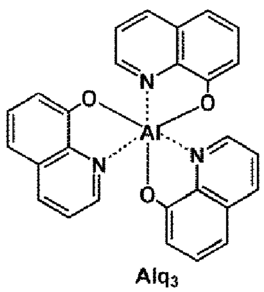

$Alq_3$

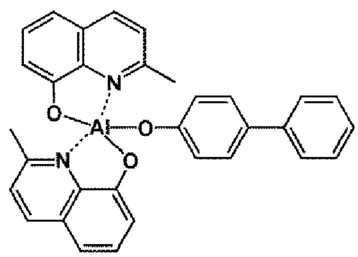

BAlq

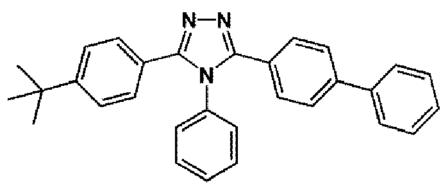

TAZ

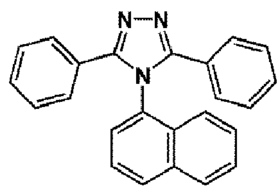

NTAZ

In one or more embodiments, the electron transport layer may include ET1 to ET25, but are not limited thereto:

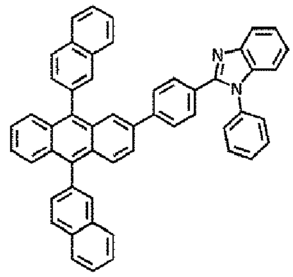

ET1

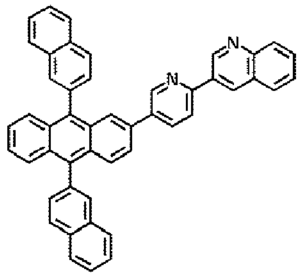

ET2

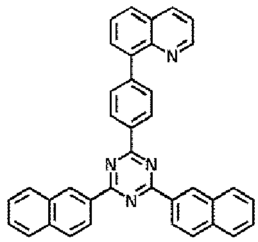

ET3

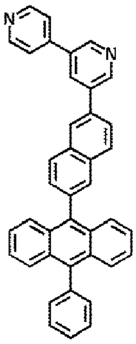

ET4

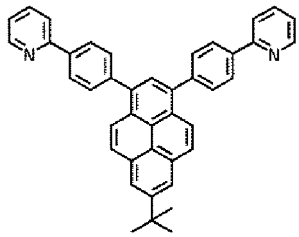

ET5

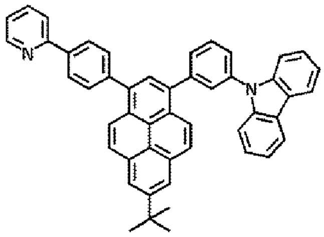

ET6

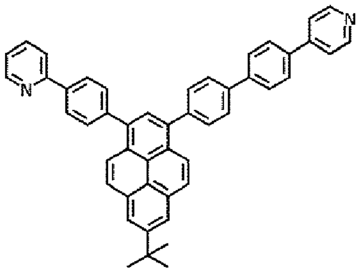

ET7

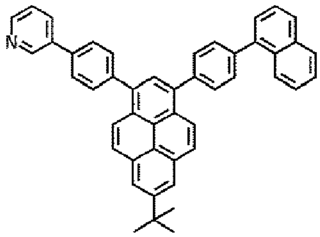

ET8

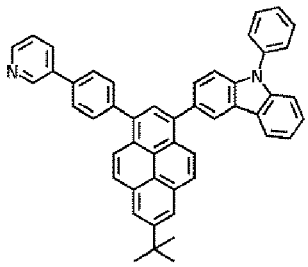

ET9

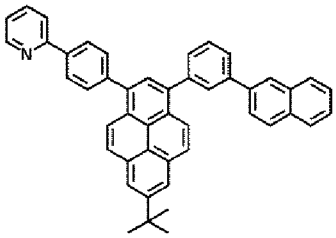

ET10

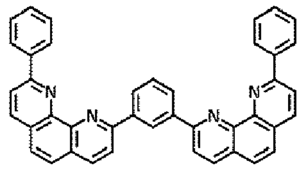

ET11

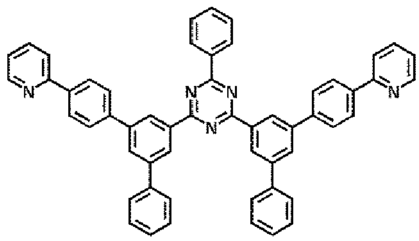

ET12

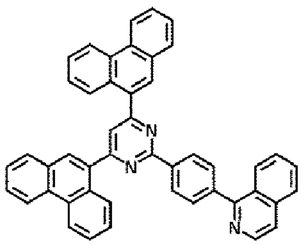

ET13

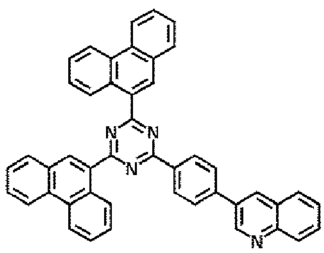

ET14

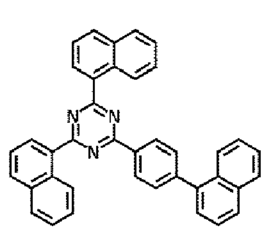

ET15

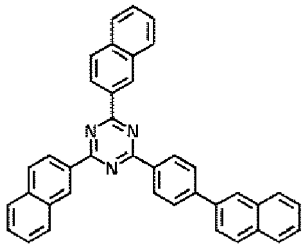

ET16

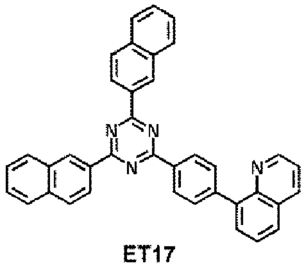

ET17

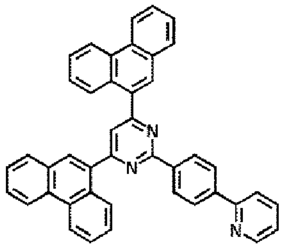

ET18

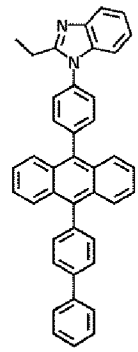

ET19

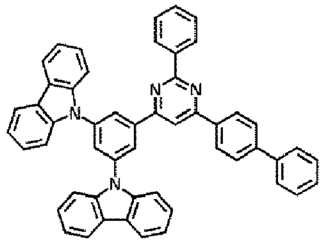

ET20

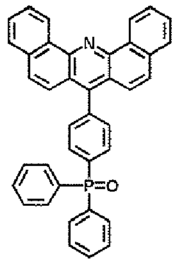

ET21

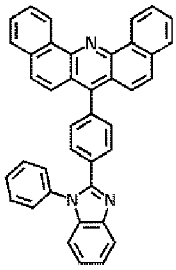

ET22

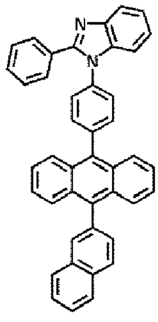

ET23

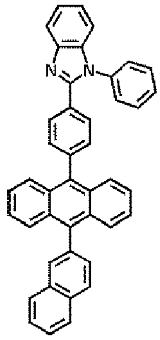

ET24

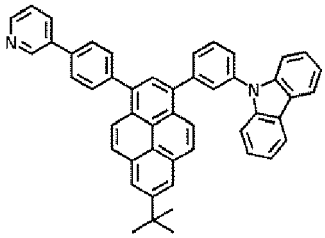

ET25

A thickness of the electron transport layer may be in a range of about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Lithium (Li) complex. The Li complex may include, for example, Compound ET-D1 (lithium 8-hydroxyquinolate, LiQ) or ET-D2:

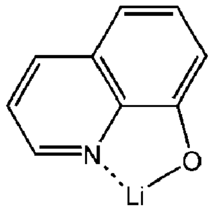

ET-D1

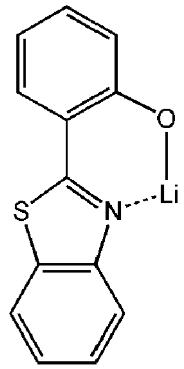

ET-D2

The electron transport region may include an electron injection layer (EIL) that promotes flow of electrons from the second electrode 19 thereinto.

The electron injection layer may include LiF, NaCl, CsF, $Li_2O$, BaO, or a combination thereof.

A thickness of the electron injection layer may be in a range of about 1 Å to about 100 Å, for example, about 3 Å to about 90 Å. When the thickness of the electron injection layer is within the range described above, the electron injection layer may have satisfactory electron injection characteristics without a substantial increase in driving voltage.

The second electrode 19 may be formed on the organic layer 15. The second electrode 19 may be a cathode. A material for forming the second electrode 19 may be selected from metal, an alloy, an electrically conductive compound, and a combination thereof, which have a relatively low work function. In an exemplary embodiment, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to FIG. 1, but embodiments of the present disclosure are not limited thereto.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group.

The term "$C_1$-$C_{30}$ heterocyclic group" as used herein refers to a saturated or unsaturated cyclic group having, as a ring-forming atom, at least one N, O, P, Si, S, or any combination thereof other than 1 to 30 carbon atoms. The $C_1$-$C_{30}$ heterocyclic group may be a monocyclic group or a polycyclic group.

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an isoamyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" as used herein refers to a monovalent group represented by $-OA_{101}$ (wherein $A_{101}$ is the $C_1$-$C_{60}$ alkyl group), and non-limiting examples thereof include a methoxy group, an ethoxy group, and an isopropyloxy group.

The term "$C_2$-$C_{60}$ alkenyl group" as used herein refers to a hydrocarbon group formed by substituting at least one double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si and S as a ring-forming atom and 1 to 10 carbon atoms, and

non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one double bond in its ring. Non-limiting examples of the $C_1$-$C_{10}$ heterocycloalkenyl group include a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_1$-$C_{60}$ heteroaryl group" as used herein refers to a monovalent group having a heterocyclic aromatic system that has at least one heteroatom selected from N, O, P, Si, and S as a ring-forming atom, and 1 to 60 carbon atoms. The term "$C_2$-$C_{60}$ heteroarylene group," as used herein refers to a divalent group having a heterocyclic aromatic system that has at least one heteroatom selected from N, O, P, Si, and S as a ring-forming atom, and 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_6$-$C_{60}$ aryloxy group" as used herein refers to $-OA_{102}$ (wherein $A_{102}$ is the $C_6$-$C_{60}$ aryl group), and a $C_6$-$C_{60}$ arylthio group used herein indicates $-SA_{103}$ (wherein $A_{103}$ is the $C_6$-$C_{60}$ aryl group).

The term "$C_7$-$C_{60}$ arylalkyl group" as used herein refers to $-A_{104}A_{105}$ (wherein $A_{104}$ is $C_1$-$C_{54}$ alkyl group, and $A_{105}$ is $C_6$-$C_{59}$ aryl group). Non-limiting example of the $C_7$-$C_{60}$ arylalkyl group is a cumyl group.

The term "monovalent non-aromatic condensed polycyclic group" as used herein refers to a monovalent group having two or more rings condensed to each other, only carbon atoms (for example, the number of carbon atoms may be in a range of 8 to 60) as a ring-forming atom, and no aromaticity in its entire molecular structure. Non-limiting examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group having two or more rings condensed to each other, a heteroatom selected from N, O, P, Si, and S, other than carbon atoms (for example, the number of carbon atoms may be in a range of 2 to 60), as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

At least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted monovalent non-aromatic condensed polycyclic group, and the substituted monovalent non-aromatic condensed heteropolycyclic group may be:

a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a

$C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -Si($Q_{11}$)($Q_{12}$)($Q_{13}$), -N($Q_{14}$)($Q_{15}$),-B($Q_{16}$)($Q_{17}$), -P(=O)($Q_{18}$)($Q_{19}$) or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, and a monovalent non-aromatic condensed heteropolycyclic group, each substituted with a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, a monovalent non-aromatic condensed heteropolycyclic group, -Si($Q_{21}$)($Q_{22}$)($Q_{23}$), -N($Q_{24}$)($Q_{25}$), -B($Q_{26}$)($Q_{27}$), -P(=O)($Q_{28}$)($Q_{29}$) or a combination thereof,

-si($Q_{31}$)($Q_{32}$)($Q_{33}$), -N($Q_{34}$)($Q_{35}$), -B($Q_{36}$)($Q_{37}$), -P(=O)($Q_{38}$)($Q_{39}$) and

$Q_1$ to $Q_9$, $Q_{11}$ to $Q_{19}$, $Q_{21}$ to $Q_{29}$, and $Q_{31}$ to $Q_{39}$ may each independently be a hydrogen, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

The term "room temperature" as used herein refers to about 25°C.

The terms "biphenyl group" and "terphenyl group" as used herein each refer to a monovalent group in which two or three benzene groups are linked to each other via a single bond, respectively.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

**Examples**

**Synthesis Example 1: Synthesis of Compound 158**

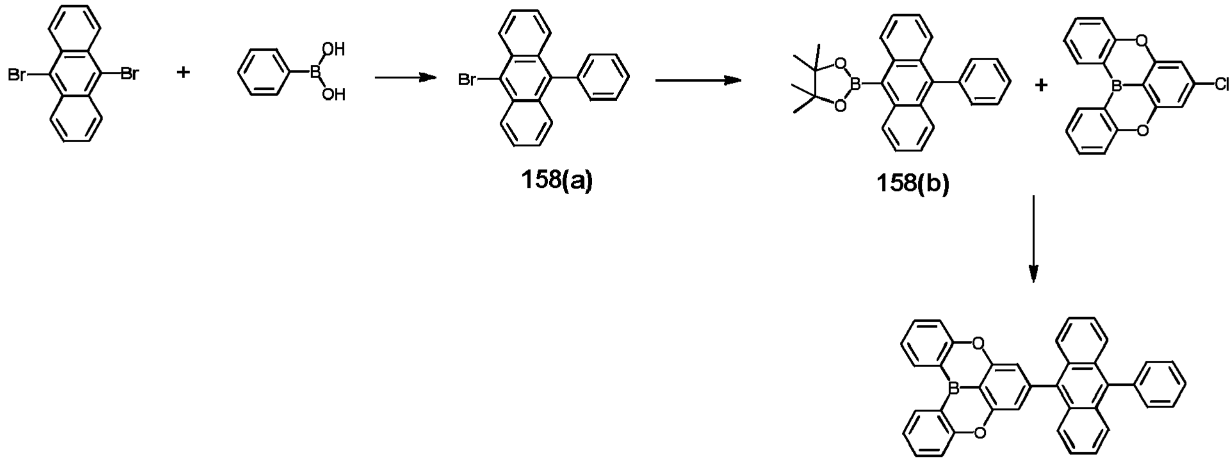

158(a) 158(b) 158

**Synthesis of Intermediate 158(a)**

2.09 grams (g) (17.11 millimole (mmol)) of phenylboronic acid, 5.0 g (14.88 mmol) of 9,10-dibromoanthracene, 1.72 g (1.49 mmol) of palladium tetrakis(triphenylphosphine) ($Pd(PPh_3)_4$), 4.11 g (29.76 mmol) of potassium carbonate, $K_2CO_3$, and 1.22 g (2.98 mmol) of S-phos were added to 50 milliliters (mL) of tetrahydrofuran and 50 mL of distilled water, followed by heating under reflux. Once the reaction was complete, the resulting mixture was cooled to room temperature. Then an organic layer was extracted therefrom using ethyl acetate, and the resulting organic layer was dried using anhydrous sodium sulfate ($Na_2SO_4$) for concentration, followed by separation through silica gel column chromatography (dichloromethane/hexane). The solid resulting therefrom was recrystallized using hexane to thereby obtain 4.23 g (14.88 mmol) of white solid, Intermediate 158(a) (yield: 85 %).
LC-Mass Spectrometry (calculated value: 333.23 g/mol, found value: 334.2 g/mol (M+1))

**Synthesis of Intermediate 158(b)**

4.2 g (12.60 mmol) of Intermediate 158(a), 4.8 g (18.91 mmol) of bis(pinacolato)diboron, 3.09 g (31.51 mmol) of potassium acetate, (AcOK), and 0.46 g (0.63 mmol) of 1,1'-bis(diphenylphosphino)ferrocene] palladium(II) dichloride, $Pd(dppf)Cl_2$ were added to a reaction vessel, and the mixture was dissolved in 30 mL of dioxane and stirred at a temperature of 100 °C. Once the reaction was complete, the resulting mixture was cooled to room temperature, and an extraction process was performed by using ethyl acetate and water to thereby obtain an organic layer. The obtained organic layer was subjected to filtration through silica gel column chromatograpy for concentration. The resulting solid compound Intermediate 158(b) was used in the following reaction without any further purification process. (4.1 g, yield: 86 %)
LC-Mass Spectrometry (calculated value: 380.19 g/mol, found value: 381.3 g/mol (M+1))

**Synthesis of Compound 158**

5.99 g (15.76 mmol) of Intermediate 158(b), 4.0 g (13.13 mmol) of 7-chloro-5,9-dioxa-13b-boranaphtho[3,2,1-de]anthracene, 0.38 g (0.66 mmol) of (bis(dibenzylideneacetone)palladium(0)), $Pd(dba)_2$, 5.58 g (26.27 mmol) of potassium phosphate tribasic ($K_3PO_4$), and 1.08 g (2.63 mmol) of S-phos were added to 40 mL of toluene and 40 mL of distilled water. Then the mixture was heated under reflux. Once the reaction was complete, the resulting mixture was cooled to room temperature. Then an organic layer was extracted therefrom using ethyl acetate, and the resulting organic layer was dried using anhydrous sodium sulfate ($Na_2SO_4$) for concentration, followed by separation through silica gel column chromatography (dichloromethane/hexane). The solid resulting therefrom was recrystallized using hexane to thereby obtain 3.6 g (13.13 mmol) of a yellow solid, Compound 15 (yield: 52 %).
LC-Mass Spectrometry (calculated value: 522.41 g/mol, found value: 523.4 g/mol (M+1))

**Synthesis Example 2: Synthesis of Compound (160)**

**Synthesis of Compound 160**

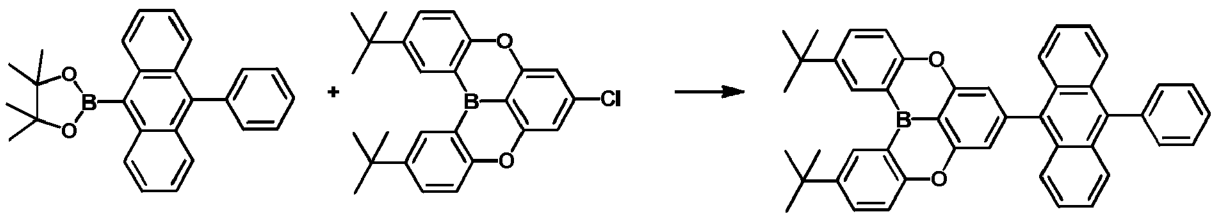

158(b) 160

4.2 g of Compound 160 was synthesized in substantially the same manner as in Synthesis of Compound 158 in Synthesis Example 1, except that 2,12-di-tert-butyl-7-chloro-5,9-dioxa-13b-boranaphtho[3,2,1-de]anthracene was used instead of 7-chloro-5,9-dioxa-13b-boranaphtho[3,2,1-de]anthracene (yield: 69 %).
LC-Mass Spectrometry (calculated value: 634.3 g/mol, found value: 635.3 g/mol (M+1))

**Synthesis Example 3: Synthesis of Compound (170)**

**Synthesis of Compound 170**

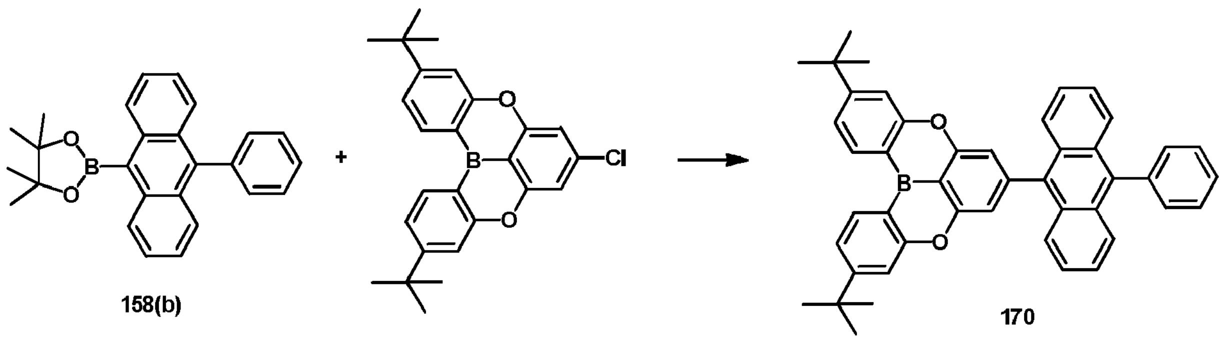

158(b) 170

4.2 g of Compound 170 was synthesized in substantially the same manner as in Synthesis of Compound 158 in Synthesis Example 1, except that 3,11-di-tert-butyl-7-chloro-5,9-dioxa-13b-boranaphtho[3,2,1-de]anthracene was used instead of 7-chloro-5,9-dioxa-13b-boranaphtho[3,2,1-de]anthracene (yield: 69 %).
LC-Mass Spectrometry (calculated value: 634.3 g/mol, found value: 635.3 g/mol (M+1))

**Synthesis Example 4: Synthesis of Compound (165)**

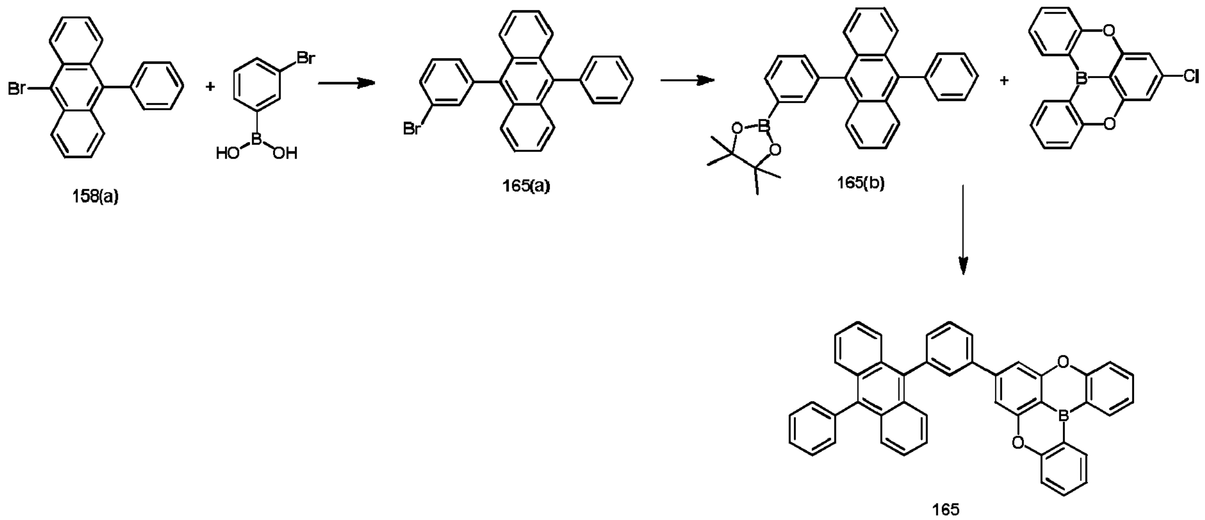

158(a) 165(a) 165(b)

165

**Synthesis of Intermediate 165(a)**

5.24 g of Intermediate 165(a) was synthesized in substantially the same manner as in Synthesis of Compound 158(a) in Synthesis Example 1, except that (3-bromophenyl)boronic acid was used instead of phenylboronic acid (yield: 86 %).
LC-Mass Spectrometry (calculated value: 408.05 g/mol, found value: 410.05 g/mol (M+1))

**Synthesis of Intermediate 165(b)**

5.8 g of Intermediate 165(a) was synthesized in substantially the same manner as in Synthesis of Compound 158(b) in Synthesis Example 1, except that Intermediate 165(a) was used instead of Intermediate 158(a) (yield: 99 %).
LC-Mass Spectrometry (calculated value: 456.23 g/mol, found value: 457.2 g/mol (M+1))

**Synthesis of Compound 165**

2.6 g of Compound 165 was synthesized in substantially the same manner as in Synthesis of Compound 158 in Synthesis Example 1, except that Intermediate 165(b) was used instead of Intermediate 158(b) (yield: 43 %).
LC-Mass Spectrometry (calculated value: 598.21 g/mol, found value: 599.31 g/mol (M+1))

**Synthesis Example 5: Synthesis of Compound (167)**

**Synthesis of Compound 167**

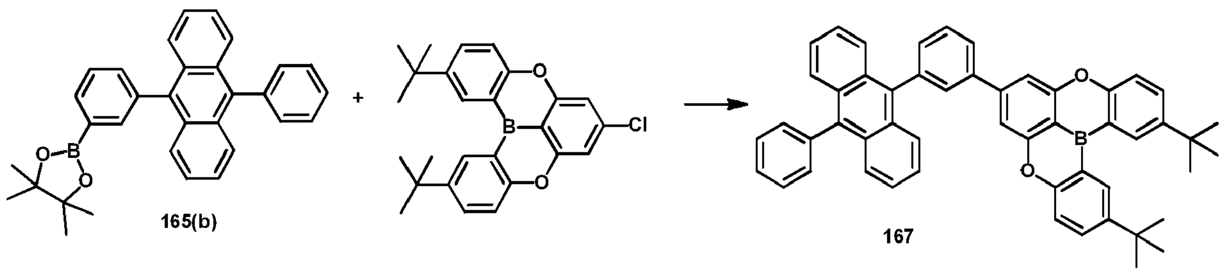

165(b) 167

3.8 g of Compound 167 was synthesized in substantially the same manner as in Synthesis of Compound 160 in Synthesis Example 2, except that Intermediate 165(b) was used instead of Intermediate 158(b) (yield: 55 %).
LC-Mass Spectrometry (calculated value: 710.34 g/mol, found value: 711.3 g/mol (M+1))

**Evaluation Example 1: Material property evaluation**

The optical band gap $E_g$, $S_1$ energy level, PL spectrum, full width at half maximum (FWHM) of some of the polycyclic compounds represented by Formula 1, e.g., Compounds 158, 160, and 170, were measured as in Table 1. The results thereof are shown in Table 2.

Table 1

| | |
|---|---|
| Evaluation method of optical band gap $E_g$ | Each compound was diluted at a concentration of $1\times10^{-5}$ M in Toluene, and an UV absorption spectrum thereof was measured at room temperature by using a Shimadzu UV-350 spectrometer. A LUMO energy level thereof was calculated by using an optical band gap ($E_g$) from an edge of the absorption spectrum and a HOMO energy level. |
| $S_1$ energy level evaluation method | A photoluminescence spectrum of a mixture of each compound, diluted with toluene at a concentration of about $1 \times 10^{-4}$ M, was measured by using a device for measuring photoluminescence (F7000 spectrofluorometer (available from Hitachi)) at room temperature. The observed peaks were analyzed to calculate onset $S_1$ energy levels. |
| Measurement of photoluminescence (PL) spectrum | Each compound was dissolved in a toluene at a concentration of $10^{-4}$ M, and then a F7000 spectrofluorometer (available from Hitachi) in which a Xenon lamp was mounted was used to measure a PL spectrum (@ 298 K) of each compound and FWHM of each compound from the PL spectrum. |

Table 2

| Compound No. | $E_g$ | $S_{1,max}$ (eV) | $S_{1,onset}$ (nm) | PL (nm) | FWHM (nm) |
|---|---|---|---|---|---|
| 158 | 2.98 | 2.84 | 408 | 436 | 48 |
| 160 | 2.98 | 2.86 | 415 | 433 | 49 |
| 170 | 3.0 | 2.88 | 401 | 430 | 52 |

Referring to the results of Table 2, the polycyclic compound represented by Formula 1 was found to have excellent light-emitting characteristics and suitable electrical characteristics for use as a dopant in an electronic device, e.g., an organic light-emitting device.

**Evaluation Example 2: Evaluation of photoluminescent quantum yield (PLQY) and decay time**

(1) Preparation of thin film

A quartz substrate was prepared by washing with chloroform and pure water. Then, as shown in Table 2, compounds (99.5 wt% of PMMA-0.5 wt% of each compound) were each dissolved in dichloromethane to use in spin-coating. Thus, a thin film having a thickness of 30 nm or greater was manufactured.

(2) Evaluation of photoluminescent quantum yield

Photoluminescent quantum yields in the thin film was evaluated by using Hamamatsu Photonics absolute PL quantum yield measurement system employing PLQY measurement software (Hamamatsu Photonics, Ltd., Shizuoka, Japan), in which a xenon light source, a monochromator, a photonic multichannel analyzer, and an integrating sphere are mounted. Thus, PLQY of the thin film of the compounds shown in Table 2 were measured accordingly.

(3) Decay time evaluation

The PL spectrum of each thin film was evaluated at room temperature by using a time-resolved photoluminescence (TRPL) measurement system, FluoTime 300 (available from PicoQuant), and a pumping source, PLS340 (available from PicoQuant, excitation wavelength=340 nm, spectral width=20 nm). Then, a wavelength of the main peak in the PL spectrum was determined, and upon photon pulses (pulse width=500 picoseconds, ps) applied to the thin film by PLS340, the number of photons emitted at the wavelength of the main peak for each thin film was repeatedly measured over time

by time-correlated single photon counting (TCSPC), thereby obtaining TRPL curves available for the sufficient fitting. $T_{decay}(E_x)$ (decay time) of the thin film was obtained by fitting at least two exponential decay functions to the results thereof. The functions used for the fitting are as described in Equation 1, and a decay time $T_{decay}$ having the largest value among values for each of the exponential decay functions used for the fitting was taken as $T_{decay}(E_x)$, i.e., a decay time. The results thereof are shown in Table 3. The remaining decay time $T_{decay}$ values were used to determine the lifetime of typical fluorescence to be decayed. Here, during the same measurement time as the measurement time for obtaining TRPL curves, the same measurement was repeated once more in a dark state (i.e., a state where a pumping signal incident on each of the films was blocked), thereby obtaining a baseline or a background signal curve available as a baseline for the fitting:

Equation 1

$$f(t) = \sum_{i=1}^{n} A_i \, exp\left(-t/T_{decay,i}\right)$$

Table 3

| Compound No. | PLQY | $T_{decay}(E_x)$ (ns) (decay time) |
|---|---|---|
| 158 | 0.957 | 91 |
| 160 | 0.934 | 19 |
| 170 | 0.954 | 109 |

Referring to the results shown in Table 3, the polycyclic compound represented by Formula 1, e.g., Compounds 158, 160, and 170, were found to be suitable for use as a dopant and have excellent PLQY (in film) and decay time characteristics.

**Example 1**

A glass substrate, on which an ITO electrode was formed, was cut to a size of 50 millimeters (mm) × 50 mm × 0.5 mm. Then the glass substrate was sonicated in acetone isopropyl alcohol and pure water for about 15 minutes in each solvent, and cleaned by exposure to ultraviolet rays with ozone for 30 minutes.

Subsequently, HAT-CN was deposited on the ITO electrode (anode) of the glass substrate to form a hole injection layer having a thickness of 100 Å, NPB was deposited on the hole injection layer to form a first hole transport layer having a thickness of 500 Å, TCTA was deposited on the first hole transport layer to form a second hole transport layer having a thickness of 50 Å, and mCP was deposited on the second hole transport layer to form an electron blocking layer having a thickness of 50 Å.

a host, a sensitizer, and an emitter were co-deposited at a predetermined weight ratio on the electron blocking layer as shown in Table 4 to thereby form an emission layer having a thickness of 400 Å.

DBFPO was deposited on the emission layer to form a hole blocking layer having a thickness of 100 Å. DBFPO and LiQ were co-deposited on the hole blocking layer at a weight ratio of 5:5 to form an electron transport layer having a thickness of 300 Å. LiQ was deposited on the electron transport layer to form an electron injection layer having a thickness of 10 Å. Aluminum (Al) was deposited on the electron injection layer to form cathode having a thickness of 1000 Å, thereby completing the manufacture of an organic light-emitting device.

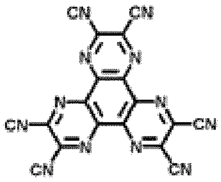

HT-D1(HAT-CN)

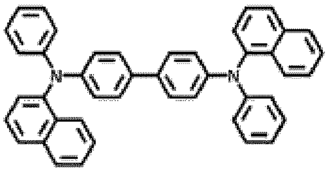

NPB

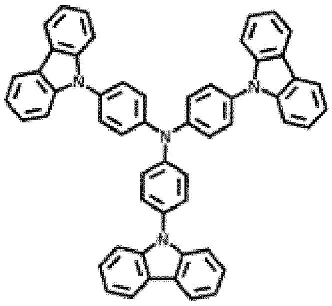

TCTA

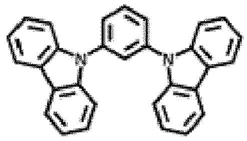

mCP

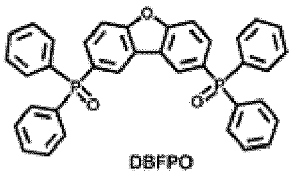

DBFPO

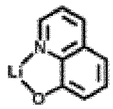

Liq

**Examples 2 to 5 and Comparative Examples 1 to** 3

Organic light-emitting devices were manufactured in the same manner as in Example 1, except that compounds shown in Table 4 were used in the formation of the emission layer.

Table 4

| | Host (mixed ratio) | Sensitizer (amount) | Emitter (amount) |
|---|---|---|---|
| Example 1 | H1, H2 | S-1 | Compound |
| | (50:50) | (13 wt%) | 158 (3 wt%) |
| Example 2 | H1, H2 (50:50) (84 wt%) | S-1 (13 wt%) | Compound 160 (3 wt%) |
| Example 3 | H1, H2 (50:50) (84 wt%) | S-1 (13 wt%) | Compound 170 (3 wt%) |
| Example 4 | H1, H2 (50:50) (84 wt%) | S-1 (13 wt%) | Compound 165 (3 wt%) |
| Example 5 | H1, H2 (50:50) (84 wt%) | S-1 (13 wt%) | Compound 167 (3 wt%) |
| Comparative Example 1 | H1, H2 (50:50) (84 wt%) | S-1 (13 wt%) | Compound A (3 wt%) |
| Comparative Example 2 | H1, H2 (50:50) (84 wt%) | S-1 (13 wt%) | Compound B (3 wt%) |
| Comparative Example 3 | Compound C (97 wt%) | - | Compound A (3 wt%) |

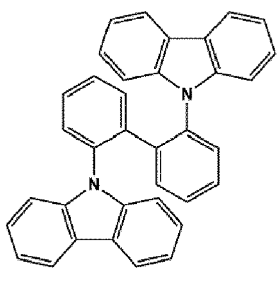

H1

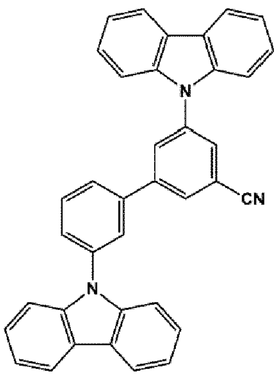

H2

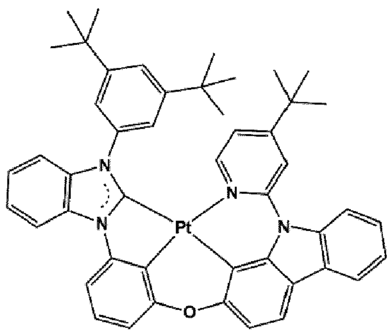

S-1

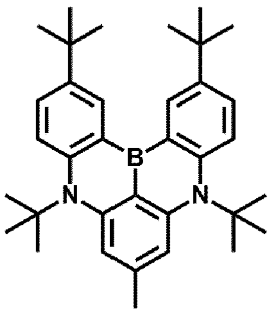

A

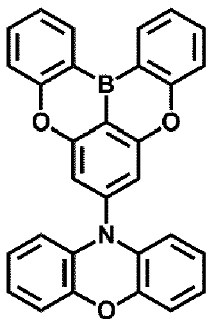

B

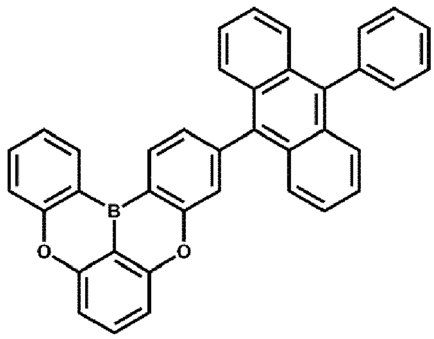

C

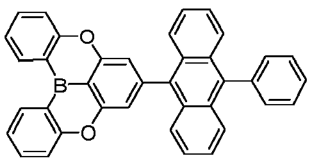

158

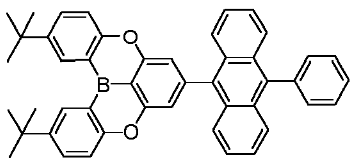

160

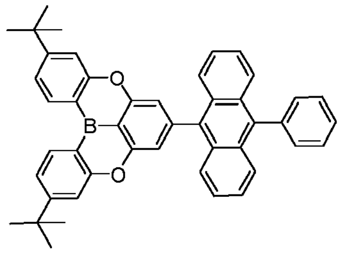

170

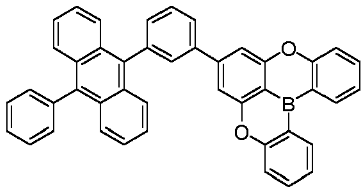

165

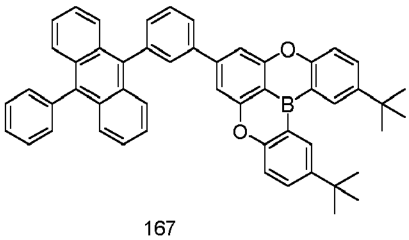

167

**Evaluation Example 3: Evaluation of characteristics of organic light-emitting device**

The driving voltage, T95 lifespan that indicates time (hour) for the luminance of each organic light-emitting device to decline to 95 % of its initial luminance, and quantum yield of the organic light-emitting devices manufactured in Examples 1 to 5 and Comparative Examples 1 to 3 were measured, and the relative values for Comparative Example 3 are shown in Table 5.

Table 5

| | Driving voltage (V) | Maximum emission wavelength (nm) | Relative quantum yield (%) | Relative lifespan (%) |
|---|---|---|---|---|
| Example 1 | 4.24 | 423 | 102 | 101 |
| Example 2 | 4.27 | 422 | 102 | 126 |
| Example 3 | 4.11 | 456 | 113 | 88 |
| Example 4 | 3.53 | 461 | 104 | 348.3 |
| Example 5 | 3.23 | 459 | 68 | 127.2 |
| Comparative Example 1 | Light-emitting characteristics not shown (not working) | | | |
| Comparative Example 2 | Light-emitting characteristics not shown (not working) | | | |

(continued)

| | Driving voltage (V) | Maximum emission wavelength (nm) | Relative quantum yield (%) | Relative lifespan (%) |
|---|---|---|---|---|
| Comparative Example 3 | 3.7 | 463 | 100 | 100 |

Referring to the results of Table 5, the organic light-emitting devices of Examples 1 to 5 and Comparative Example 3 were found to have high efficiency and/or long lifespan characteristics, and the organic light-emitting devices of Comparative Examples 1 and 2 were found not to have light-emitting characteristics due to no energy transfer to the dopant.

As apparent from the foregoing description, an organic light-emitting device according to an embodiment may have high efficiency and high colorimetric purity.

**Claims**

**1.** An organic light-emitting device comprising:

a first electrode;
a second electrode; and
an organic layer between the first electrode and the second electrode and comprising an emission layer,
wherein the emission layer comprises a polycyclic compound represented by Formula 1 and a host, and a content of the polycyclic compound is smaller than a content of the host:

Formula 1

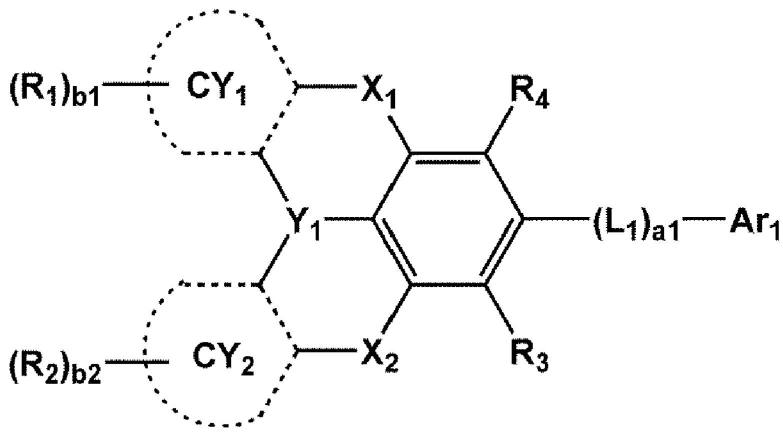

Formula 1A

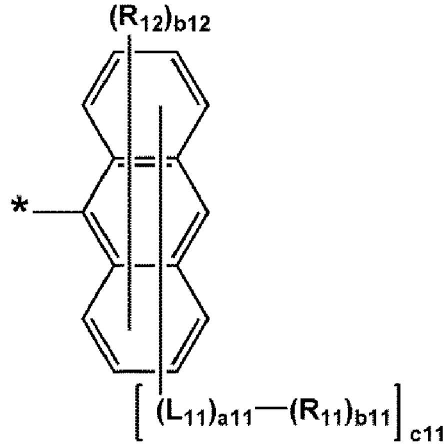

wherein, in Formulae 1 and 1A,

$Ar_1$ is a group represented by Formula 1A,

rings $CY_1$ and $CY_2$ are each independently a $C_5$-$C_{30}$ carbocyclic group or a $C_1$-$C_{30}$ heterocyclic group,

$Y_1$ is B, N, P, P(=O), P(=S), Al, Ga, As, Si($R_5$), or Ge($R_5$),

$X_1$ and $X_2$ are each independently selected from O, S, Se, N($R_6$), C($R_6$)($R_7$), Si($R_6$)($R_7$), Ge($R_6$)($R_7$), and P(=O)($R_6$),

$L_1$ and $L_{11}$ are each independently selected from a single bond, a substituted or unsubstituted $C_5$-$C_{30}$ carbocyclic group and a substituted or unsubstituted $C_1$-$C_{30}$ heterocyclic group,

a1 and a11 are each independently an integer from 1 to 3,

when a1 is 2 or greater, at least two $L_1$(s) are identical to or different from each other, and when a11 is 2 or greater, at least two $L_{11}$(s) are identical to or different from each other,

$R_1$, $R_2$, $R_3$, $R_4$, $R_5$, $R_6$, $R_7$, $R_{11}$, and $R_{12}$ are each independently selected from hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -B($Q_6$)($Q_7$), and -P(=O)($Q_8$)($Q_9$),

$R_1$ and $R_2$ are optionally bound to form a substituted or unsubstituted $C_5$-$C_{30}$ carbocyclic group or a substituted or unsubstituted $C_1$-$C_{30}$ heterocyclic group,

b1 and b2 are each independently an integer from 0 to 10,

when b1 is 2 or greater, at least two $R_1$(s) are identical to or different from each other, and when b2 is 2 or greater, at least two $R_2$(s) are identical to or different from each other,

b11 is an integer from 1 to 5,

when b11 is 2 or greater, at least two $R_{11}$(s) are identical to or different from each other,

b12 is an integer from 1 to 8,

when b12 is 2 or greater, at least two $R_{12}$(s) are identical to or different from each other,

c11 is an integer from 1 to 8,

when c11 is 2 or greater, at least two -($L_{11}$)$a_{11}$-($R_{11}$)$b_{11}$(s) are identical to or different from each other,

a sum of b12 and c11 is 9, and

at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the

substituted $C_7$-$C_{60}$ arylalkyl group, the substituted $C_1$-$C_{60}$ heteroaryl group, the substituted monovalent non-aromatic condensed polycyclic group, and the substituted monovalent non-aromatic condensed heteropolycyclic group is selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each unsubstituted or substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, a monovalent non-aromatic condensed heteropolycyclic group, $-Si(Q_{11})(Q_{12})(Q_{13})$, $-N(Q_{14})(Q_{15})$, $-B(Q_{16})(Q_{17})$, and $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, a monovalent non-aromatic condensed heteropolycyclic group, $-Si(Q_{21})(Q_{22})(Q_{23})$, $-N(Q_{24})(Q_{25})$ $-B(Q_{26})(Q_{27})$, and $-P(=O)(Q_{28})(Q_{29})$; and

$-si(Q_{31})(Q_{32})(Q_{33})$, $-N(Q_{34})(Q_{35})$, $-B(Q_{36})(Q_{37})$, and $-P(=O)(Q_{38})(Q_{39})$,

wherein $Q_1$ to $Q_9$, $Q_{11}$ to $Q_{19}$, $Q_{21}$ to $Q_{29}$, and $Q_{31}$ to $Q_{39}$ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted monovalent non-aromatic condensed polycyclic group, and a substituted or unsubstituted monovalent non-aromatic condensed heteropolycyclic group.

**2.** The organic light-emitting device of claim 1, wherein $Y_1$ is B, and
$X_1$ and $X_2$ are each independently selected from O, S, Se, $N(R_6)$, $C(R_6)(R_7)$, and $Si(R_6)(R_7)$.

**3.** The organic light-emitting device of claims 1 or 2, wherein $CY_1$ and $CY_2$ are each independently selected from an A group, a B group, a condensed ring in which at least two groups selected from the A group are condensed, a condensed ring in which at least two groups selected from the B group are condensed, and a condensed ring in which at least one group selected from the A group and at least one group selected from the B group are condensed,
wherein, the A group is selected from cyclopenta-1,3-diene, an indene group, an azulene group, a benzene group, a naphthalene group, an anthracene group, a phenanthrene group, a tetracene group, a tetrapene group, a pyrene group, a chrysene group, a triphenylene group, and a fluorene group, and
the B group is selected from a furan group, a thiophene group, a pyrrole group, a borole group, a silole group, a pyrrolidine group, an imidazole group, a thiazole group, a triazole group, an oxazole group, an isoxazole group, a

thiazole group, an isothiazole group, a pyridine group, a pyrimidine group, a pyridazine group, a triazine group, an indole group, an isoindole group, an indolizine group, a quinoline group, an isoquinoline group, a quinoxaline group, an isoquinoxaline group, a carbazole group, a dibenzofuran group, a dibenzothiophene group, a dibenzosilole group, and a dibenzoborole group.

**4.** The organic light-emitting device of any of claims 1-3, wherein $CY_1$ and $CY_2$ are each independently selected from a benzene group, a naphthalene group, an anthracene group, and a fluorene group.

**5.** The organic light-emitting device of any of claims 1-4, wherein $L_1$ and $L_{11}$ are each independently selected from:

a single bond;
a phenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, and a chrysenylenylene group; and
a phenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, and a chrysenylenylene group, each substituted with at least one of deuterium, -F, -Cl, -Br, - I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, and a monovalent non-aromatic condensed heteropolycyclic group; and
a phenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, and a chrysenylenylene group, each substituted with at least one selected from a phenyl group, an indenyl group, a naphthyl group, an azulenyl group, a heptalenyl group, an acenaphthyl group, a fluorenyl group, a phenalenyl group, a phenanthrenyl group, an anthracenyl group, a fluoranthenyl group, a triphenylenyl group, a pyrenyl group, and a chrysenylenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, and a monovalent non-aromatic condensed heteropolycyclic group.

**6.** The organic light-emitting device of any of claims 1-5, wherein $L_1$ and $L_{11}$ are selected from a single bond and groups represented by one of Formulae 3-1 to 3-32:

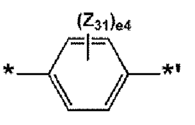
3-1

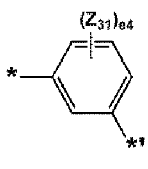
3-2

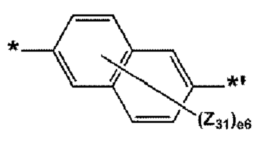
3-3

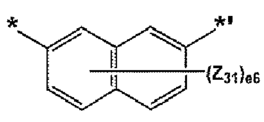
3-4

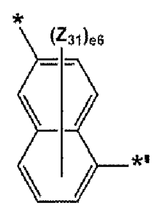
3-5

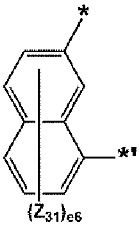
3-6

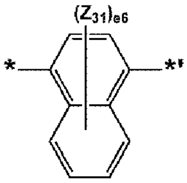
3-7

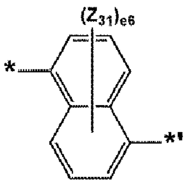
3-8

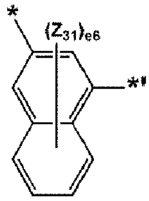
3-9

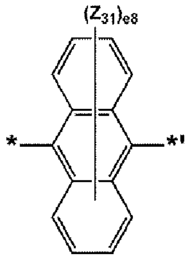
3-10

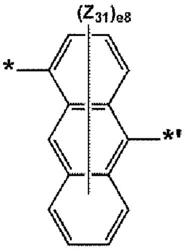
3-11

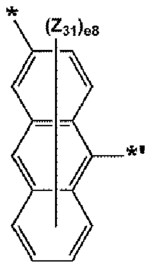
3-12

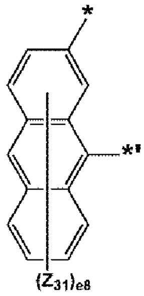
3-13

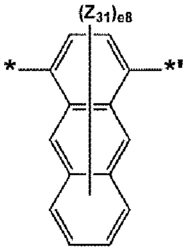
3-14

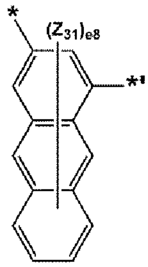
3-15

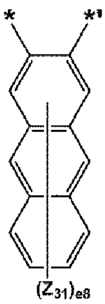
3-16

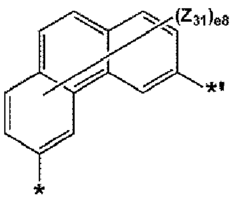
3-17

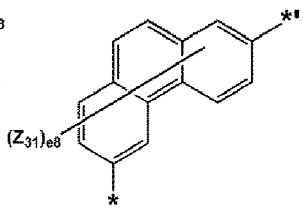
3-18

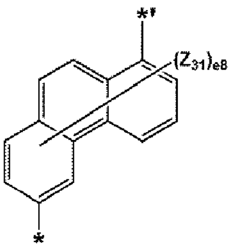
3-19

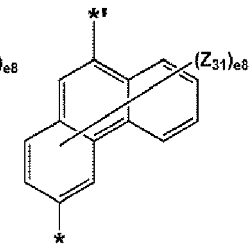
3-20

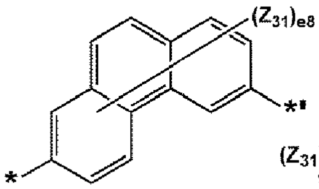
3-21

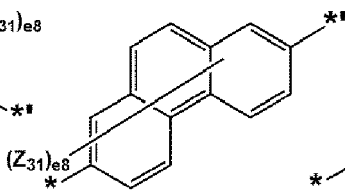
3-22

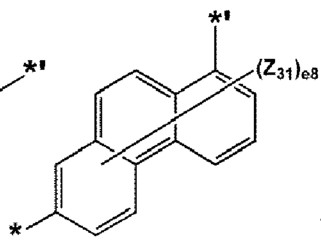
3-23

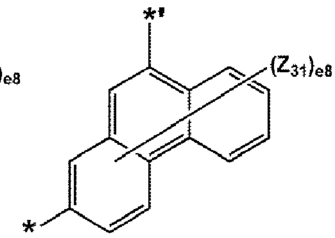
3-24

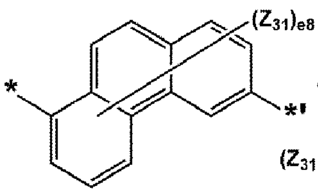
3-25

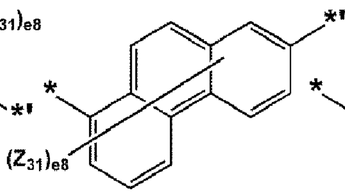
3-26

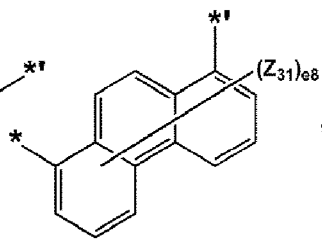
3-27

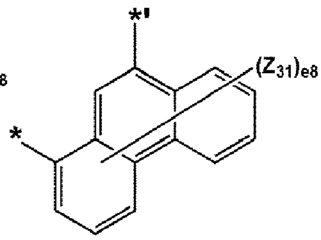
3-28

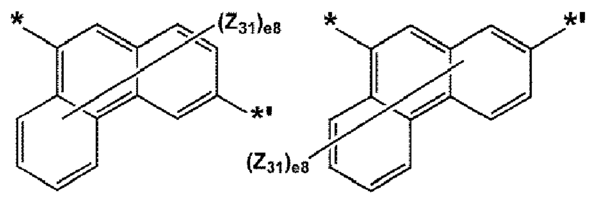

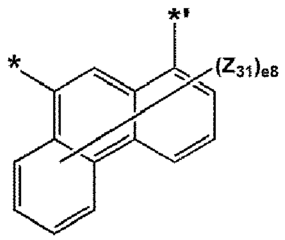

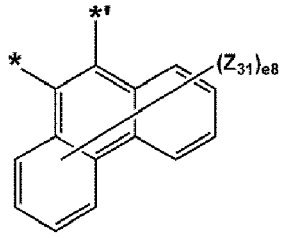

3-29 3-30 3-31 3-32

wherein, in Formulae 3-1 to 3-32,

$Z_{31}$ is selected from: hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, and a $C_1$-$C_{60}$ heteroaryl group; and

a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, and a $C_1$-$C_{60}$ heteroaryl group, each substituted with at least one selected from deuterium, -F, -Cl,-Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a monovalent non-aromatic condensed polycyclic group, a monovalent non-aromatic condensed heteropolycyclic group, - $Si(Q_{21})(Q_{22})(Q_{23})$, $-N(Q_{24})(Q_{25})$ $-B(Q_{26})(Q_{27})$, and $-P(=O)(Q_{28})(Q_{29})$,

e4 is an integer from 1 to 4,

e6 is an integer from 1 to 6,

e8 is an integer from 1 to 8, and

* and *' each indicate a binding site to an adjacent atom.

**7.** The organic light-emitting device of any of claims 1-6, wherein $R_1$ and $R_2$ are each independently selected from:

hydrogen, deuterium, -F, -Cl, -Br, -I, a hydroxyl group, a cyano group (CN), a nitro group, an amino group, a $C_1$-$C_{60}$ alkyl group, and a $C_1$-$C_{60}$ alkoxy group;

a $C_1$-$C_{60}$ alkyl group and a $C_1$-$C_{60}$ alkoxy group, each substituted with at least one of deuterium, -F, -Cl, -Br, -I, a hydroxyl group, a cyano group (CN), a nitro group, an amino group, a phenyl group, a biphenyl group, a naphthyl group, a fluorenyl group, a phenanthrenyl group, an anthracenyl group, a fluoranthenyl group, a triphenylenyl group, a pyrenyl group, and a chrysenyl group;

a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, and a carbazolyl group;

a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl

group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, and a carbazolyl group, each substituted with at least one of deuterium, -F, -Cl, -Br, -I, a hydroxyl group, a cyano group (CN), a nitro group, an amino group, a $C_1$-$C_{60}$ alkyl group, a $C_1$-$C_{60}$ alkoxy group, a $C_7$-$C_{60}$ arylalkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a carbazolyl group, -si($Q_{31}$)($Q_{32}$)($Q_{33}$), -N($Q_{34}$)($Q_{35}$), -B($Q_{36}$)($Q_{37}$), and -P(=O)($Q_{38}$)($Q_{39}$); and
-N($Q_1$)($Q_2$), -Si($Q_3$)($Q_4$)($Q_5$), -B($Q_6$)($Q_7$), and -P(=O)($Q_8$)($Q_9$).

**8.** The organic light-emitting device of any of claims 1-7, wherein at least one of $R_1$ and $R_2$ is selected from groups represented by Formulae 5-1 and 5-2:

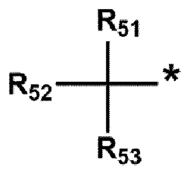

5-1

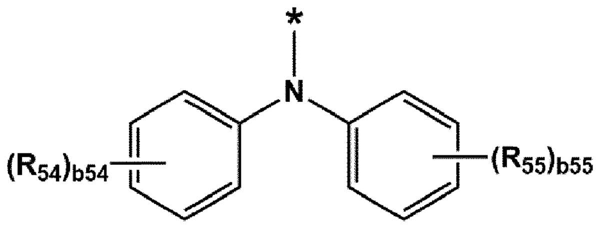

5-2

wherein, in Formulae 5-1 and 5-2,
$R_{51}$ to $R_{55}$ are each independently selected from:

deuterium, -F, -Cl, -Br, -I, a hydroxyl group, a cyano group, a nitro group, a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, a tert-hexyl group, a phenyl group, a biphenyl group, and a terphenyl group; and;
a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group, each substituted with at least one of deuterium, -F, -Cl, -Br, -I, a hydroxyl group, a cyano group, a nitro group, and a phenyl group,
$R_{54}$ and $R_{55}$ are optionally bound to each other to form a heteroring, and
b54 and b55 are each independently an integer from 0 to 4.

**9.** The organic light-emitting device of any of claims 1-8, wherein $R_3$ and $R_4$ are each independently selected from:

hydrogen, deuterium, -F, -Cl, -Br, -I, a hydroxyl group, a cyano group, a nitro group, a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group;
a methyl group, an ethyl group, an n-propyl group, an iso-propyl group, an n-butyl group, an iso-butyl group, a

sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group, each substituted with at least one of deuterium, -F, -Cl, -Br, -I, a hydroxyl group, a cyano group, a nitro group, and a phenyl group;
preferably wherein $R_3$ and $R_4$ are each hydrogen.

**10.** The organic light-emitting device of any of claims 1-9, wherein $R_5$, $R_6$, and $R_7$ are each independently selected from:

hydrogen, deuterium, -F, -Cl, -Br, -I, a hydroxyl group, a cyano group, a nitro group, a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group;
a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group, each substituted with at least one of deuterium, -F, -Cl, -Br, -I, a hydroxyl group, a cyano group, a nitro group, and a phenyl group,
a phenyl group, a biphenyl group, a naphthyl group, a fluorenyl group, a carbazolyl group, a dibenzofuranyl group, and a dibenzothiophenyl group;
a phenyl group, a biphenyl group, a naphthyl group, a fluorenyl group, a carbazolyl group, a dibenzofuranyl group, and a dibenzothiophenyl group, each substituted with a phenyl group, a biphenyl group, a naphthyl group, a fluorenyl group, a carbazolyl group, a dibenzofuranyl group, and a dibenzothiophenyl group.

**11.** The organic light-emitting device of any of claims 1-10, wherein
$R_{11}$ is selected from Formulae 4-1 to 4-42;
$R_{12}$ is selected from: hydrogen, deuterium, -F, -Cl, -Br, -I, a hydroxyl group, a cyano group, a nitro group, a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group; and
a methyl group, an ethyl group, an n-propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, and a tert-hexyl group, each substituted with at least one of deuterium, -F, -Cl, -Br, -I, a hydroxyl group, a cyano group, a nitro group, and a phenyl group,

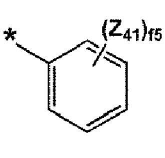
4-1

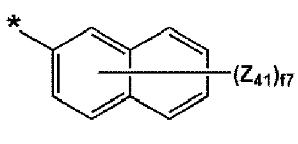
4-2

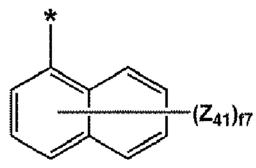
4-3

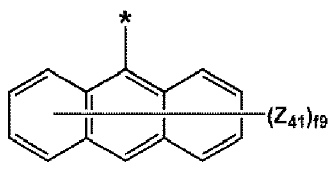
4-4

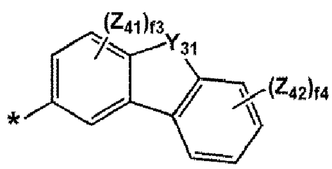
4-5

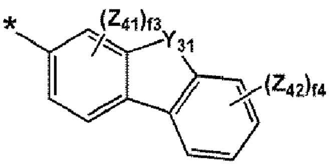
4-6

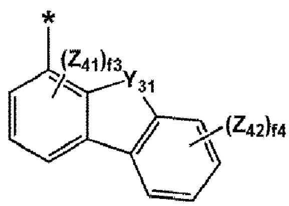
4-7

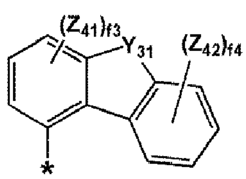
4-8

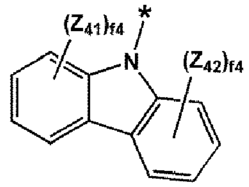
4-9

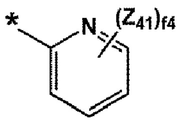
4-10

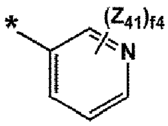
4-11

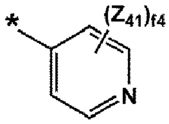
4-12

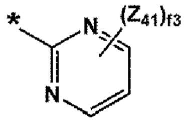
4-13

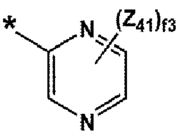
4-14

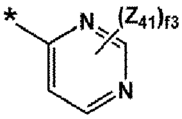
4-15

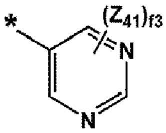
4-16

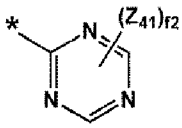
4-17

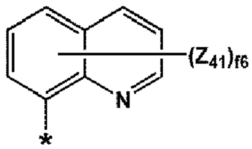
4-18

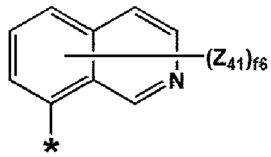
4-19

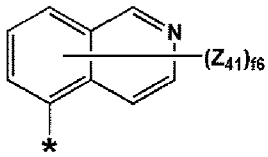
4-20

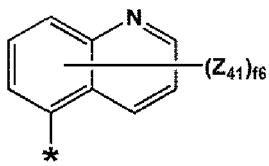
4-21

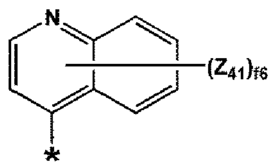
4-22

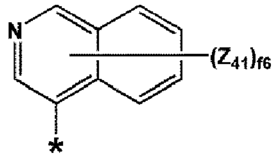
4-23

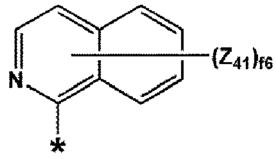
4-24

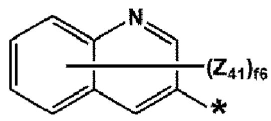
4-25

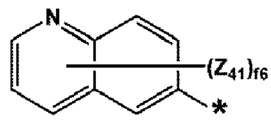
4-26

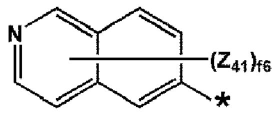
4-27

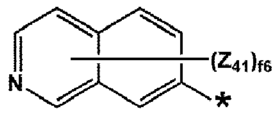
4-28

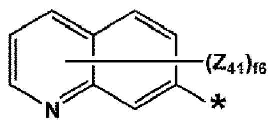
4-29

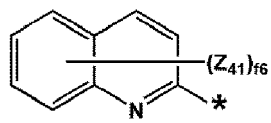
4-30

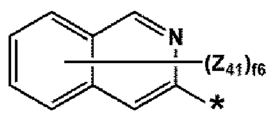
4-31

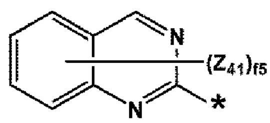
4-32

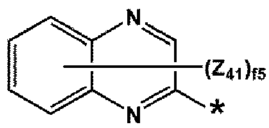
4-33

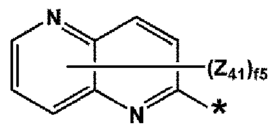
4-34

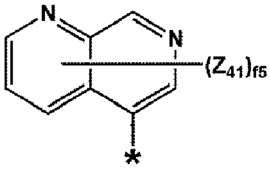
4-35

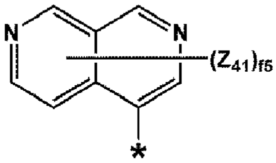
4-36

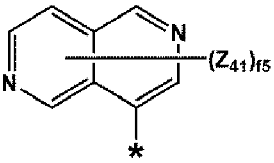
4-37

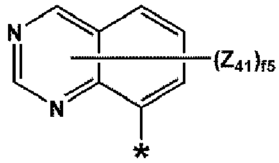
4-38

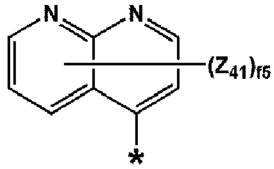
4-39

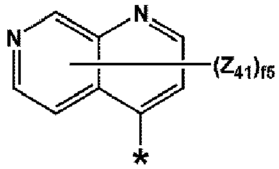
4-40

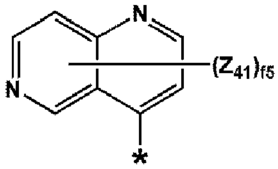
4-41

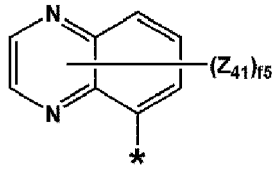
4-42

wherein, in Formulae 4-1 to 4-42,
$Y_{31}$ is O, S, $C(Z_{45})(Z_{46})$, $N(Z_{47})$, or $Si(Z_{48})(Z_{49})$,
$Z_{41}$ to $Z_{49}$ are each independently selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_7$-$C_{60}$ arylalkyl group, a cyclopentyl group, a cyclohexyl group, a cycloheptyl group, a cyclopentenyl group, a cyclohexenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, and a carbazolyl group;
a cyclopentyl group, a cyclohexyl group, a cycloheptyl group, a cyclopentenyl group, a cyclohexenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, and a carbazolyl group, each substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, and a cumyl group,
f3 is an integer from 1 to 3,
f4 is an integer from 1 to 4,
f5 is an integer from 1 to 5,
f6 is an integer from 1 to 6,
f7 is an integer from 1 to 7,
f9 is an integer from 1 to 9, and
* indicates a binding site to an adjacent atom.

**12.** The organic light-emitting device of any of claims 1-11, wherein Formula 1A is selected from Formulae 1A-1 to 1A-5:

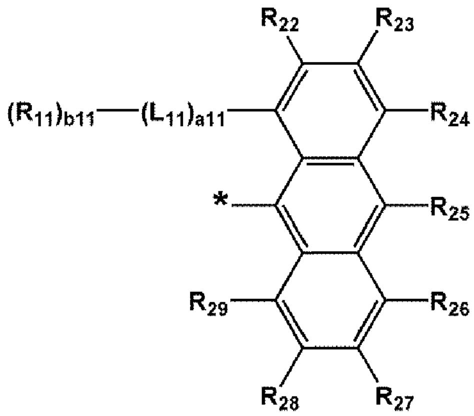

1A-1

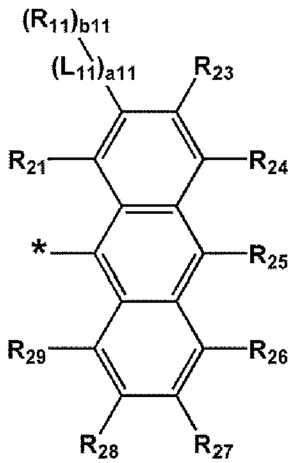

1A-2

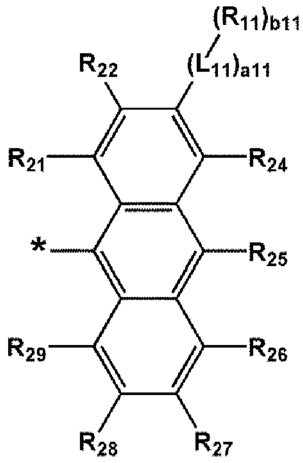

1A-3

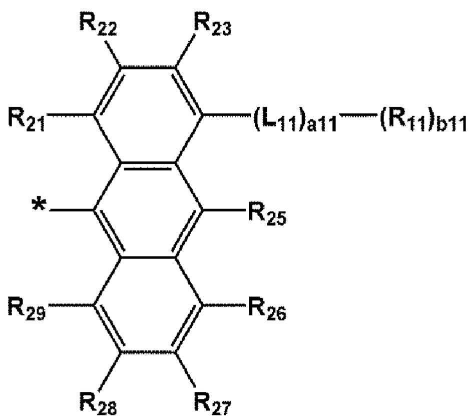

1A-4

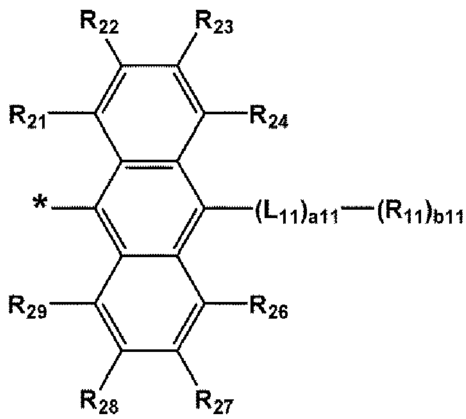

1A-5

wherein in Formulae 1A-1 to 1A-5,
$L_{11}$, $a_{11}$, $R_{11}$, and $b_{11}$ are respectively understood by referring to the descriptions of $L_{11}$, $a_{11}$, $R_{11}$, and $b_{11}$ in claim 1,
$R_{21}$ to $R_{29}$ are each understood by referring to the description of $R_{12}$ in claim 1, and
* indicates a binding site to an adjacent atom; and/or
wherein the polycyclic compound comprises a compound represented by one of Formulae 2-1 to 2-8:

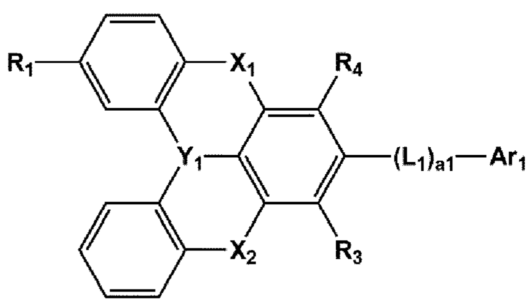

2-1

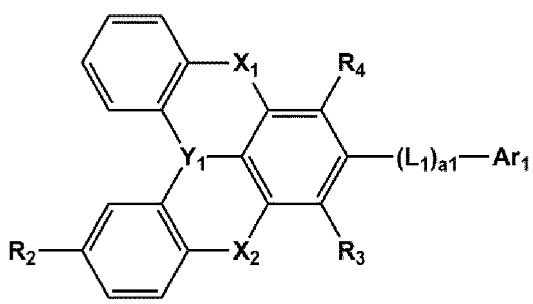

2-2

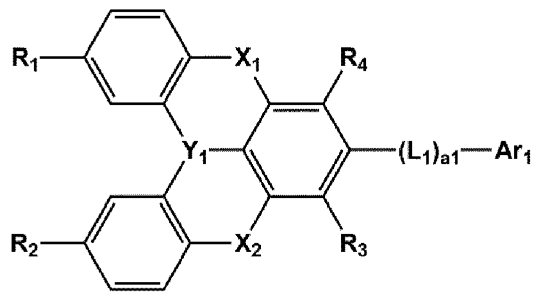

2-3

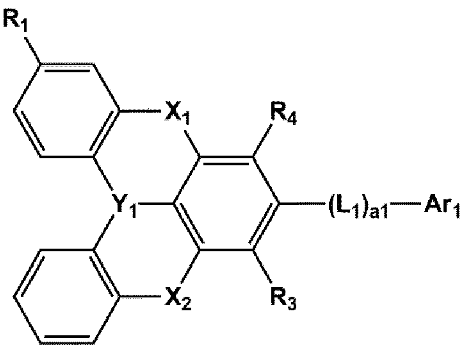

2-4

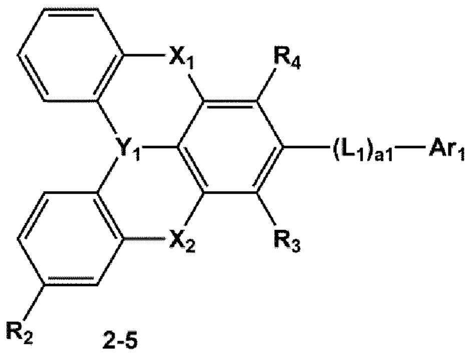

2-5

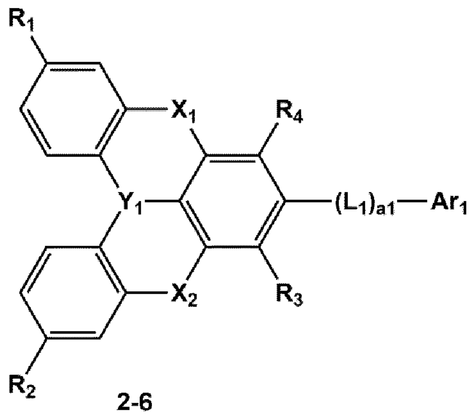

2-6

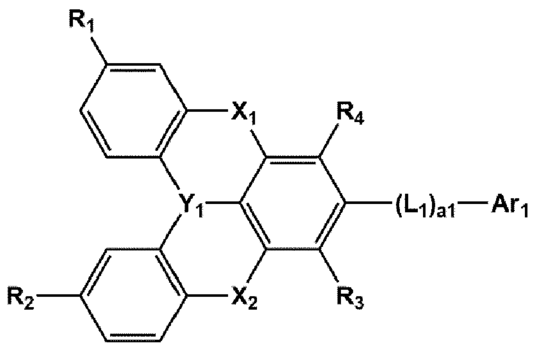

2-7

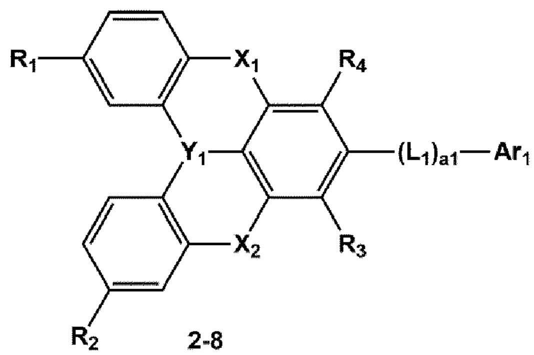

2-8

wherein, in Formulae 2-1 to 2-8,

$Y_1$, $X_1$, $X_2$, $R_1$, $R_2$, $R_3$, $R_4$, $R_5$, $L_1$, $a_1$, and $Ar_1$ are respectively understood by referring to the descriptions of $Y_1$, $X_1$, $X_2$, $R_1$, $R_2$, $R_3$, $R_4$, $R_5$, $L_1$, $a_1$, and $Ar_1$ in claim 1.

**13.** The organic light-emitting device of any of claims 1-12, wherein the polycyclic compound is selected from Compounds 1 to 468:

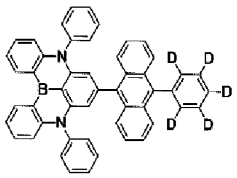
1

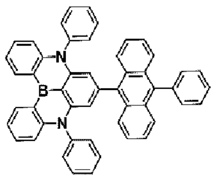
2

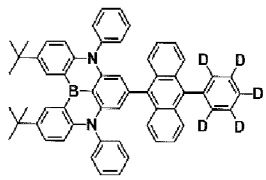
3

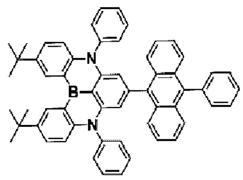
4

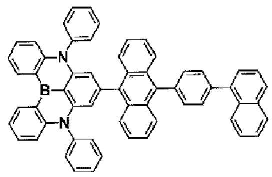
5

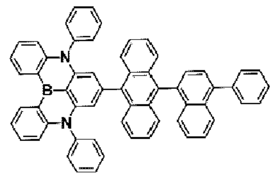
6

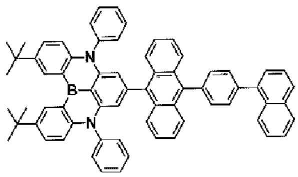
7

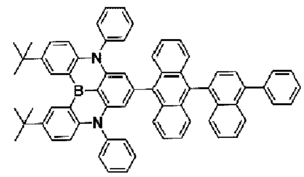
8

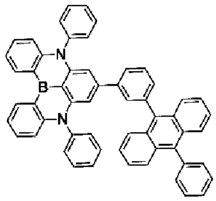
9

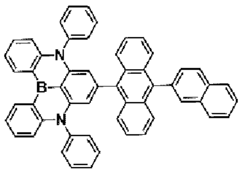
10

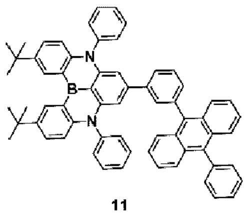
11

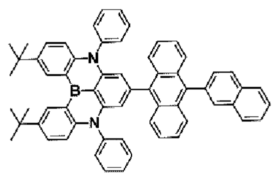
12

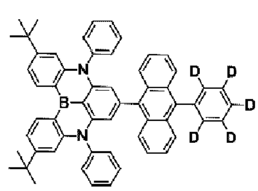
13

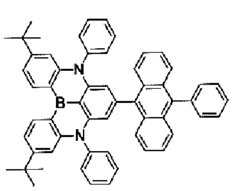
14

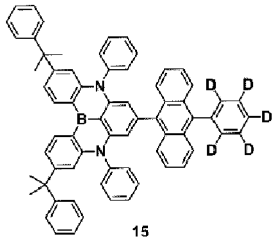
15

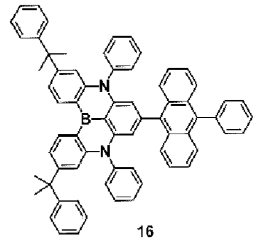
16

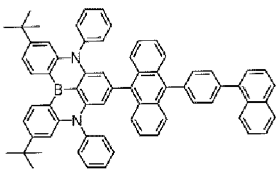
17

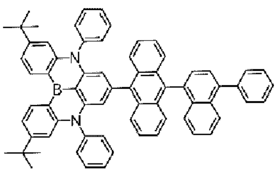
18

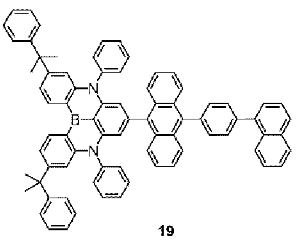
19

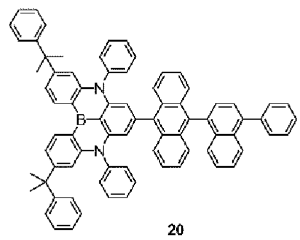
20

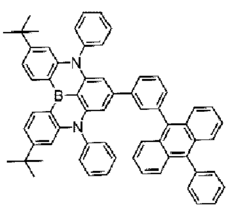
21

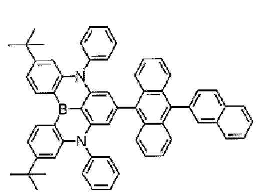
22

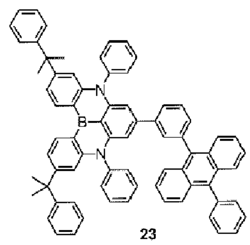
23

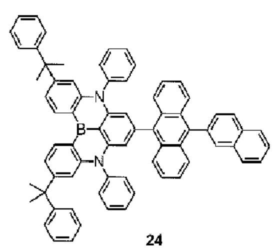
24

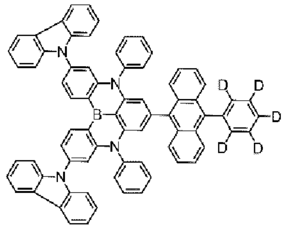
25

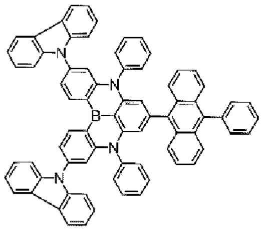
26

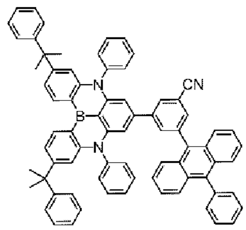
27

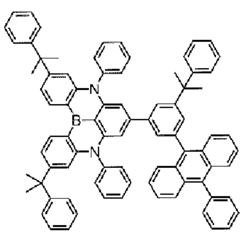
28

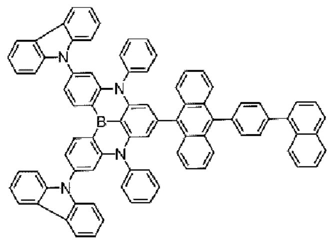
29

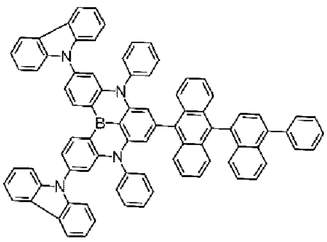
30

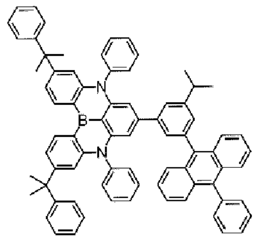
31

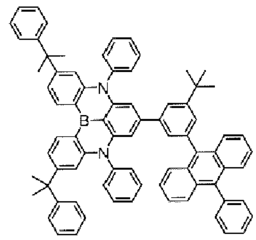
32

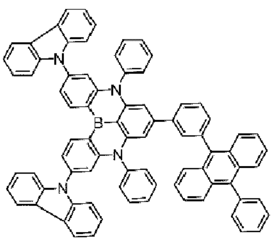
33

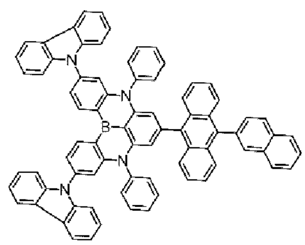
34

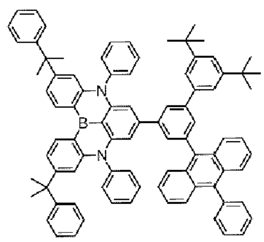
35

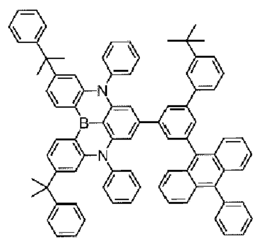
36

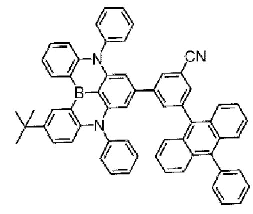
37

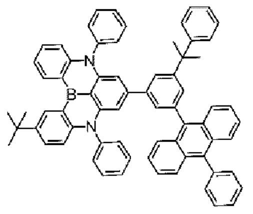
38

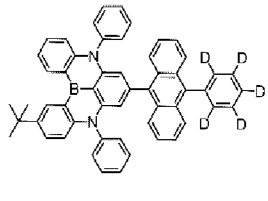
39

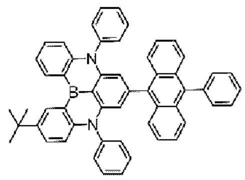
40

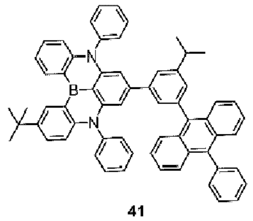
41

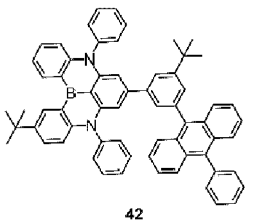
42

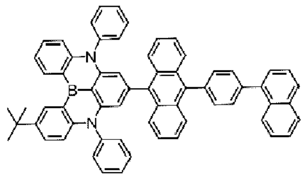
43

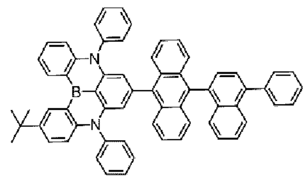
44

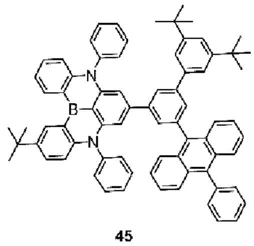
45

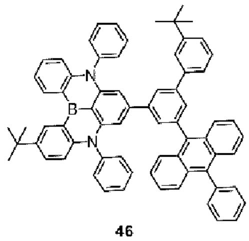
46

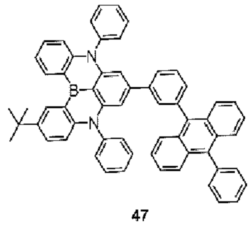
47

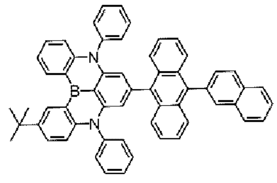
48

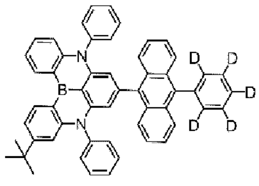
49

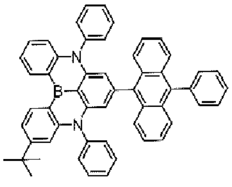
50

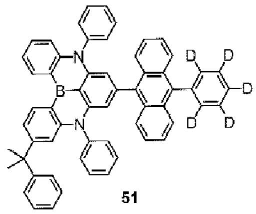
51

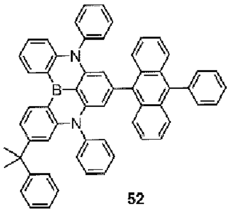
52

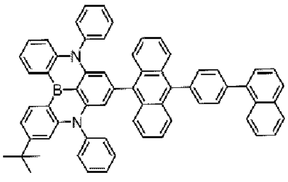
53

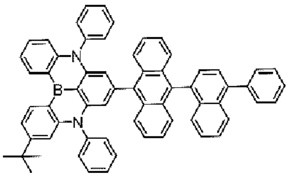
54

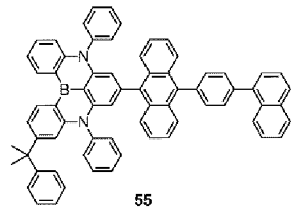
55

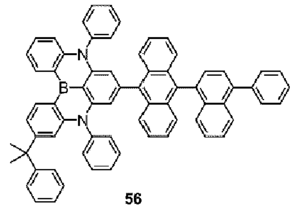
56

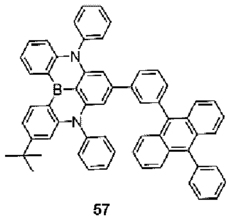
57

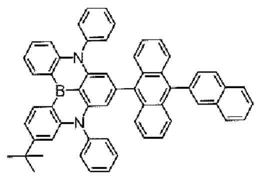
58

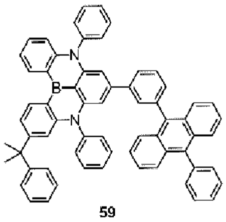
59

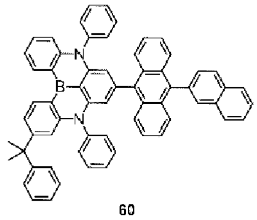
60

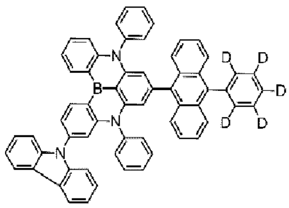
61

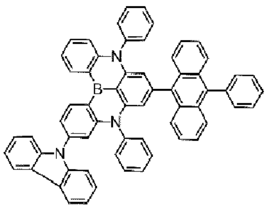
62

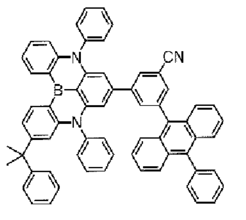
63

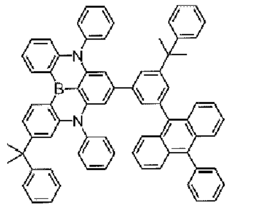
64

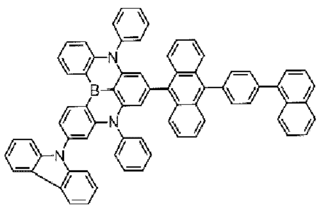
65

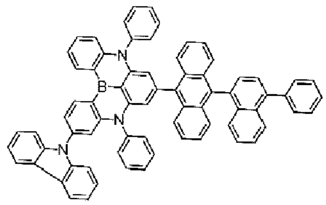
66

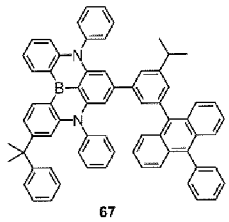
67

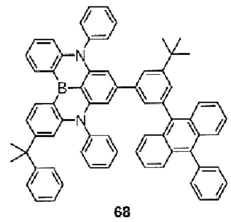
68

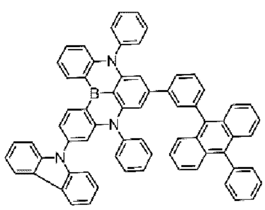
69

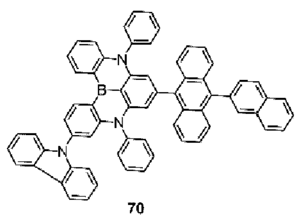
70

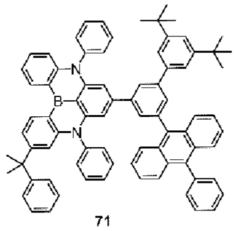
71

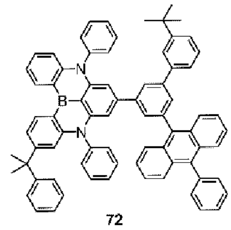
72

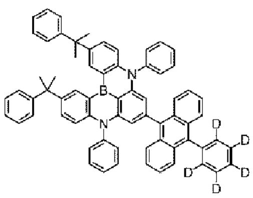

73

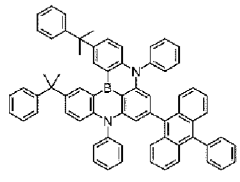

74

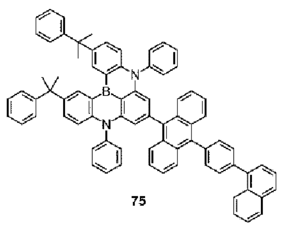

75

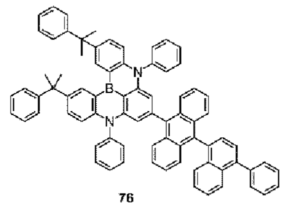

76

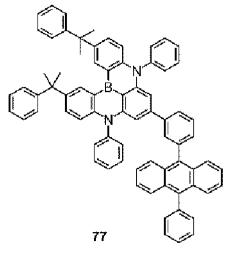

77

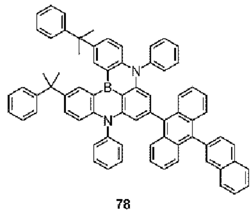

78

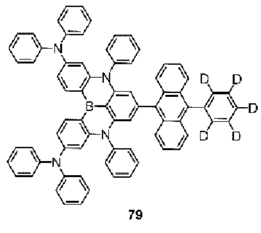

79

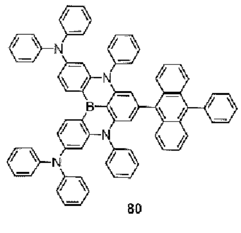

80

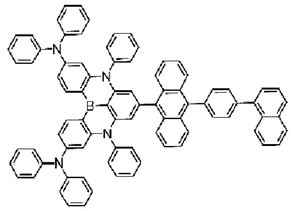

81

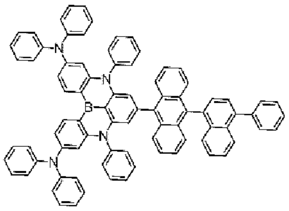

82

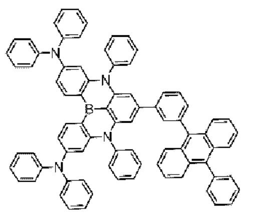

83

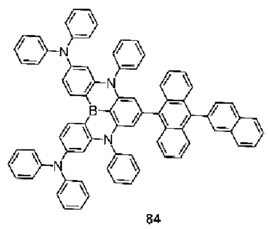

84

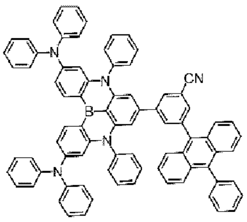

85

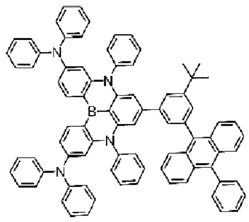

86

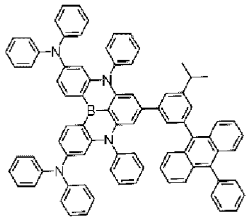

87

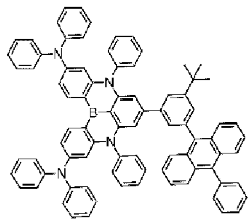

88

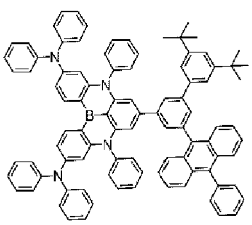

89

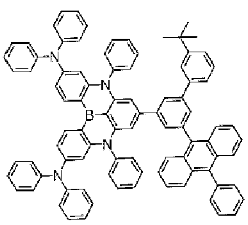

90

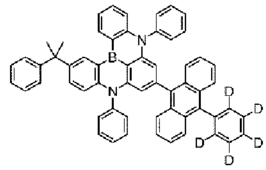

91

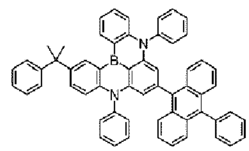

92

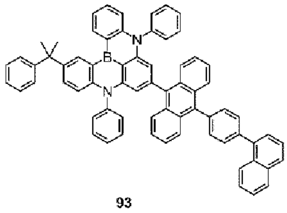

93

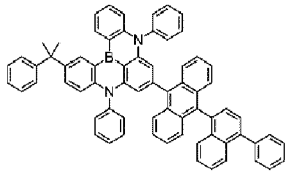

94

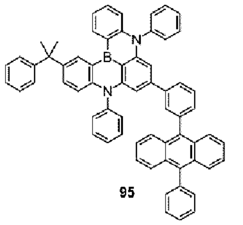

95

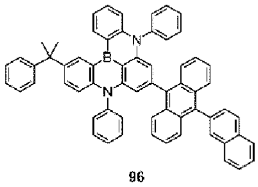

96

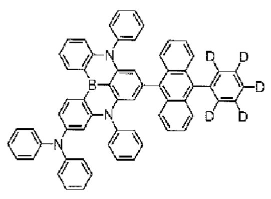
97
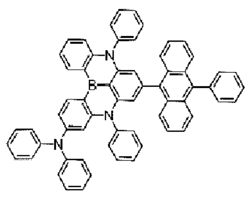
98
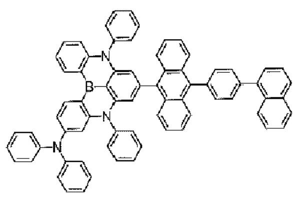
99
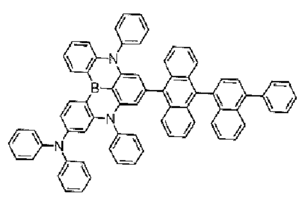
100

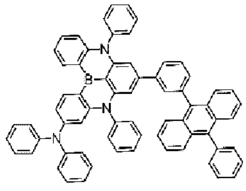
101
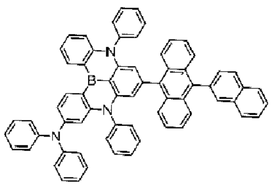
102
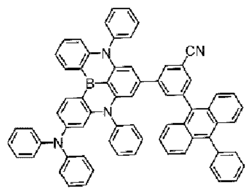
103
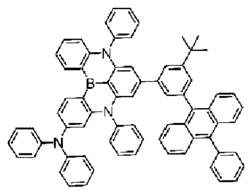
104

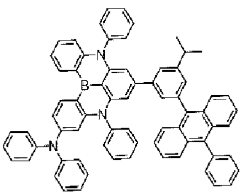
105
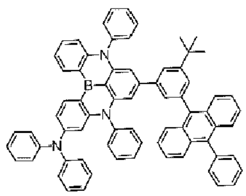
106
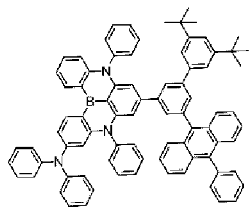
107
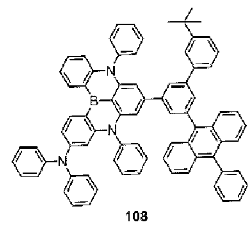
108

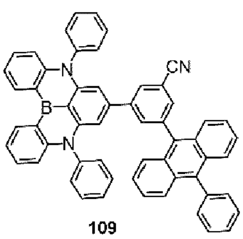
109
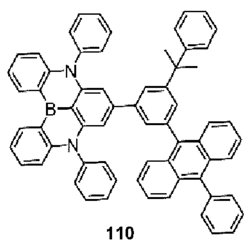
110
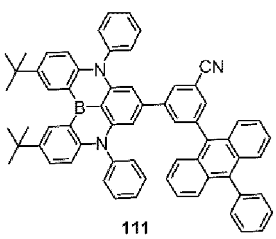
111
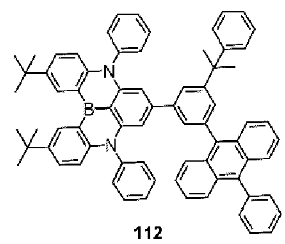
112

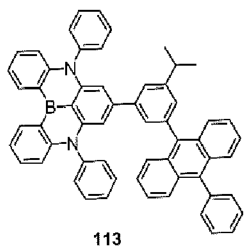
113
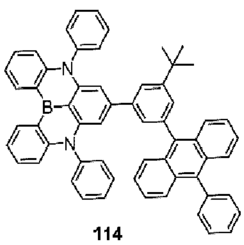
114
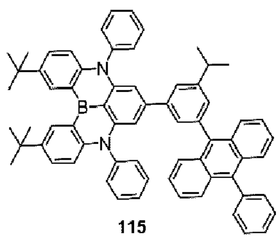
115
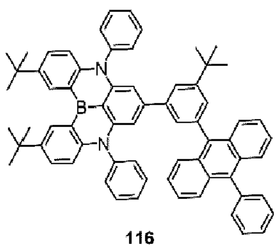
116

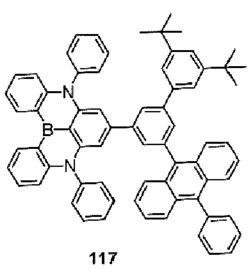
117
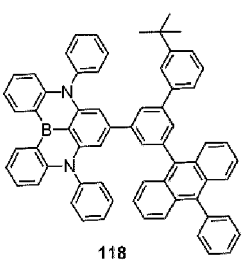
118
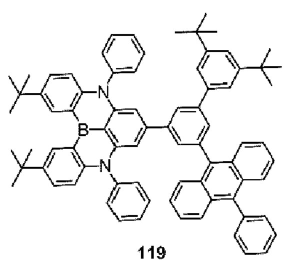
119
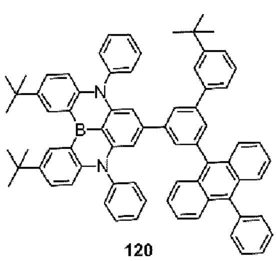
120

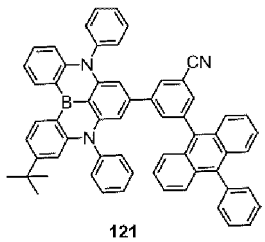
121

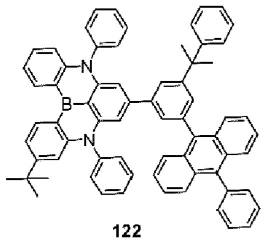
122

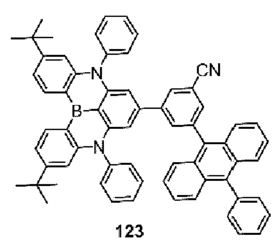
123

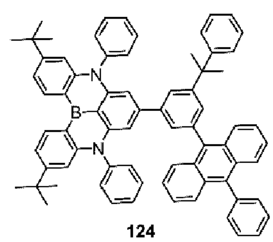
124

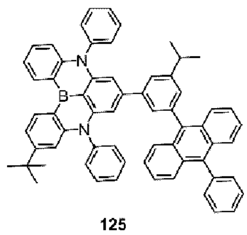
125

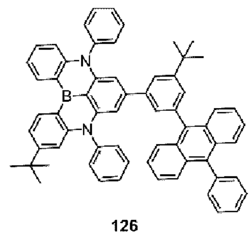
126

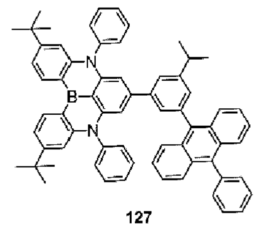
127

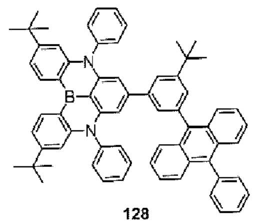
128

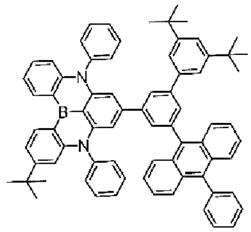
129

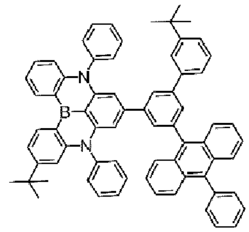
130

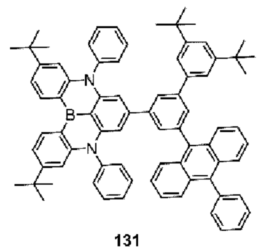
131

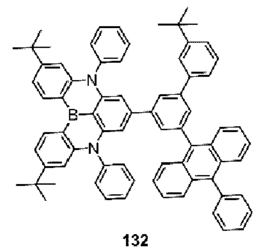
132

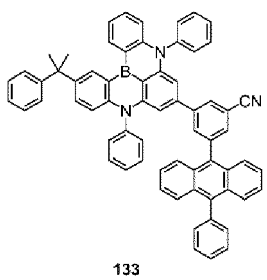
133

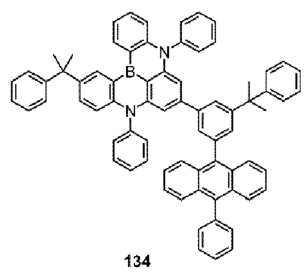
134

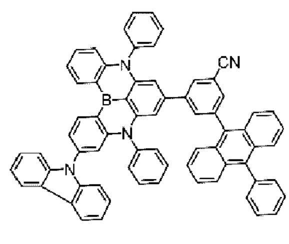
135

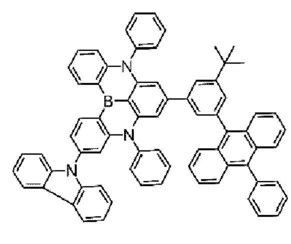
136

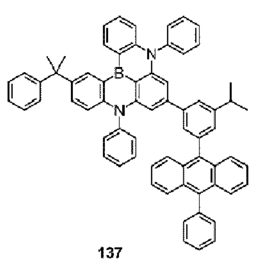
137

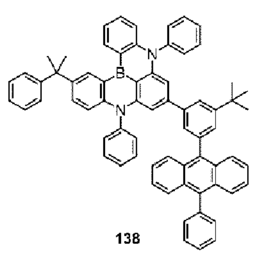
138

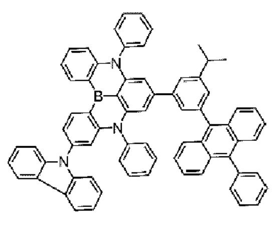
139

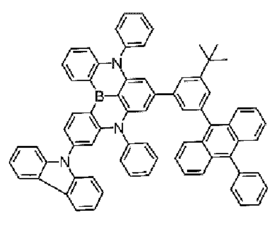
140

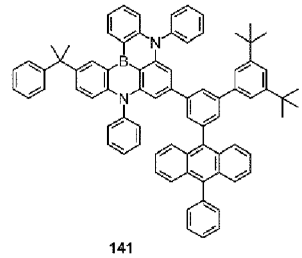
141

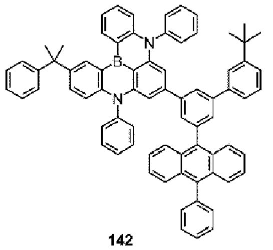
142

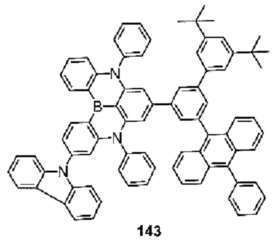
143

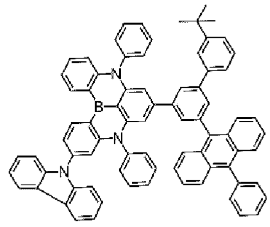
144

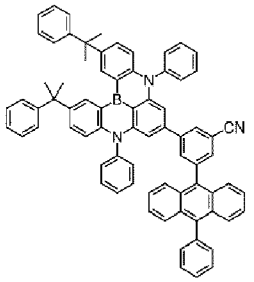
145

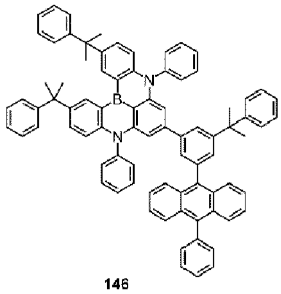
146

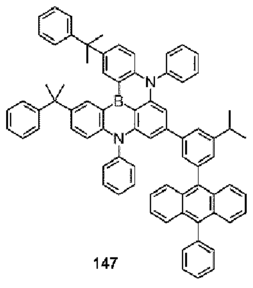
147

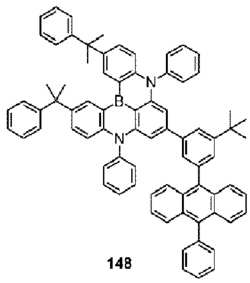
148

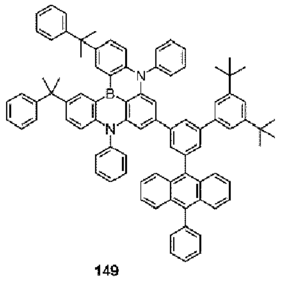
149

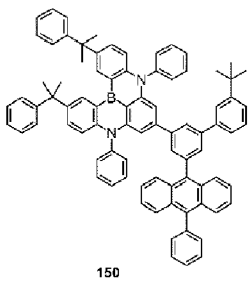
150

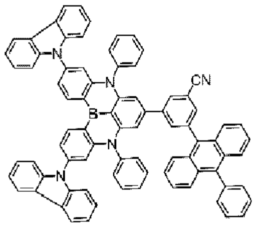
151

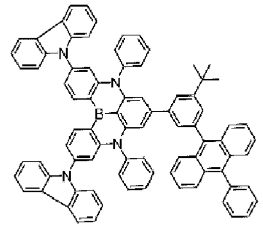
152

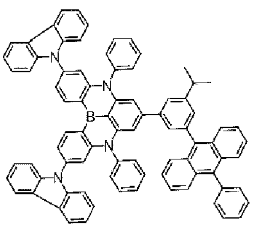
153

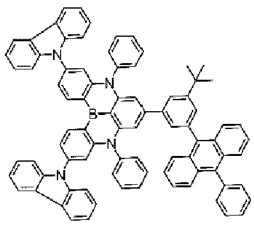
154

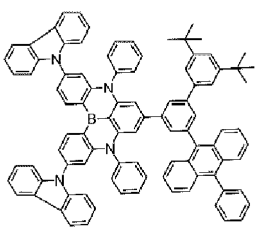
155

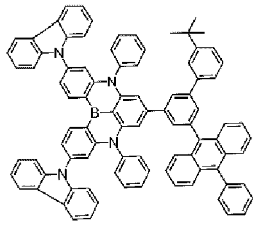
156

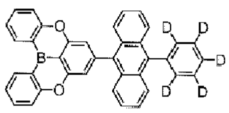
157

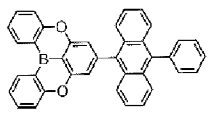
158

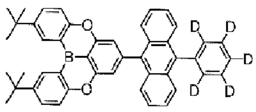
159

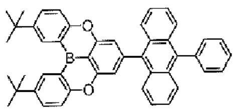
160

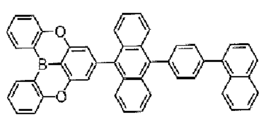
161

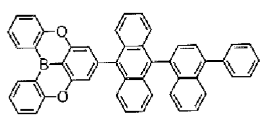
162

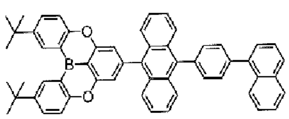
163

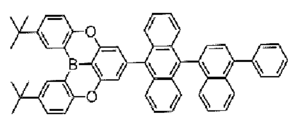
164

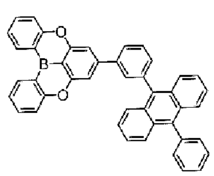
165

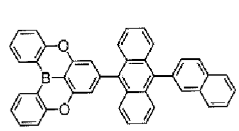
166

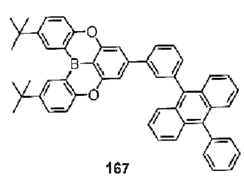
167

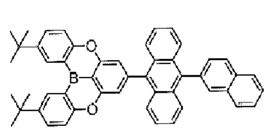
168

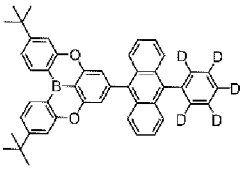
169

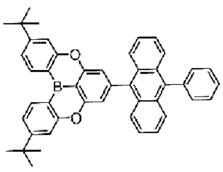
170

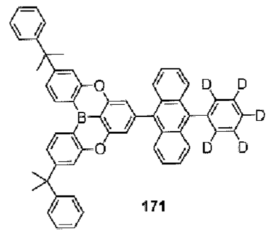
171

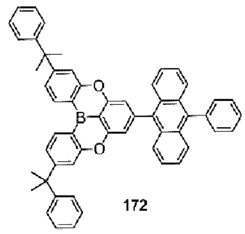
172

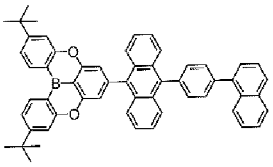
173

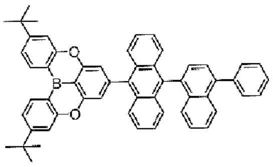
174

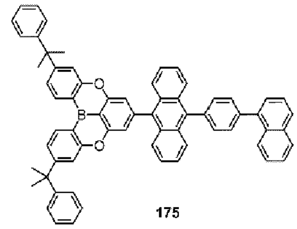
175

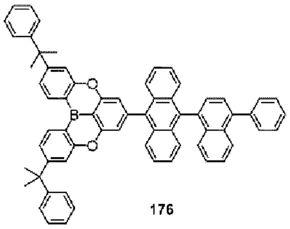
176

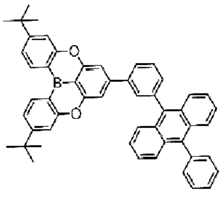
177

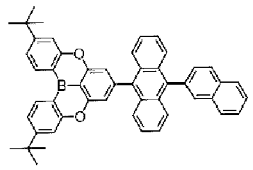
178

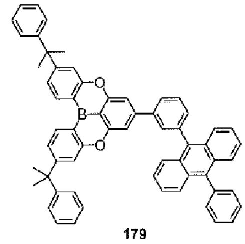
179

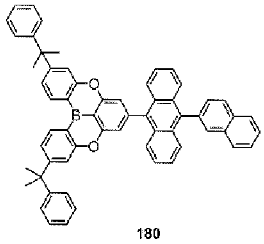
180

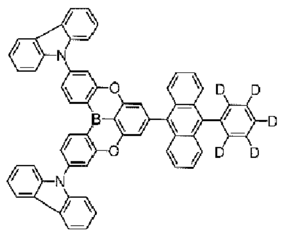
181

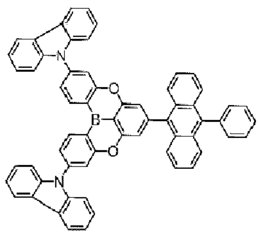
182

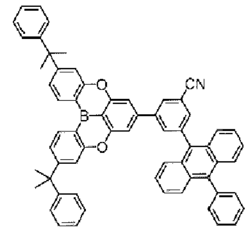
183

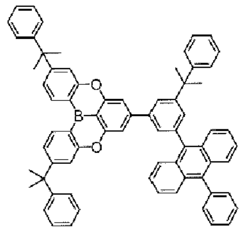
184

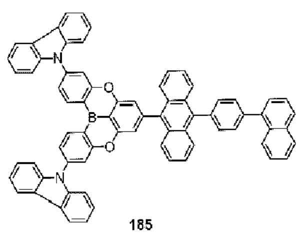
185

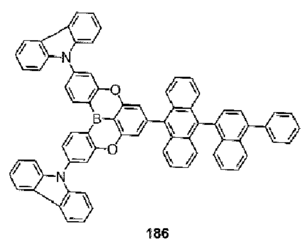
186

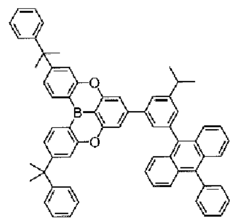
187

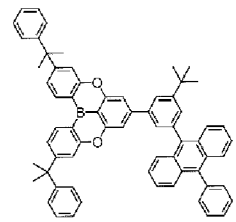
188

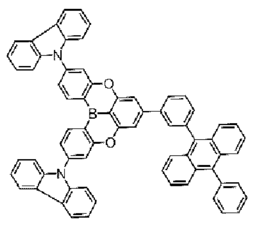
189

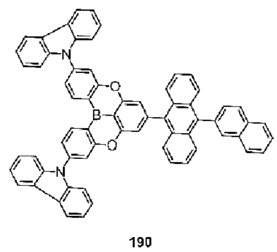
190

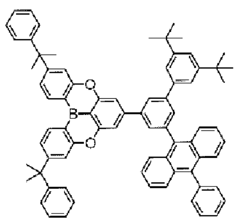
191

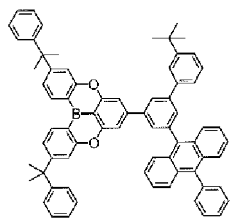
192

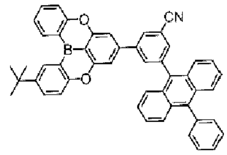
193

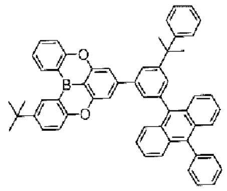
194

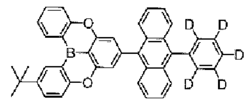
195

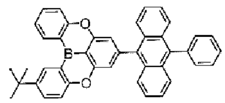
196

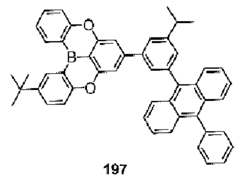
197

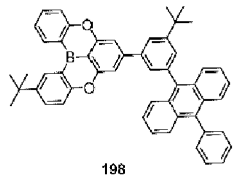
198

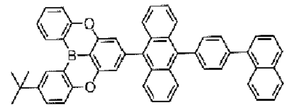
199

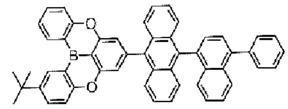
200

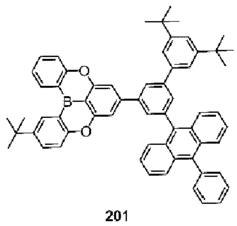
201

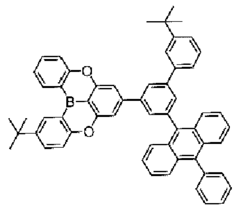
202

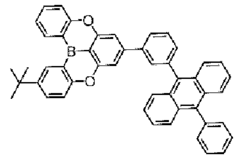
203

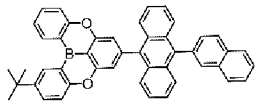
204

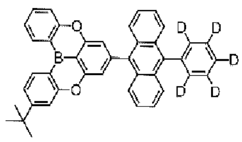
205

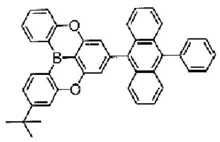
206

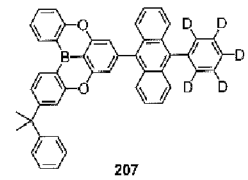
207

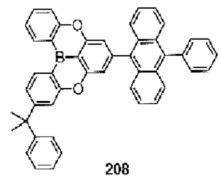
208

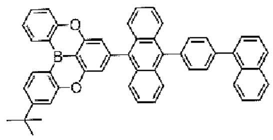
209

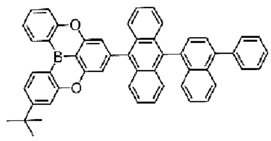
210

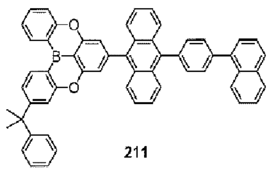
211

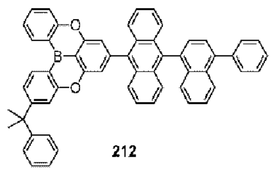
212

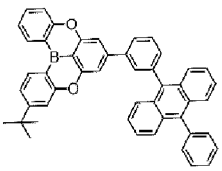
213

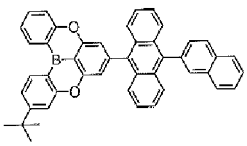
214

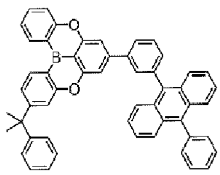
215

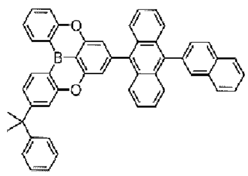
216

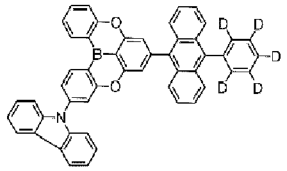
217

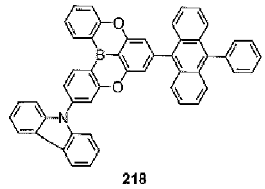
218

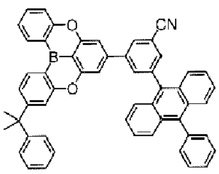
219

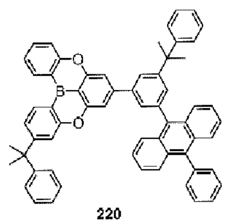
220

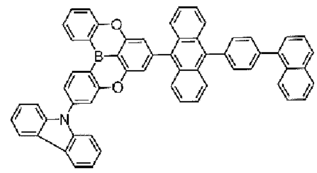

221

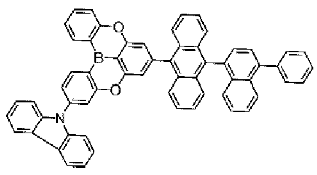

222

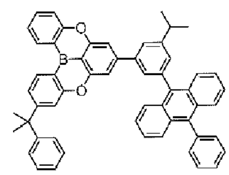

223

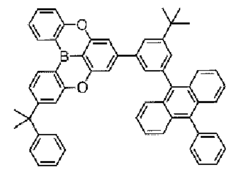

224

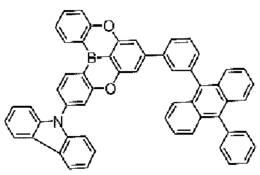

225

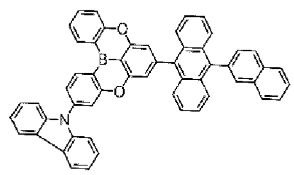

226

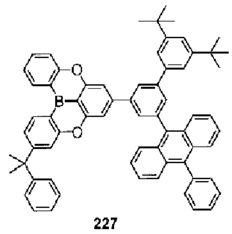

227

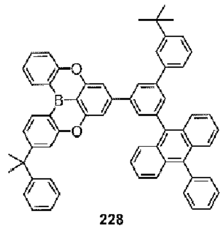

228

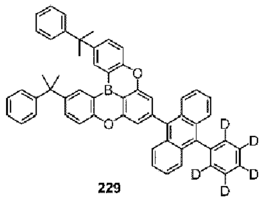

229

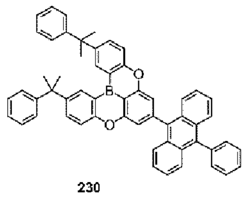

230

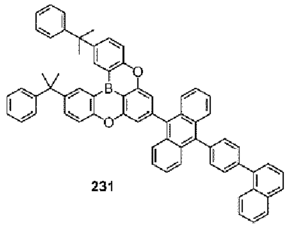

231

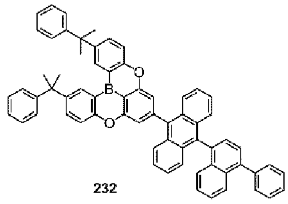

232

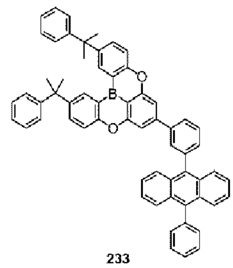

233

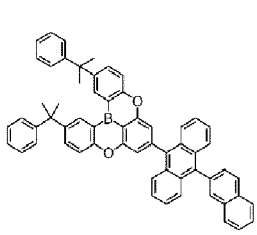

234

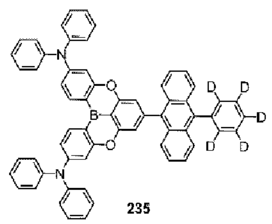

235

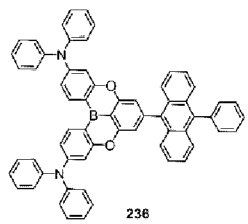

236

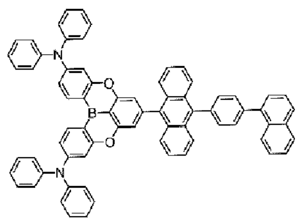

237

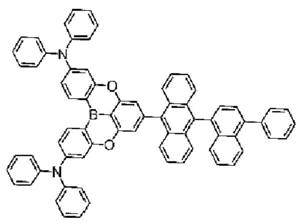

238

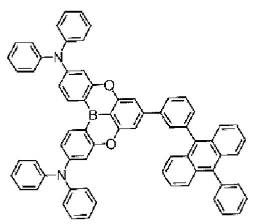

239

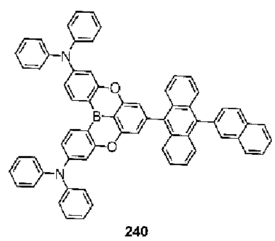

240

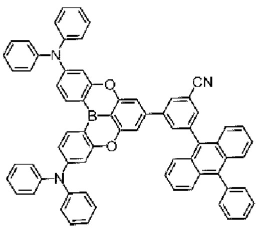

241

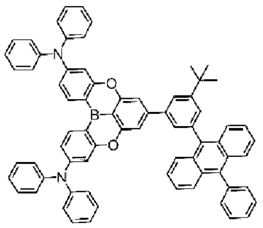

242

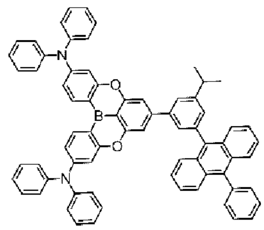

243

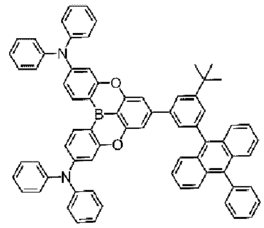

244

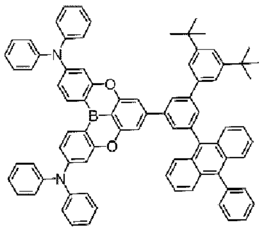

245

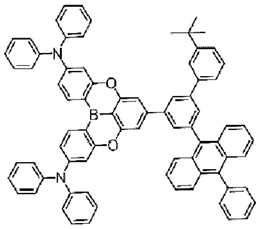

246

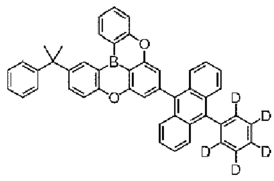

247

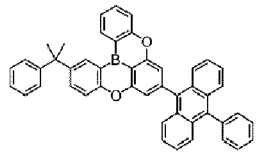

248

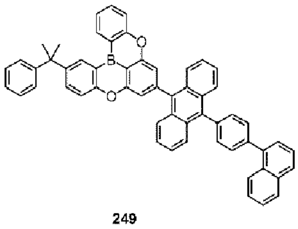

249

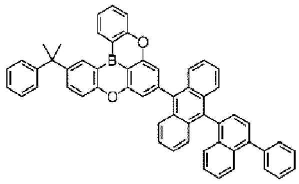

250

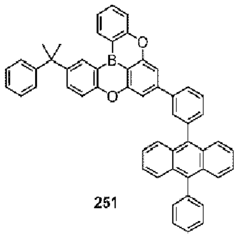

251

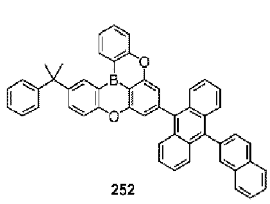

252

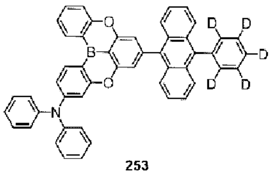

253

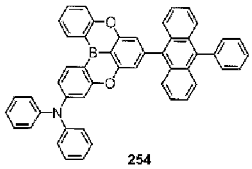

254

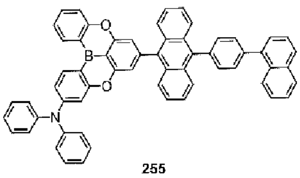

255

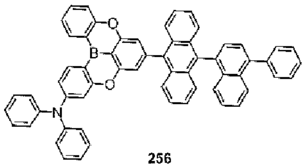

256

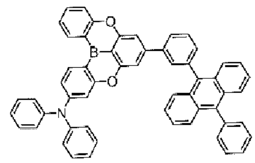

257

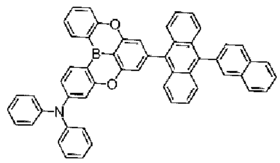

258

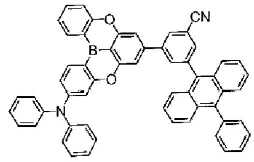

259

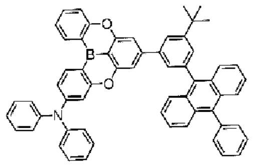

260

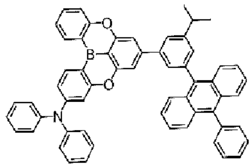

261

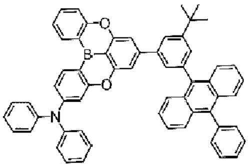

262

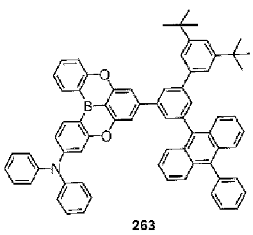

263

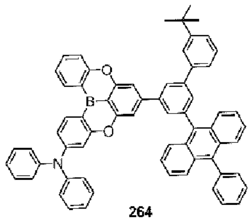

264

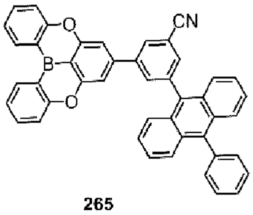

265

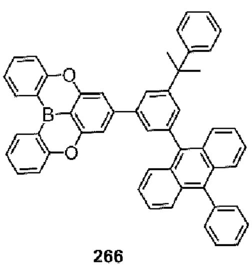

266

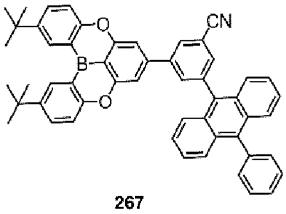

267

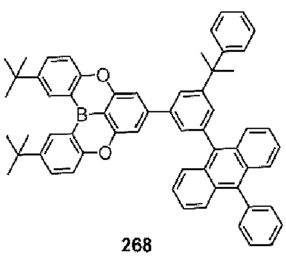

268

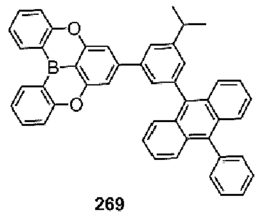

269

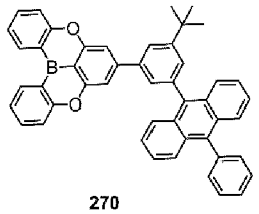

270

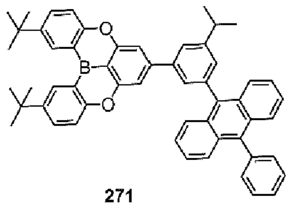

271

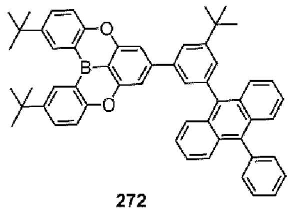

272

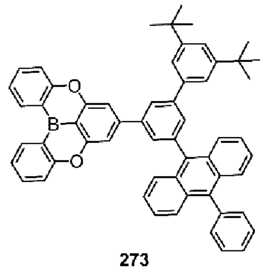

273

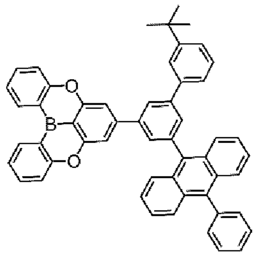

274

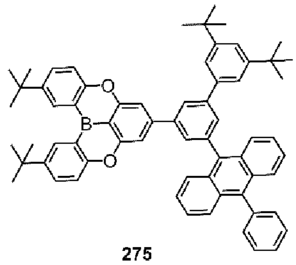

275

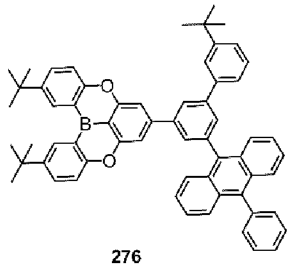

276

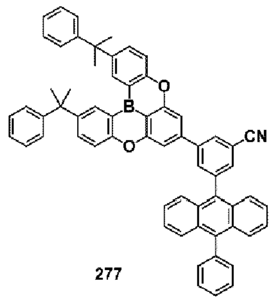

277

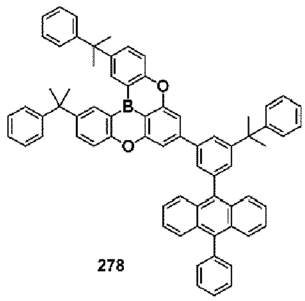

278

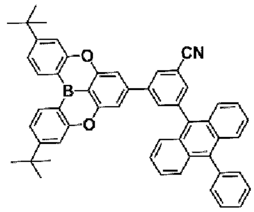

279

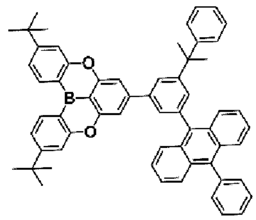

280

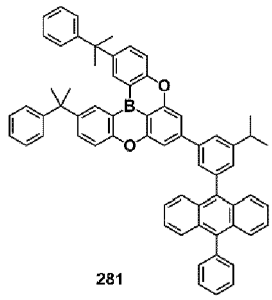

281

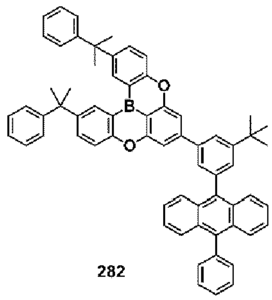

282

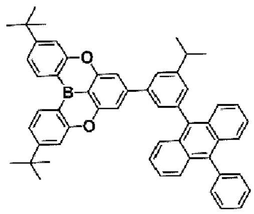

283

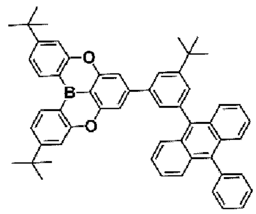

284

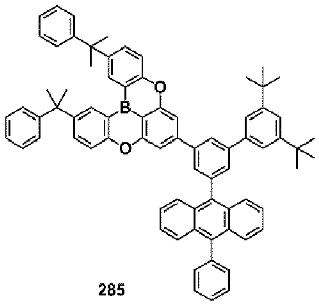

285

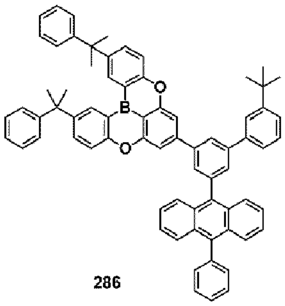

286

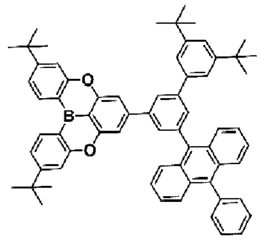

287

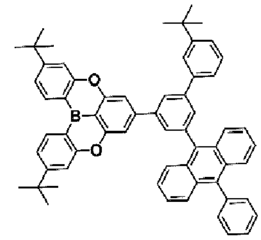

288

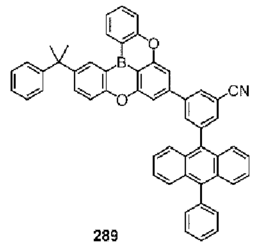
289

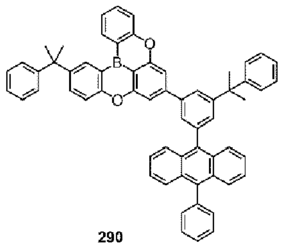
290

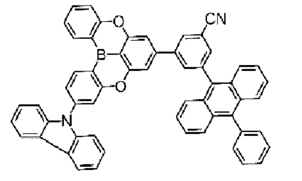
291

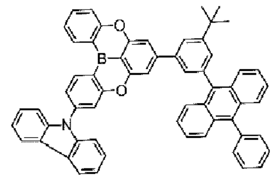
292

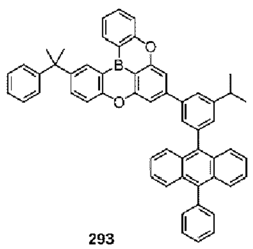
293

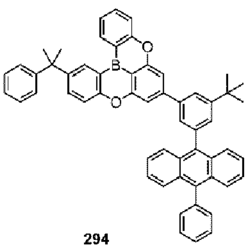
294

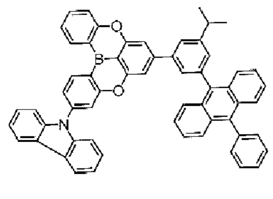
295

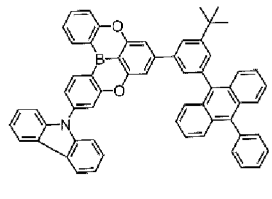
296

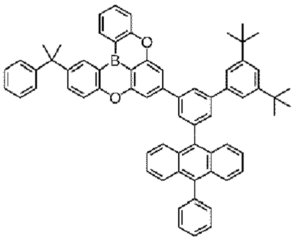
297

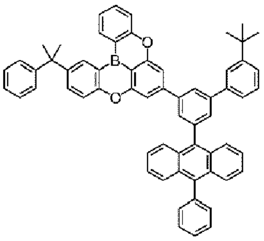
298

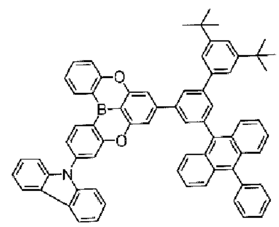
299

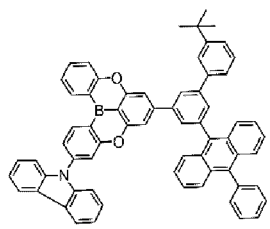
300

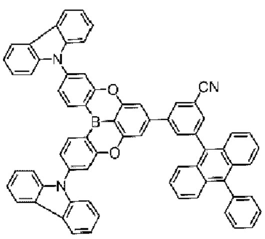
301

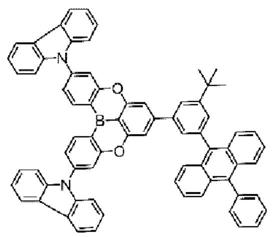
302

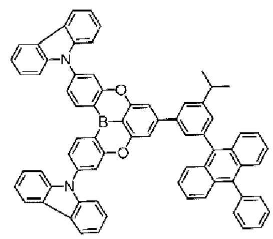
303

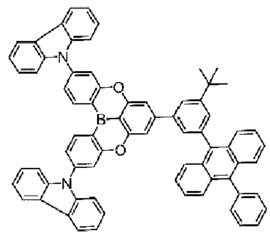
304

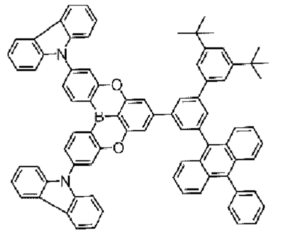
305

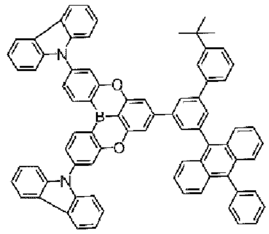
306

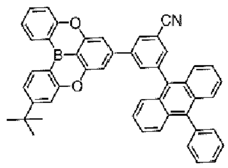
307

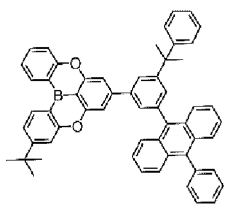
308

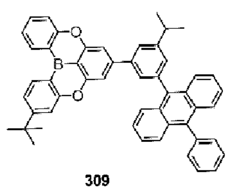
309

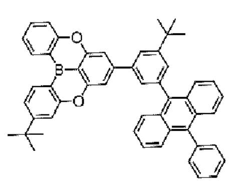
310

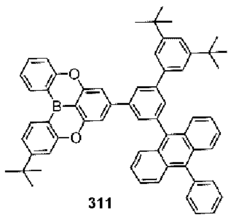
311

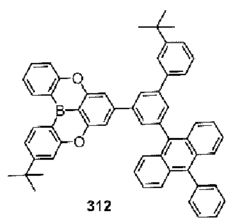
312

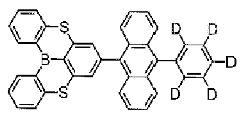
313
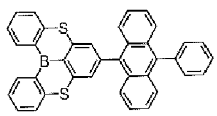
314
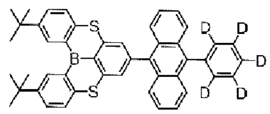
315
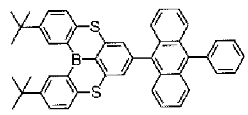
316

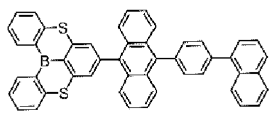
317
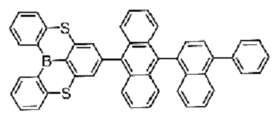
318
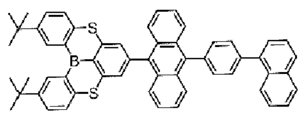
319
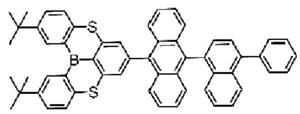
320

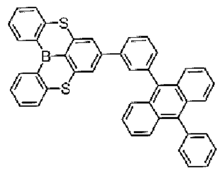
321
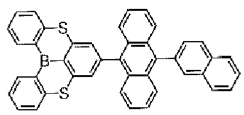
322
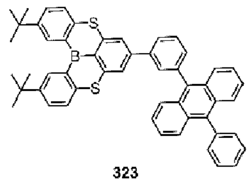
323
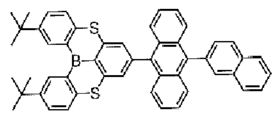
324

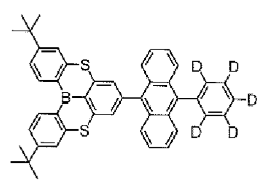
325
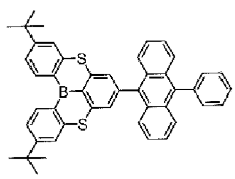
326
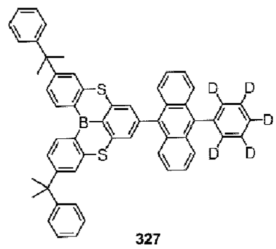
327
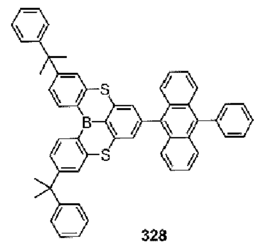
328

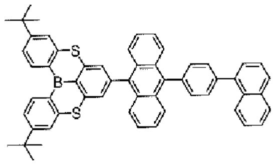
329
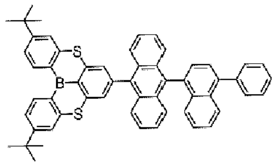
330
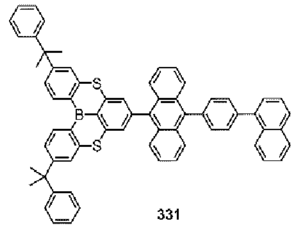
331
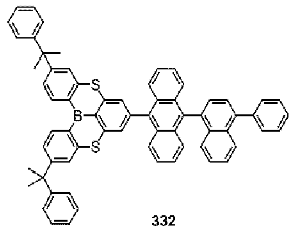
332

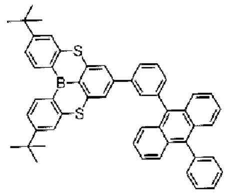
333
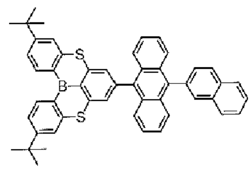
334
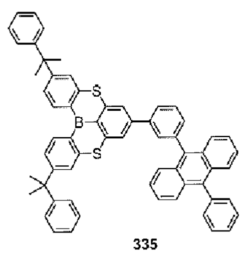
335
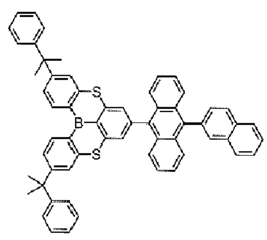
336

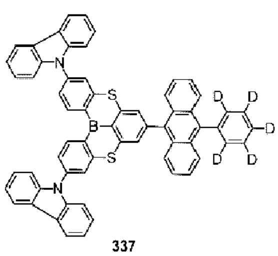
337
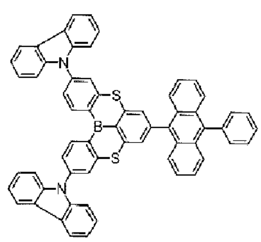
338
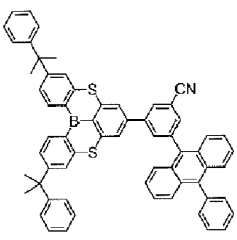
339
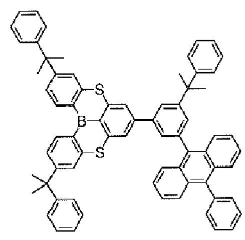
340

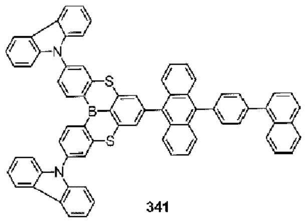
341
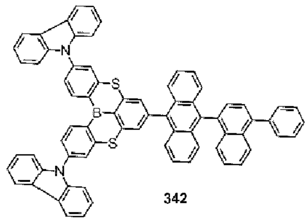
342
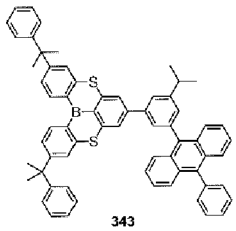
343
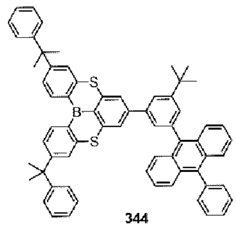
344

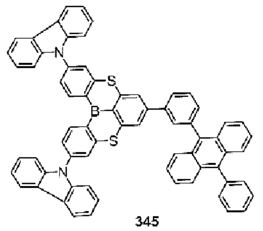
345
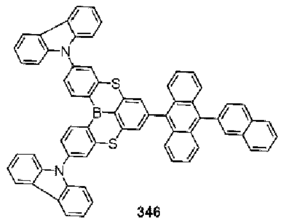
346
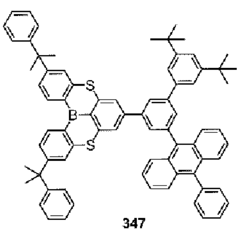
347
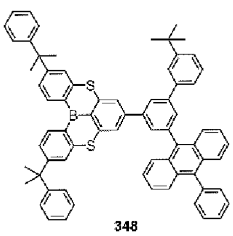
348

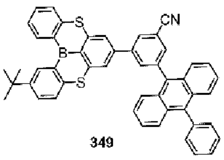
349
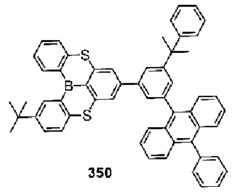
350
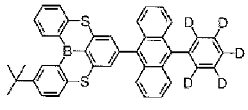
351
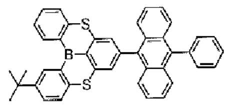
352

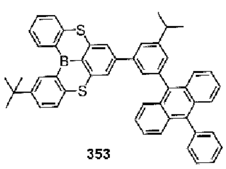
353
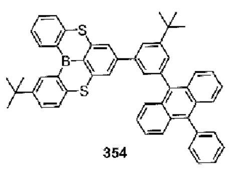
354
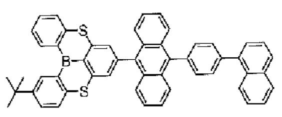
355
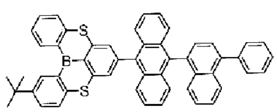
356

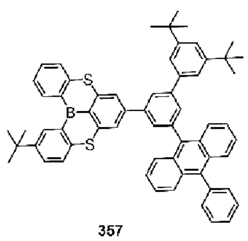
357
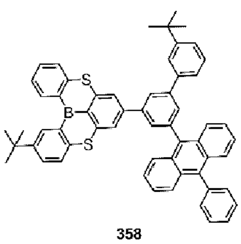
358
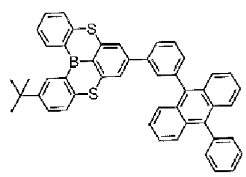
359
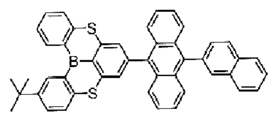
360

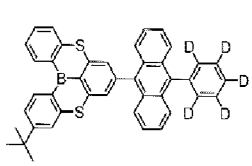
361
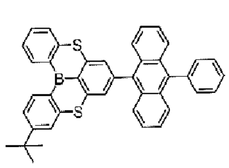
362
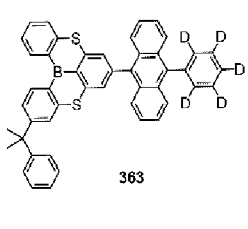
363
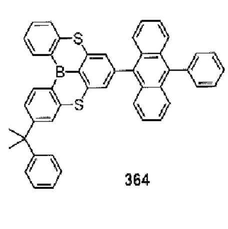
364

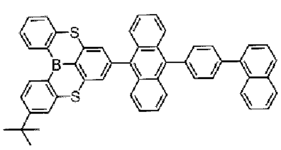
365
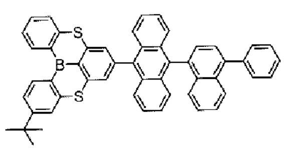
366
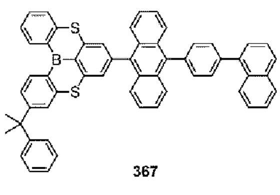
367
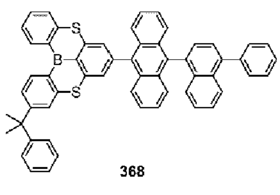
368

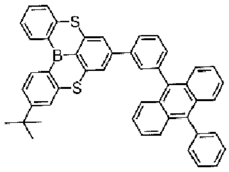
369
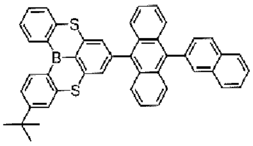
370
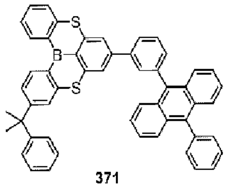
371
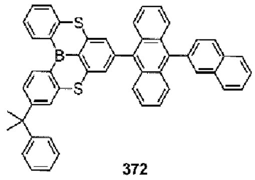
372
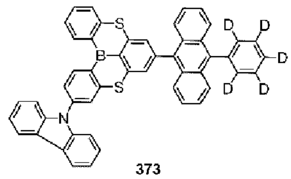
373
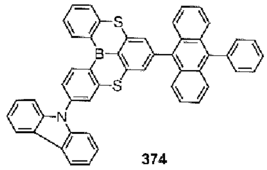
374
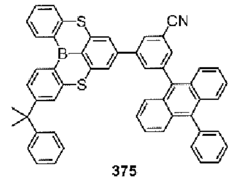
375
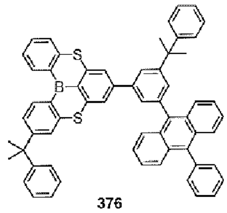
376
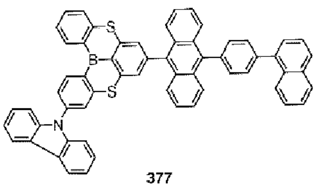
377
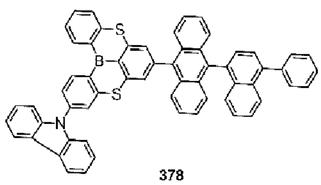
378
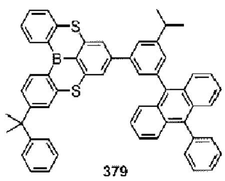
379
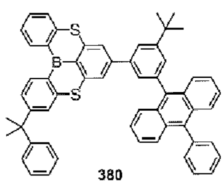
380
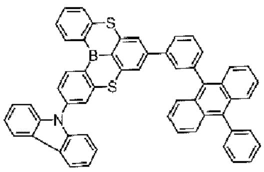
381
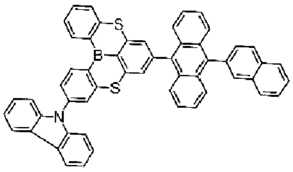
382
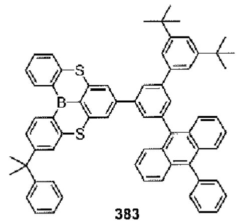
383
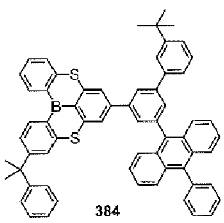
384
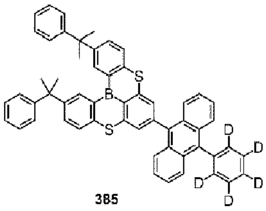
385
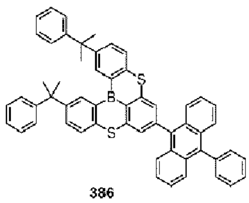
386
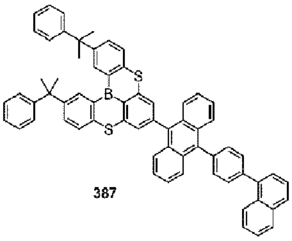
387
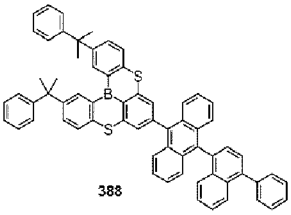
388
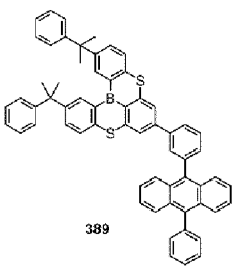
389
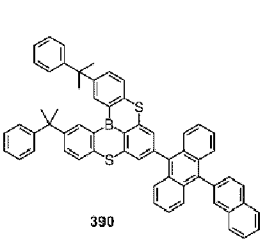
390
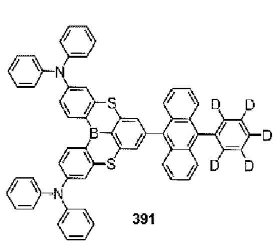
391
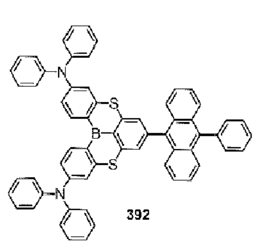
392

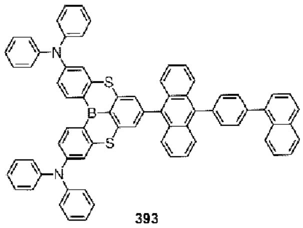
393

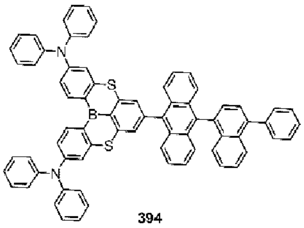
394

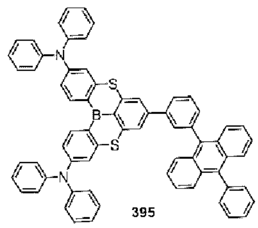
395

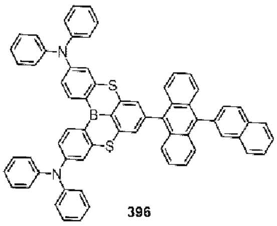
396

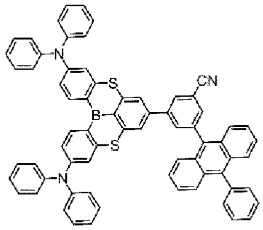
397

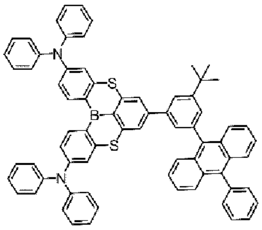
398

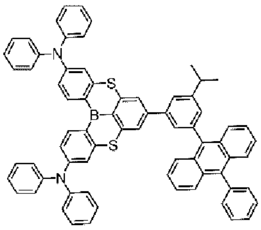
399

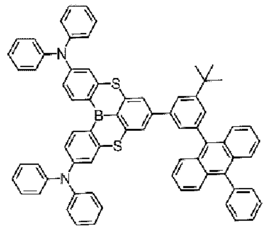
400

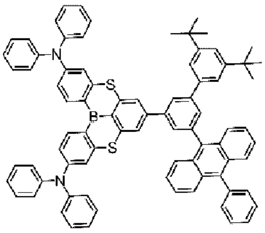
401

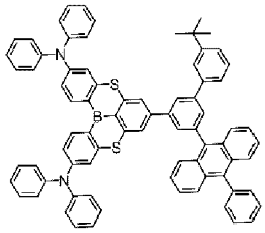
402

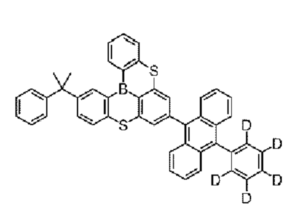
403

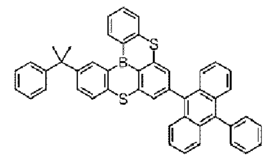
404

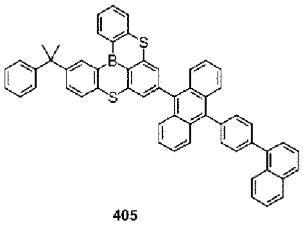
405

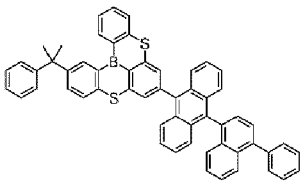
406

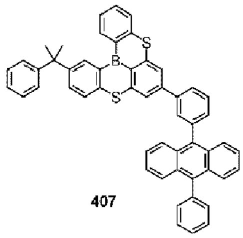
407

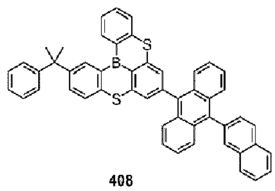
408

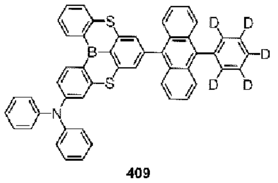
409

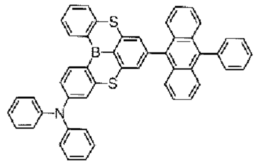
410

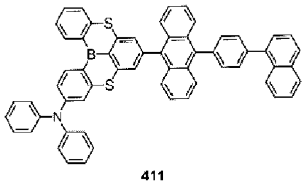
411

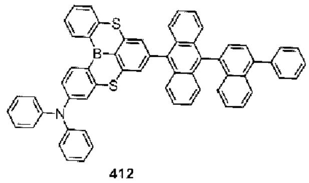
412

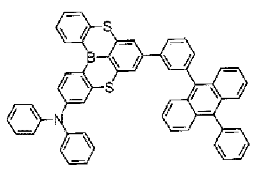
413

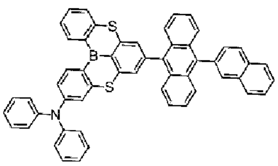
414

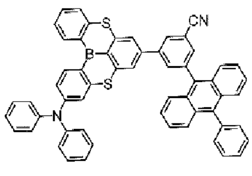
415

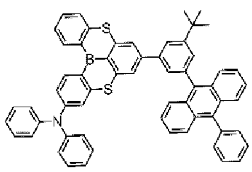
416

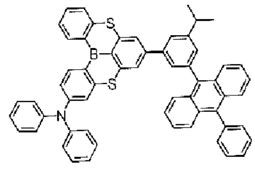
417
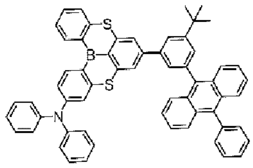
418
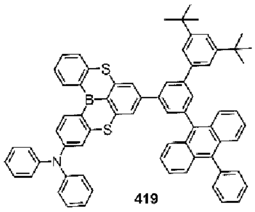
419
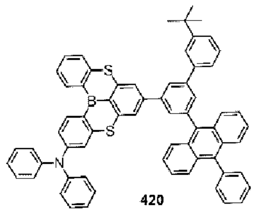
420

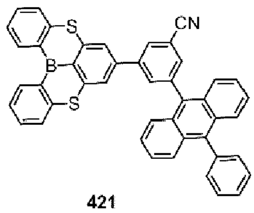
421
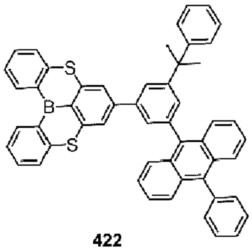
422
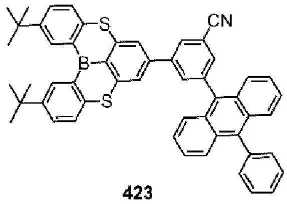
423
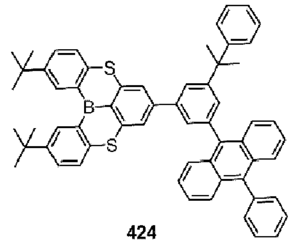
424

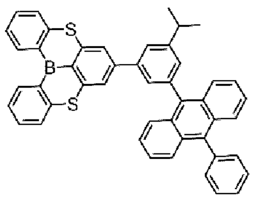
425
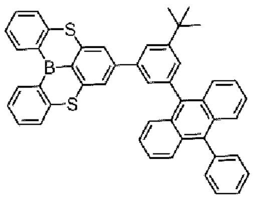
426
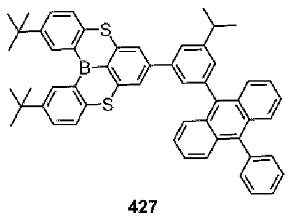
427
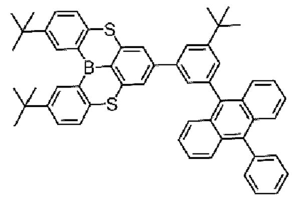
428

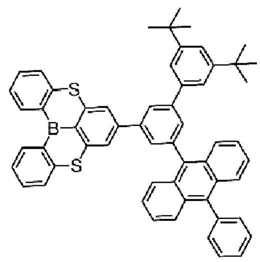
429
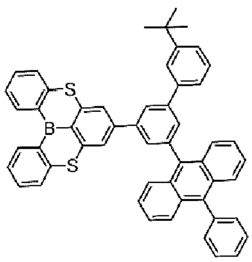
430
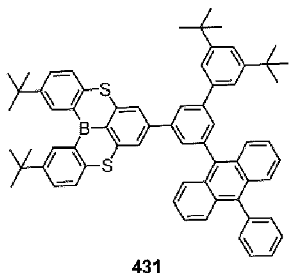
431
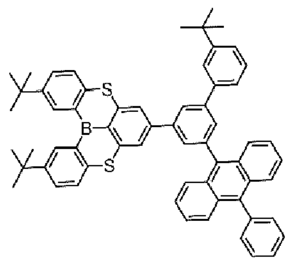
432

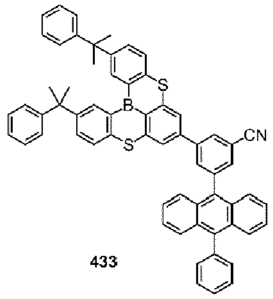
433
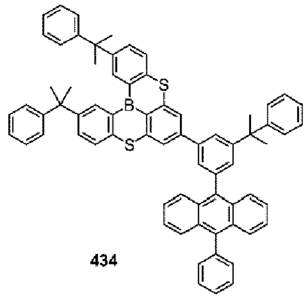
434
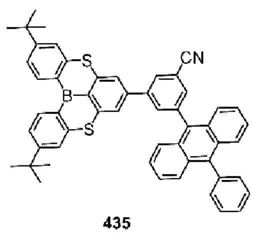
435
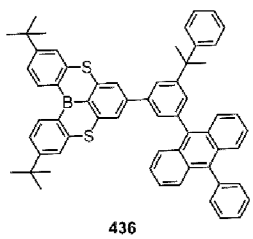
436

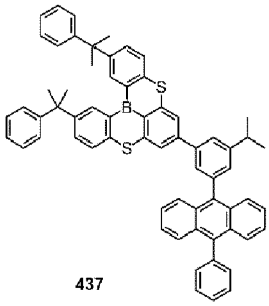
437
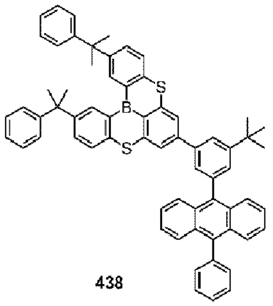
438
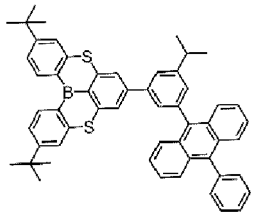
439
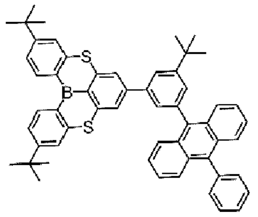
440

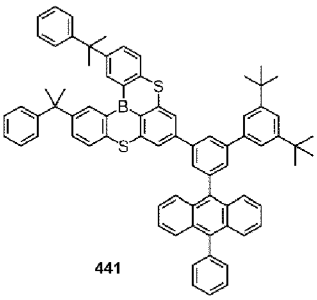
441
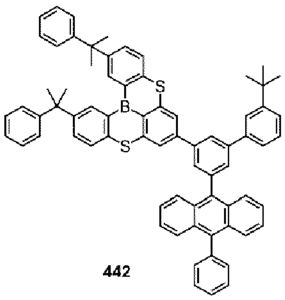
442
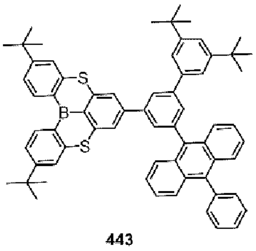
443
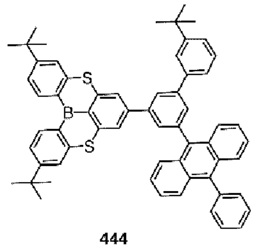
444

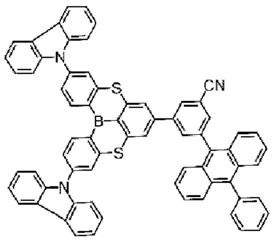
445
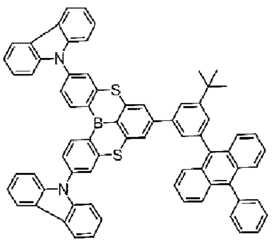
446
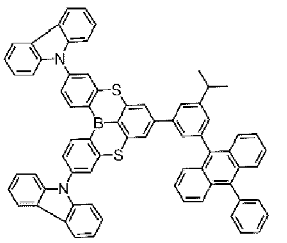
447
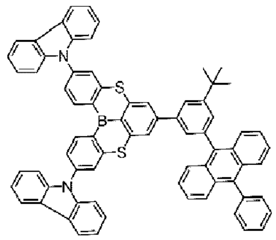
448

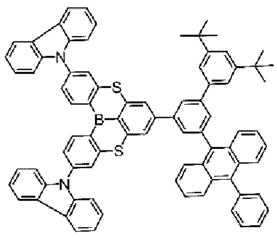
449
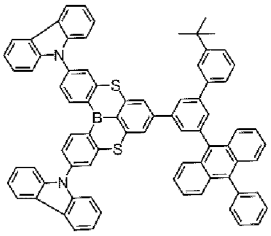
450
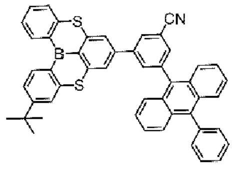
451
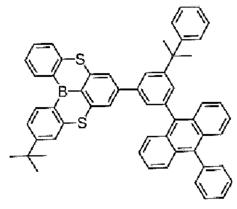
452

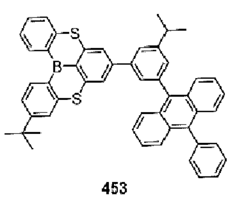
453
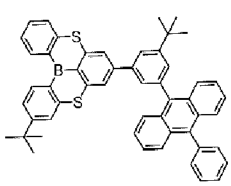
454
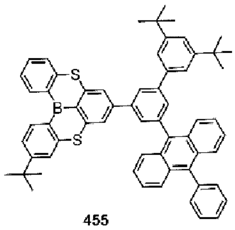
455
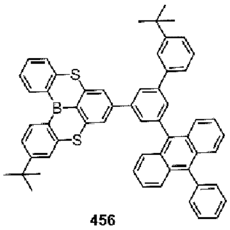
456

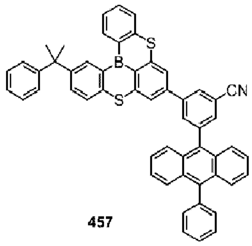
457

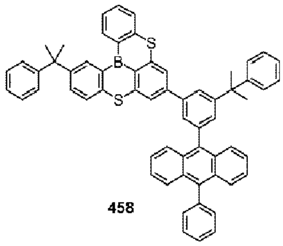
458

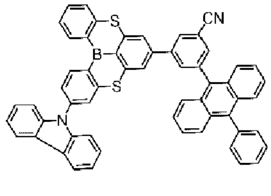
459

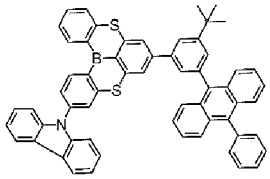
460

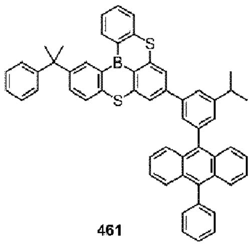
461

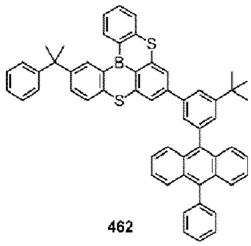
462

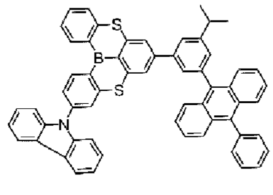
463

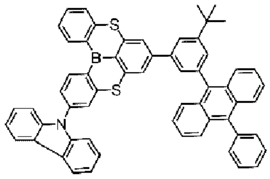
464

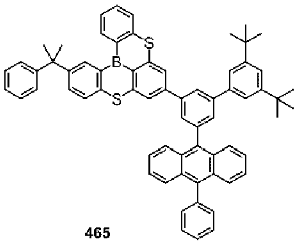
465

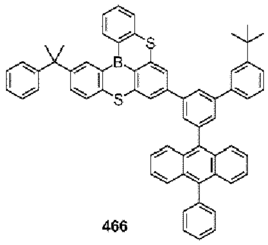
466

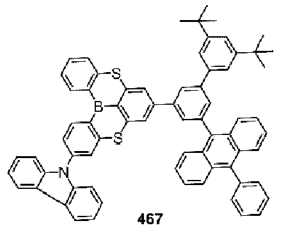
467

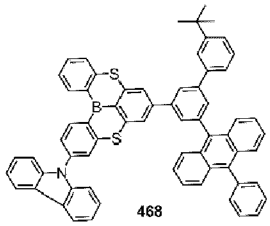
468

.

**14.** The organic light-emitting device of any of claims 1-13, wherein the polycyclic compound is a fluorescence emitter; preferably wherein the emission layer further comprises a sensitizer that satisfies Equation 1:

Equation 1

$$\Delta E_{ST} \geq 0.3 \text{ eV}$$

wherein, in Equation 1, $\Delta E_{ST}$ represents an energy level gap between a lowest excited singlet energy level ($S_1$) and a lowest excited triplet energy level ($T_1$);
preferably wherein the sensitizer and the polycyclic compound both satisfy Conditions 1 and 2:

Condition 1

$$T_{decay}(PC) < T_{decay}(S)$$

Condition 2

$$T_{decay}(PC) < 1.5 \ \mu s$$

wherein, in Conditions 1 and 2,
$T_{decay}(PC)$ represents a decay time of the polycyclic compound, and
$T_{decay}(S)$ represents a decay time of the sensitizer.

**15.** The organic light-emitting device of any of claims 1-14, wherein the emission layer further comprises a photoluminescent dopant, and a content of the host is greater than a content of the polycyclic compound and the photoluminescent dopant; and/or

wherein the first electrode is an anode, the second electrode is a cathode, the organic layer comprises a hole transport region between the first electrode and the emission layer and an electron transport region between the emission layer and the second electrode, the hole transport region comprises a hole injection layer, a hole transport layer, an electron blocking layer, a buffer layer, or any combination thereof, and the electron transport region comprises a hole blocking layer, an electron transport layer, an electron injection layer, or any combination thereof.

FIG. 1

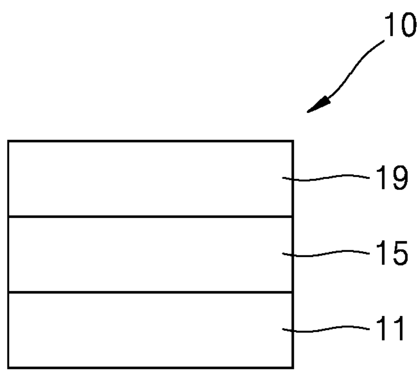
10
19
15
11

FIG. 2A

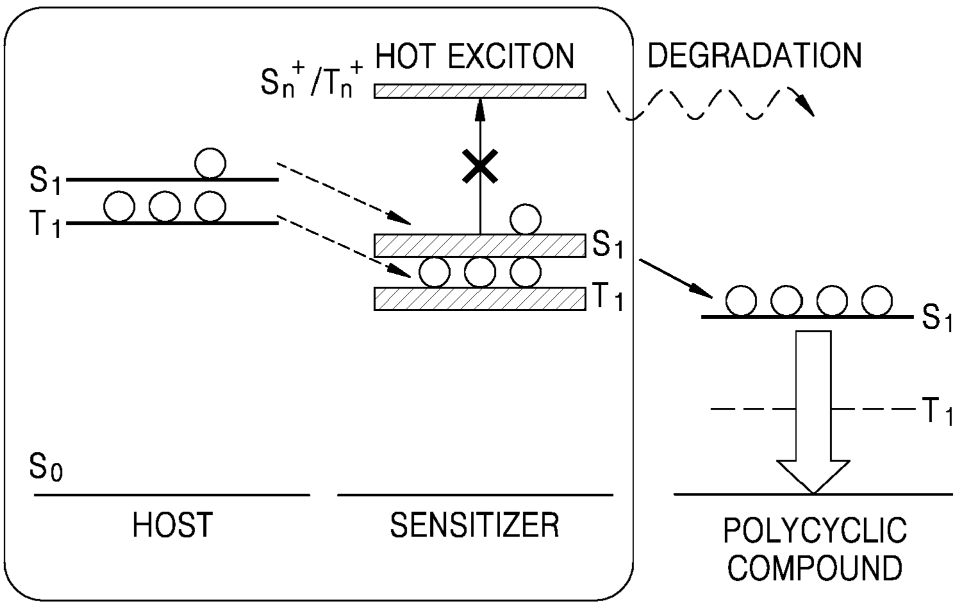
HOT EXCITON
DEGRADATION
$S_n^+/T_n^+$
$S_1$
$T_1$
$S_0$
HOST
SENSITIZER
POLYCYCLIC
COMPOUND

FIG. 2B

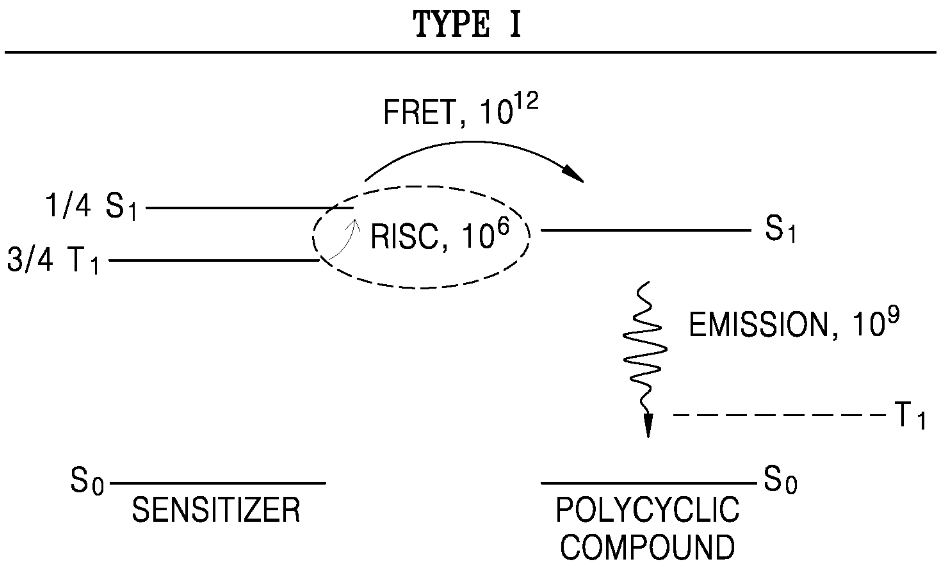
TYPE I
FRET, 10^12
1/4 S1
3/4 T1
RISC, 10^6
S1
EMISSION, 10^9
T1
S0
SENSITIZER
S0
POLYCYCLIC COMPOUND

FIG. 2C

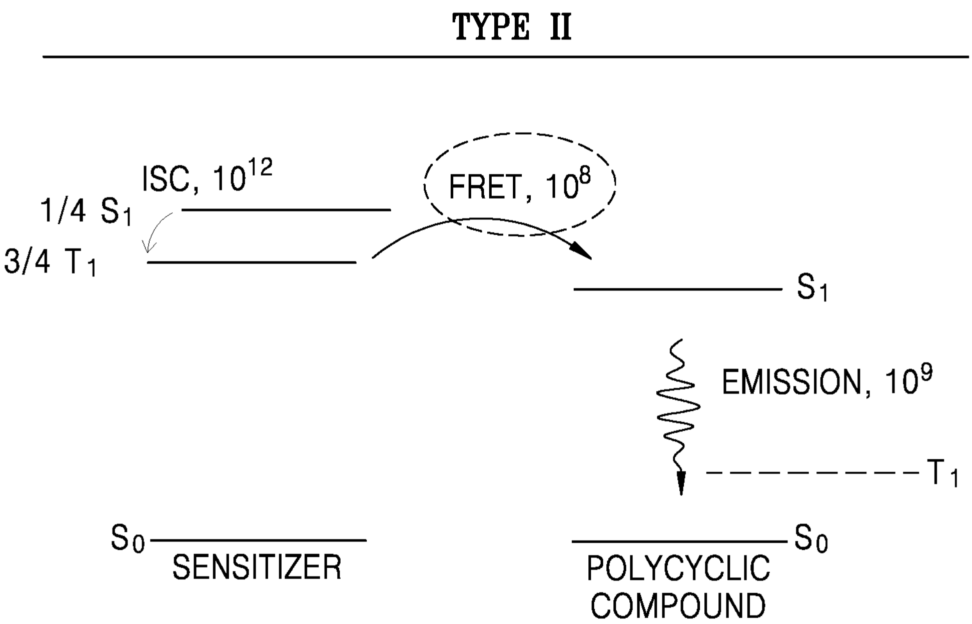
TYPE II
ISC, 10^12
1/4 S1
3/4 T1
FRET, 10^8
S1
EMISSION, 10^9
T1
S0
SENSITIZER
S0
POLYCYCLIC COMPOUND

Europäisches Patentamt
European Patent Office
Office européen des brevets

# EUROPEAN SEARCH REPORT

Application Number
EP 21 16 0639

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2019/009052 A1 (KWANSEI GAKUIN EDUCATIONAL FOUND [JP]; JNC CORP [JP]) 10 January 2019 (2019-01-10) * page 26, paragraphs 0009,0022-0024,0199-0201,0212-0216 - page 27; figure 1 * | 1-15 | INV. H01L51/00 H01L51/50 |
| X | KR 2009 0065201 A (HANA FINE CHEMICALS CO LTD [KR]) 22 June 2009 (2009-06-22) * page 84, paragraph 0376-0393; compounds H-74,75 * | 1-7,9-13 | |
| A | KR 2011 0106192 A (SFC CO LTD [KR]) 28 September 2011 (2011-09-28) * pages 33-80 * | 1-15 | |
| A | WO 2010/050778 A1 (GRACEL DISPLAY INC [KR]; EUM SUNG JIN [KR] ET AL.) 6 May 2010 (2010-05-06) * the whole document * | 1-13 | |

TECHNICAL FIELDS SEARCHED (IPC)

H01L

The present search report has been drawn up for all claims

2

| Place of search | Date of completion of the search | Examiner |
|---|---|---|
| The Hague | 22 July 2021 | Chin, Patrick |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 21 16 0639

This annex lists the patent family members relating to the patent documents cited in the above-mentioned European search report. The members are as contained in the European Patent Office EDP file on
The European Patent Office is in no way liable for these particulars which are merely given for the purpose of information.

22-07-2021

| Patent document cited in search report | Publication date | Patent family member(s) | Publication date |
|---|---|---|---|
| WO 2019009052 A1 | 10-01-2019 | CN 110719914 A | 21-01-2020 |
| | | JP WO2019009052 A1 | 30-04-2020 |
| | | KR 20200026182 A | 10-03-2020 |
| | | TW 201906851 A | 16-02-2019 |
| | | US 2021167288 A1 | 03-06-2021 |
| | | WO 2019009052 A1 | 10-01-2019 |
| KR 20090065201 A | 22-06-2009 | NONE | |
| KR 20110106192 A | 28-09-2011 | NONE | |
| WO 2010050778 A1 | 06-05-2010 | CN 102203212 A | 28-09-2011 |
| | | CN 103864789 A | 18-06-2014 |
| | | EP 2182040 A2 | 05-05-2010 |
| | | JP 2012507507 A | 29-03-2012 |
| | | KR 20100048447 A | 11-05-2010 |
| | | TW 201114770 A | 01-05-2011 |
| | | WO 2010050778 A1 | 06-05-2010 |

EPO FORM P0459

For more details about this annex : see Official Journal of the European Patent Office, No. 12/82